# EUROPEAN PATENT SPECIFICATION

(11) **EP 2 838 129 B1**
(45) Date of publication and mention of the grant of the patent: **18.03.2026**
(21) Application number: 13776357.9
(22) Date of filing: 08.04.2013
(51) Int. Cl.: H10K 85/10, C08G 65/40

(54) **COMPOSITION FOR ORGANIC ELECTROLUMINESCENT ELEMENTS**
ZUSAMMENSETZUNG FÜR EIN ORGANISCHES ELEKTROLUMINESZENZELEMENT
COMPOSITION POUR ÉLÉMENTS ÉLECTROLUMINESCENTS ORGANIQUES

(30) Priority: 09.04.2012 JP 2012088476; 09.04.2012 JP 2012088477; 12.03.2013 JP 2013049291
(43) Date of publication of application: 18.02.2015
(73) Proprietor: Mitsubishi Chemical Corporation, Tokyo 100-8251 (JP)
(72) Inventor: MIZUKAMI Junji, Yokohama-shi, Kanagawa 227-8502 (JP); SHIMIZU Wataru, Yokohama-shi, Kanagawa 227-8502 (JP); TAKEMOTO Hiroki, Kitakyushu-shi, Fukuoka 806-0004 (JP)
(74) Representative: Hoffmann Eitle
(86) International application number: PCT/JP2013/060654
(87) International publication number: WO 2013/154076

(56) References cited:
- EP-A1- 2 315 291
- EP-A2- 1 482 576
- WO-A1-00/41443
- WO-A1-2010/140187
- JP-A- 2003 347 624
- JP-A- 2004 083 650
- JP-A- 2005 209 626
- JP-A- 2007 324 233
- JP-A- 2008 516 421
- JP-A- 2009 114 380
- STEFFEN JUNGERMANN ET AL: "Novel Photo-Cross-Linkable Hole-Transporting Polymers: Synthesis, Characterization, and Application in Organic Light Emitting Diodes", MACROMOLECULES, AMERICAN CHEMICAL SOCIETY, vol. 39, no. 26, 1 January 2006 (2006-01-01), pages 8911 - 8919, XP008142411, ISSN: 0024-9297, DOI: 10.1021/MA060844O
- TANAKA D ET AL: "high Luminous Efficiency Blue Organic Light-Emittimg Devices Using high Triplet Excited Energy Materials", JAPANESE JOURNAL OF APPLIED PHYSICS, JAPAN SOCIETY OF APPLIED PHYSICS, JP, vol. 46, no. 4-7, 1 February 2007 (2007-02-01), pages L117 - L119, XP001516300, ISSN: 0021-4922, DOI: 10.1143/JJAP.46.L117

## Description

### Technical Field

The present invention relates to a composition for organic electroluminescent elements, which is used for forming a hole injection layer and/or a hole transport layer of an organic electroluminescent element.

The present invention also relates to an organic electroluminescent element having a hole injection layer and/or a hole transport layer formed according to a wet film formation method using the composition for organic electroluminescent elements.

### Background Art

Recently, development is under way of an electroluminescent element using an organic thin film (hereinafter referred to as "organic electroluminescent element"). As a method for forming the organic thin film in the organic electroluminescent element, there are mentioned a vacuum vapor deposition method and a wet film formation method.

Of those, a vacuum vapor deposition method enables multilayer lamination, and therefore has the advantage of being able to improve charge injection from an anode and/or a cathode and facilitating sealing up of excitons in a light-emitting layer.

On the other hand, a wet film formation method does not require a vacuum process, and therefore has the advantage of facilitating large-area film formation and facilitating mixing up of multiple materials having various functions in one layer (coating liquid).

As a case of forming an organic layer according to a wet film formation method, PTL 1 discloses a composition for hole injection layer using various solvents for use for a composition for charge transportation and ethyl benzoate as a solvent.

However, in a wet film formation method, when a foreign substance is mixed in, there may occur coating defects, and especially in an organic electroluminescent element using an organic thin film, formation of an extremely thin film is required, and therefore it is desired to prevent mixing of a foreign substance and to prevent formation of a foreign substance in a composition.

Especially in a case where an organic solvent is used as a coating solvent, the salt to be formed by ionic bonding is insoluble in the organic solvent, and consequently, a slight amount of an impurity that may not precipitate in a water-based solvent would precipitate as a foreign substance, therefore often causing troubles during film formation or causing formation of defective organic electroluminescent elements.

As a case of forming a hole injection layer according to a wet film formation method, a technique relating to a PEDOT (polyethylenedioxythiophene)-PSS (polystyrenesulfonic acid) resin-based hole injection material using water as a coating solvent is described in PTL 2 to 4.
EP 2 315 291 A1 aims at providing an organic electroluminescent element having a low driving voltage, high current efficiency and high voltage efficiency. An organic electroluminescent element comprising an anode, a cathode and an organic layer disposed between the anode and the cathode is described, wherein the organic layer comprises a mixed layer containing a light-emitting low molecular compound and/or a charge-transporting low molecular compound in a film containing an insolubilized polymer obtained by insolubilizing an insolubilizing polymer, and, adjacent to the mixed layer, a layer containing a light-emitting low molecular compound and a charge-transporting low molecular compound and not containing an insolubilized polymer. Example 1 of the document makes use of a polymer H1 as shown below, having a weight-average molecular weight of 86,000: 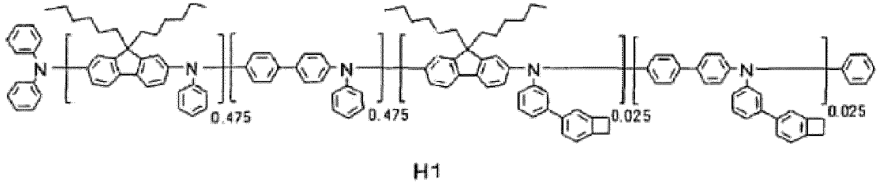 The documed is silent on the Zn content.
S. Jungermann et al. describe in "Novel Photo-Cross-Linkable Hole Transporting Polymers: Synthesis, Characterization and Application in Organic Light Emitting Diodes", Macromol. 2006 (39) 8911-8919 certain aromatic amine polymers having weight-average molecular weights of 12,230, 17,160, 37,170 and 40,790, respectively. The document is silent on the Zn content and indicates that the starting materials were used as purchased without further purification.
D Tanaka et al describe in "High Luminous Efficiency Blue Organic Light-Emitting Devices Using high Triplet Excited Energy Materials", Jap. J. Appl. Phys., 2007 (46), L117-L119 certain aromatic amine polymers for use in OLEDs. The documed is silent on the Zn content.
EP 1 482 576 A2 describes hole transport materials that have a limited sulfate ion content of 1000 ppm or less at the time of hole transport layer formation. Examples 11 - 20 make use of a polyaniline having a weight average molecular weight of 20,000.

### Citation List

PTL 1: JP-A 2010-98306
PTL 2: JP-A 2005-276749
PTL 3: JP-A 2006-5144
PTL 4: JP-T 2008-515194

### Summary of Invention

### Technical Problem

However, the above-mentioned technique relates to a water-based system that differs from a solvent system. In addition, because of such a water-based system, the amount of a metal component to mix in is large, and the amount of metal to mix in is several tens of ppm or more as the concentration thereof in a solution, and the contamination level is extremely high.

Consequently and in consideration of the above situation, an object of the present invention is provide a composition for organic electroluminescent elements that contains a hole injection/transport material and an organic solvent for use for forming a hole injection layer and/or a hole transport layer of an organic electroluminescent element, in which the content of a foreign substance is small and which is therefore troubled little in film formation.

### Solution to Problem

The present inventors have made assiduous investigations and, as a result, have found that, when the content of Zn (Zn concentration) in the composition is controlled to be less than 0.5 ppm, then the formation of a foreign substance to be caused by Zn can be prevented and the above-mentioned problems can be thereby solved, and have completed the present invention. Here, the content of Zn is to be determined by the ICP method described in the Examples below.

### Advantageous Effects of Invention

The composition for organic electroluminescent (hereinafter this may be referred to as "organic EL") element of the present invention is a uniform solution and the Zn concentration to cause foreign substance formation is reduced therein, and therefore, the composition enables uniform film formation. Accordingly, the organic electroluminescent element produced using the composition for organic electroluminescent elements of the present invention is protected against short circuit and is free from dark spots, and therefore has a long driving life.

The organic electroluminescent element of the present invention produced using the composition for organic electroluminescent elements of the present invention is applicable to light sources (for example, light sources for duplicators, backlight sources for liquid-crystal displays and indicators) that make the most of being flat panel displays (for example, for OA computers or wall-hanging TVs) or being planar light-emitting devices, and to sign boards and marker lamps, and its technical value is high.

### Brief Description of Drawing

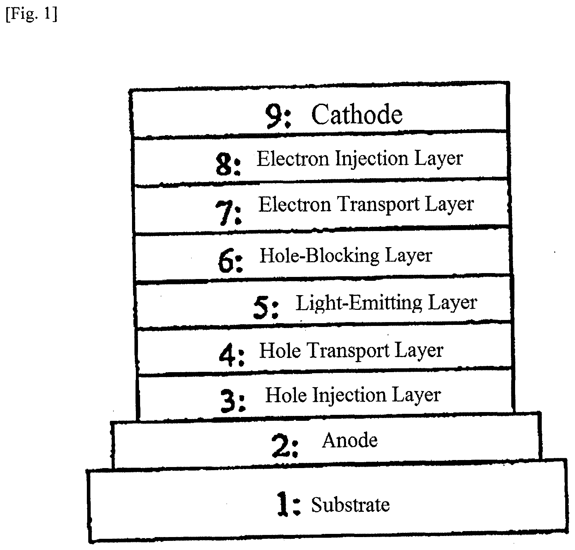

[Fig. 1] Fig. 1 is a schematic cross-sectional view showing one example of configuration of the organic electroluminescent element of the present disclosure.

### Description of Embodiments

Embodiments of the composition for organic electroluminescent elements and the organic electroluminescent element of the present invention are described in detail hereinunder. The scope of the present invention is defined by the claims. In the present invention, the simple expression of "ppm" indicates "ppm by weight".

### [Composition for Organic Electroluminescent Elements]

The composition for organic electroluminescent elements of the present invention (hereinafter this may be referred to as "the composition of the present invention") is a composition for organic electroluminescent elements that is for forming at least one layer selected from a group consisting of a light-emitting layer, a hole injection layer and a hole transport layer of an organic electroluminescent element, which contains an aromatic amine polymer having a weight-average molecular weight of from 3,000 to 1,000,000 and an organic solvent, and wherein the content of Zn in the composition is less than 0.5 ppm, as determined by the **ICP** method described in the Examples. The aromatic amine polymer in the present invention is a polymer having an aromatic amino group in the main chain thereof. The details are described hereinunder.

Above all, the composition for organic electroluminescent elements of the present invention is preferably a composition for organic electroluminescent elements of the present invention that is for forming at least one layer of a hole injection layer and a hole transport layer of an organic electroluminescent element.

Also preferably, the composition for organic electroluminescent elements of the present invention contains an electron-accepting compound from the viewpoint of voltage reduction for organic electroluminescent elements.

### <Description of Zn>

**In** the composition of the present invention, the Zn content, or that is, the Zn concentration is less than 0.5 ppm. The reason is mentioned below.

When a Zn atom exists in the composition of the present invention, then the Zn atom may gradually react with time with the anion component contained in the composition to form an insoluble precipitate (foreign substance). The precipitate could cause short circuit or dark spots in organic electroluminescent elements containing the composition.

As the anion component, especially mentioned is a sulfur (S)-containing anion component, and the anion component is described hereinunder.

Zn has a large atomic radius and has a large van deer Waals' force, and therefore has a strong interaction with organic substances. Consequently, Zn is readily taken in a polymer that forms a hole injection layer and/or a hole transport layer. Accordingly, when a Zn atom exists in the composition, it would detract from the function of organic electroluminescent elements owing to unintentional complex formation or inhibition of polarization or intermolecular interaction.

Zn would mix in the composition through various routes.

Specific examples of the routes include contamination from solid materials such as an aromatic amine polymer and other materials such as an organic amine constituting the composition; contamination from containers for mixing the materials in preparing the composition; contamination from the ambient environments in mixing the material to prepare the composition; contamination from containers for charging and storing the composition therein, etc.

For preventing contamination with Zn from containers, the containers to be used must be fully washed. For example, it is desirable that the containers are repeatedly washed and rinsed using ultrapure water having few particles (microparticles) in an environment having few particles, for example, in a clean room, and dried in a clean oven.

Prior to washing with ultrapure water, it is also desirable to wash away the organic substances or inorganic substances adhering to the inner walls of the containers and others, optionally using an organic solvent, or an alkaline, acidic or neutral detergent.

For preventing contamination with Zn from the ambient environment in preparing the composition, it is important that the absence of any contaminating substance to be a contaminant source in the environment is fully confirmed and, in case where any contaminating substance exists, this must be removed.

For example, it is desirable that a clean environment that is partitioned from the external environment by a partition wall or a hood is prepared, and a flowing gas is cleaned away using various filters such as a hepafilter.

For reducing the Zn content in the composition, in particular, it is important to fully purify the constituent materials of the composition.

For example, regarding liquids such as an organic solvent, it is effective to purify them prior to preparing the composition, by applying thereto a purification method of distillation, ion chromatography, column chromatography or using various metal removers, etc. Regarding solid materials, it is necessary to prevent them from being contaminated with Zn as much as possible in order that Zn is prevented from mixing in the reaction materials such as starting materials, catalysts, organic solvents and others in the stage of producing those materials.

A combined purification method is also effective that comprises a washing method using an acidic aqueous solution, an alkaline aqueous solution, or an organic solvent in the production stage, as combined with a reprecipitation method, a recrystallization method, or a distillation/sublimation purification method. Regarding solid materials that are poorly soluble in such an aqueous solution or an organic solvent, it is desirable that the materials are washed with an acidic aqueous solution, an alkaline aqueous solution, or an organic solvent, while finely ground in a ball mill.

For removing Zn that has been mixed in the prepared composition, there may be employed a column chromatography method, a crystallization-filtration method, a decantation method a washing method with water, a method of filtering through a filter, etc.

In the present invention, from the stage of preparing the constituent materials for the composition, and in the other stages of preparation and storage of the composition, the composition is prevented from being contaminated with Zn as mentioned above, or Zn having mixed in the composition is removed, whereby the content of Zn in the composition of the present invention is controlled to be less than 0.5 ppm.

The content of Zn in the composition of the present invention is preferably lower, and is more preferably less than 0.1 ppm, even more preferably lower than the detection limit in the analysis for determination of the content of Zn to be mentioned below.

When the content of Zn in the composition is 0.5 ppm or more, then uniform film formation could not be realized owing to formation of Zn-caused foreign substances, and the organic electroluminescent element produced using the composition may be troubled by short circuit, dark spots, reverse voltage leak current, etc., and therefore it is impossible to obtain an organic electroluminescent element having a long driving life.

In the present invention, the content of Zn in the composition is controlled to be less than 0.5 ppm thereby to prevent the formation of Zn-caused foreign substances, and consequently, the composition enables uniform film formation, and the organic electroluminescent element produced using the composition is free from troubles of short circuit, dark spot, reverse voltage leak current, etc., and the composition realizes production of an organic electroluminescent element having a long driving life.

The content of Zn in the composition of the present invention can be measured according to an ICP (spectrometry) method, as described in the section of Examples to be given hereinunder.

In the composition of the present invention, the content of Zn is low as described above, and therefore another characteristic feature of the composition is that the content of the foreign substances to be formed through reaction of Zn with the anion component in the composition is low. For example, the number of Zn-containing foreign substances having a long diameter of 0.1 µm or more contained in 1 ml of the composition of the present invention can be preferably 50,000 or less, more preferably 20,000 or less, even more preferably 10,000 or less.

Here, the number of Zn-containing foreign substances having a long diameter of 0.1 µm or more in the composition is preferably smaller, and especially preferably, no Zn-containing foreign substances having a long diameter of 0.1 µm or more exist in the composition.

As a method for measuring the number of Zn-containing foreign substances in the composition, there may be mentioned a method of observing the unit area of the composition with a scanning electronic microscope (SEM) and measuring the foreign substances, if any, therein. In the case, the elements contained in the foreign substances may be identified through EDX or EDS (with an energy dispersive X-ray analyzer).

Concretely, for example, one ml of a composition is filtered through a filter having a filtration area of A cm², and an arbitrary area of B cm² of the filter is observed. In case where one Zn-containing foreign substance is detected through SEM-EDX, then the number of the Zn-containing foreign substance in one ml can be calculated as 1 × A/B.

### <Zn Reduction Method>

A purification method for preparing the composition of the present invention in which the Zn content is less than 0.5 ppm is described below.

For preparing the composition of the present invention in which the Zn content is less than 0.5 ppm, the Zn content in the aromatic amine polymers that are the hole injection/transport materials for use in preparing the composition of the present invention, and other solid materials and organic solvents, as well as the Zn content in the prepared composition is reduced. For the reduction method, employable here is any known method of an acid treatment method, a method of using an ion remover, and any other method (for example, reprecipitation method, organic solvent washing method), and combination of those methods.

### (Acid Treatment Method)

As an acid treatment method, there may be mentioned a method of dissolving the material to be purified such as an aromatic amine polymer in an organic solvent to give a liquid, and the liquid is brought into contact with an acidic aqueous solution for liquid-liquid extraction to thereby extract the impurities toward the aqueous solution side to remove them.

Concretely, for example, there are mentioned the methods described in JP-A 2004-2627 and JP-A 2011-42745.

Concretely, the material to be purified such as an aromatic amine polymer is dissolved in an organic solvent, and then the resulting solution may be brought into contact with an acidic aqueous solution for liquid-liquid extraction to thereby purify the material. Here, the organic solvent to dissolve the material to be purified is described hereinunder.

The amount of the organic solvent to be used for dissolving therein the material to be purified may be any one capable of dissolving the material to be purified, and is not specifically defined. However, when the organic solvent is used excessively, then the total liquid amount would increase to worsen the operability of the system. On the other hand, when the amount of the organic solvent is too small, then the separability from the aqueous layer after treatment with an acidic aqueous solution may worsen.

Consequently, a favorable amount of the organic solvent to be used is from 50 to 5000 parts by weight relative to 100 parts by weight of the material to be purified, more preferably from 100 to 4000 parts by weight.

The material to be purified that has been dissolved in an organic solvent is then brought into contact with an acidic aqueous solution for liquid-liquid extraction. The acidic aqueous solution is preferably one prepared by adding an acid to water to have a pH of 5 or less. When the acid degree of the aqueous solution is too large, then the solution may have some influences on the physical properties and the structure of the material to be purified, and therefore, in general, preferred is an acidic aqueous solution having a pH of around 0 or more, and the pH range is more preferably from 1 to 5.

The acid to be used in preparing the acidic aqueous solution includes, for example, inorganic acids such as hydrochloric acid, nitric acid, sulfuric acid, hydrofluoric acid, phosphoric acid, boric acid, etc.; organic acids such as acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linolic acid, linoleic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, tartaric acid, succinic acid, fumaric acid, itaconic acid, mesaconic acid, citraconic acid, malic acid, glutaric acid hydrolyzate, maleic anhydride hydrolyzate, phthalic anhydride hydrolyzate, etc.

Above all, from the viewpoint of the cost, the removability and the reactivity thereof, preferred are inorganic acids and lower organic acids such as acetic acid, etc. One alone or two or more these acids may be used here either singly or as combined.

Water for use in preparing the acidic aqueous solution is preferably one in which the metal content is small so as to be appropriate for the object of the present invention, for example, ion-exchanged water, distilled water having an electric resistance of 10 MΩ/cm or more. For example, also preferred is a weakly acidic one prepared by adding an acid to ion-exchanged water or water in which the metal content is small.

The amount of the acidic aqueous solution for use for liquid-liquid extraction is not specifically defined, but when the amount is excessively small, then the extraction frequency for Zn removal must be increased. On the other hand, when the amount of the acidic aqueous solution is excessively large, then the total liquid amount would increase to worsen the operability of the system.

The amount of the acidic aqueous solution to be used is preferably from 100 to 3000 parts by weight relative to 100 parts by weight of the material to be purified, more preferably from 150 to 2500 parts by weight.

The liquid-liquid extraction treatment is carried out generally by stirring and fully mixing an organic solvent solution prepared by dissolving the material to be purified therein and an acidic aqueous solution serving as an extractant at a temperature of from 5 to 60°C, more preferably at a temperature of from 10 to 50°C, and then statically leaving the resultant mixture.

With that, the solution layer of the material to be purified and the aqueous layer are separated to be two layers, and the Zn ion having been contained in the solution of the material to be purified is thus transferred into the aqueous layer. In this stage, a centrifuge may be used for enhancing the separability of the solution layer of the material to be purified and the aqueous layer.

Through this treatment, the Zn content in the solution of the material to be purified can be reduced. Desirably, however, the resulting solution layer of the material to be purified is further put into water or into an acidic aqueous solution, and processed a few times for the treatment of stirring and mixing, static standing as such and liquid-liquid separation in the same manner as in the above-mentioned liquid-liquid extraction treatment, to thereby further more reduce the Zn content. Also desirably, after the extraction with such an acidic aqueous solution, the resultant solution is further processed for extraction a few times using water for acid removal. The water to be used in this step is also preferably ion-exchanged water or distilled water in which the metal content is small, like the water for use in preparing the acidic aqueous solution.

### (Method of Using Ion Remover)

One preferred embodiment of the method of reducing the Zn content using an ion remover is a method that comprises dissolving the material to be purified in an organic solvent to be mentioned below to give a liquid and then bringing the resultant liquid into contact with an ion remover.

As the contact method with an ion remover, there may be mentioned a method comprising adding an ion remover to a solution of the material to be purified, then mixing and fully stirring them, and thereafter removing the ion remover through filtration, and a method of introducing the solution of the material to be purified into a column filled with an ion remover.

The ion remover is preferably an ion-exchange resin. The ion-exchange resin may be an acidic cation-exchange resin or a basic anion-exchange resin. Of those, for removing a metal ion such as Zn, preferred is an acidic cation-exchange resin.

The acidic cation-exchange resin comprises, for example, a substrate of various polymers such as styrenic, acrylic, methacrylic polymers, in which various types of ion-exchange groups (functional groups) such as -SO₃M (-SO₃H), -COOM, -N=(CH₂COOM)₂ are introduced into the main chain, or that is, the main chain is modified with such an ion-exchange group. M in the ion-exchange groups (functional groups) is a metal element.

The acidic cation-exchange resin includes a strongly-acidic cation-exchange resin and a weakly-acidic cation-exchange resin. The strongly-acidic cation-exchange resin comprises a styrenic polymer as the substrate and has a sulfonic acid group (-SO₃H) as the ion-exchange group (functional group) therein, and this well ion-exchanges cations (positive ions) as impurities to trap them and remove them from the liquid being processed.

Here, the cations as impurities to be removed include Zn as well as other various types of metal ions and P, Si, etc. The metal ions include ions of metals belonging to Group Ia, Group IIa, Group VIa, Group VIIa and Group IIb of the Periodic Table, more concretely Ca, Cr, Fe, Pd, Na, Mg, Ni, Sn, K, etc. Specific examples of such strongly-acidic cation-exchange resins include Mitsubishi Chemical's "Diaion (registered trademark) SK110" (trade name), etc.

The weakly-acidic cation-exchange resin includes one comprising an acrylic polymer as the substrate and having an acrylic acid group as the ion-exchange group (functional group) therein, and one comprising a methacrylic polymer as the substrate and having a methacrylic acid group as the ion-exchange group (functional group) therein. Like the above-mentioned strongly-acidic cation-exchange resin, the weakly-acidic cation-exchange resin well ion-exchanges cations such as metal ions to trap them and remove them from the liquid being processed.

When the weakly-acidic cation-exchange resin is used especially in an amount excessive over the donor polymer in the liquid being processed, and when brought into contact with the liquid, the resin can selectively adsorb (ion-exchange) the low-molecular side component of the donor polymer to remove the component from the liquid being processed, like the above-mentioned strongly-acidic cation-exchange resin. Specific examples of the strongly-acidic cation-exchange resin of the type include Mitsubishi Chemical's "Diaion (registered trademark) WK100" (trade name), "Diaion (registered trademark) WK11" (trade name), etc.

These ion-exchange resins are not specifically defined in point of the morphology thereof, and various types of ion-exchange resins are usable here. For example, granular or fibrous resins, or woven or nonwoven fabrics of such fibrous resins, and further various compact bodies shaped in various forms are usable here.

Also preferably, the above-mentioned acidic cation-exchange resin is used for cation removal and, at the same time, a basic anion-exchange resin is used for removing anionic impurities, thereby prolonging the life of the organic electroluminescent element produced using the composition of the present invention.

The basic anion-exchange resin comprises, for example, various polymers such as styrenic, acrylic polymers as the substrate, and has various types of ion-exchange groups (functional groups) such as quaternary ammonium bases (quaternary amines), tertiary amines, primary or secondary polyamines introduced into the main chain thereof, or that is the main chain of the resin is modified with such an ion-exchange resin.

The basic anion-exchange resin includes a strongly-basic anion-exchange resin and a weakly-basic anion-exchange resin.

The strongly-basic anion-exchange resin comprises, for example, a styrenic polymer as the substrate and has a quaternary ammonium base (quaternary amine) as the ion-exchange group (functional group) therein, and the resin well ion-exchanges anions (negative ions) as impurities to trap them and remove them from the liquid being processed.

The anions as impurities to be removed include inorganic ions and organic ions such as a sulfate ion (SO₄²⁻), a formate ion (HCO₂⁻), an oxalate ion (C₂O₄²⁻), an acetate ion (CH₃COO⁻), an F⁻ ion, a Cl⁻ ion, a Br⁻ ion, an NO₃⁻ ion, etc.

Specific examples of such strongly-basic anion-exchange resins include Mitsubishi Chemical's "Diaion (registered trademark) NSA100" (trade name), "Diaion (registered trademark) SAN1" (trade name), etc.

The weakly-basic anion-exchange resin includes one comprising a styrenic polymer as the substrate and having a tertiary amine as the ion-exchange group (functional group), and one comprising an acrylic polymer as the substrate and having a primary or secondary polyamine as the ion-exchange group (functional group); and like the above-mentioned strongly-basic anion-exchange resin, this resin also well ion-exchanges anions such as a sulfate ion (sulfonate ion) to trap them and remove them from the liquid being processed.

Specific examples of the weakly-basic anion-exchange resins include Mitsubishi Chemical's "Diaion (registered trademark) WA20" (trade name), etc.

As the ion remover, preferably used here is an inorganic ion-exchange material. The inorganic ion-exchange material comprises a metal salt such as a metal oxide, and includes a type that adsorbs a cation for ion exchange; a type that adsorbs an anion for ion exchange; and a type that adsorbs both a cation and an anion for ion exchange.

The inorganic ion-exchange material of the type of cation exchange includes antimony pentoxide (Sb₂O₅) hydrate (for example, Toa Gosei's "IXE (registered trademark)-300" (trade name)), titanium phosphate (for example, Toa Gosei's "IXE (registered trademark)-400" (trade name)), zirconium phosphate (for example, Toa Gosei's IXE (registered trademark)-100" (trade name)), etc.

The inorganic ion-exchange material of the type of anion exchange includes bismuth oxide hydrate (for example, Toa Gosei's "IXE (registered trademark)-500" (trade name)), lead phosphate hydroxide (for example Toa Gosei's "IXE (registered trademark)-1000" (trade name)), etc. In particular, bismuth oxide hydrate has a high adsorption selectivity for a sulfate ion (SO₄²⁻).

As the ion remover, also usable here are active carbon, activated earth, silica, silica gel , in addition to the above-mentioned ion-exchange agents.

### (Reprecipitation Method)

The reprecipitation method for Zn content reduction is a method comprising dissolving the material to be purified in a suitable solvent (good solvent) capable of dissolving the material, adding a bad solvent to the resulting solution and precipitating the material to be purified as a solid for purifying the material. The amount of the good solvent to be used in the reprecipitation method is, in general, preferably at least 5 times by mass the material to be purified, for the purpose of completely dissolving therein the material to be purified such as the aromatic amine polymer to be purified, more preferably at least 10 times by mass.

The organic solvent to be used here is preferably an alcoholic organic solvent such as methanol, ethanol, an aliphatic organic solvent such as pentane, hexane, heptane, or an aromatic organic solvent such as benzene, toluene, among the organic solvents for purification to be mentioned below. Naturally, it is desirable that the amount of impurities in the organic solvent to be used is small.

### (Washing Method with Organic Solvent)

The washing method with an organic solvent, which is used for Zn content reduction, is a method comprising selecting a suitable organic solvent capable of dispersing the material to be purified and having a suitable volatility, and washing the material to be purified with the selected solvent. The organic solvent to be used in the washing method with an organic solvent may be one that may dissolve in some degree the material to be purified such as an aromatic amine polymer, etc.

The organic solvent for use in the washing method with an organic solvent is preferably an alcoholic organic solvent such as methanol, ethanol, isopropanol, butanol, etc.

The manner of operation of the washing method with an organic solvent is described. Herein employable are a dispersive washing mode, in which a mixture of the material to be purified and an organic solvent is mixed generally for from 1 minute to 70 hours, preferably from 5 minutes to 24 hours, more preferably from 10 minutes to 6 hours, using a mixing apparatus such as a dissolve, a homomixer, a homogenizer, a paint shake, a three-roll mixer, a two-roll mixer, or a bead mill, and thereafter the organic solvent is separated through filtration, or decantation, and then the resultant residue is dried; an ultrasonic washing mode, in which a mixture of the material to be purified and an organic solvent is irradiated with ultrasonic waves having a frequency of generally from 1 to 300 KHz, preferably from 2 to 100 KHz, generally for 30 seconds to 10 hours, preferably for 1 minute to 5 hours, in an ultrasonic mixing apparatus such as an ultrasonic dispersive homogenizer, an ultrasonic washer, etc., and thereafter the organic solvent is removed through filtration, or decantation, and then the resultant residue is dried; a stirring washing mode, in which a mixture of the material to be purified and an organic solvent is stirred generally at a rotation number of from 50 to 15,000 rpm, preferably from 100 to 2,000 rpm and generally for 5 minutes to 10 hours, preferably for 10 minutes to 5 hours, using a paddle stirrer, and thereafter the organic solvent is removed through filtration, decantation, and then the resultant residue is dried; etc.

These operations may be carried out separately, or two or more of them may be combined. The concentration of the material to be purified in these operations is generally from 0.1 to 70% by weight, preferably from 1 to 50% by weight.

### (Organic Solvent for Purification)

The organic solvent for use in the above-mentioned purification methods may be the same as the organic solvent for use in preparing the composition of the present invention. From the viewpoint of the Zn removability thereof, for example, preferred is use of the following organic solvents.

There are mentioned ester organic solvents such as methyl acetate, ethyl acetate, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetacetate, ethyl acetacetate, propylene glycol acetate monobutyl ether, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, diethyl phthalate, etc.; aliphatic hydrocarbon organic solvents such as n-pentane, i-pentane, n-hexane, i-hexane, n-heptane, i-heptane, 2,2,4-trimethypentane, n-octane, i-octane, cyclohexane, methylcyclohexane, etc.; aromatic hydrocarbon organic solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, n-amylnaphthalane, trimethylbenzene, etc.; ketone organic solvents such as cyclopentanone, cyclohexanone, 2-hexanone, 2-heptanone, methylcyclohexanone, etc.; ether organic solvents such as diethyl ether, tetrahydrofuran, etc.

Two or more these organic solvents may be used simultaneously, as combined.

### (Purification Method for Organic Solvent)

Regarding the purification method for the organic solvent for use for preparing the composition of the present invention, the organic solvent may be purified according to the same method as the purification method for the material to be purified mentioned hereinabove, in which the organic solvent to be purified is used in place of the solution of the material to be purified.

### <Storage of Composition>

The composition of the present invention can maintain the uniform solution state thereof, by sealing it up in a specific glass container and by storing it therein, since the metal to be a factor for formation of foreign substances in the composition can be trapped by the wall surface of the glass container during storage therein. Consequently, the composition enables stable and uniform film formation, not having any foreign substance formed therein. Accordingly, when the composition for organic electroluminescent elements of the present invention that has been sealed up and stored in a specific glass container is used to produce the organic electroluminescent element of the present invention, then the thus-formed organic electroluminescent element is free from short circuit and dark spots and has a long driving life.

Specifically, it is desirable that the composition for organic electroluminescent elements of the present invention is stored as a sealed body sealed up in a specific glass container.

The glass container is such that such that, in the inner surface of the container that is in contact with the composition for organic electroluminescent elements (hereinafter this may be referred to as "contact surface"), the areal ratio of the surface projection/recess part of being the total of the projection regions projecting from the base level by 0.8 nm or more and the recess regions recessing from the surface level by 0.8 nm or more, as calculated from the projected area, is 0.2% or more.

Also preferably, the glass container is such that, in the contact surface of the glass container, the areal ratio of the surface recess part of the recess regions recessing from the base level by 0.8 nm or more, as calculated from the projected area, is 0.1% or more.

More preferably, the glass container is such that, in the contact surface of the glass container, the total of the number of the projection regions projecting from the base level by 0.8 nm or more and the number of the recess regions recessing from the base level by 0.8 nm or more in an arbitrarily-selected region of 10 µm × 10 µm is 5 or more.

The projected area of the contact surface of the inner surface of the container is the area of an arbitrarily-selected region of the contact surface of the inner surface of the container that is the sample to be analyzed, as seen in the vertical direction relative to the contact surface of the inner surface of the container. Concretely, an arbitral contact surface of 10 µm × 10 µm may be the area seen in the vertical direction relative to the contact surface.

The inner surface of the container is macroscopically a curved one in many cases, but the minor region of 10 µm × 10 µm can be approximately considered as a flat plane, and the vertical direction relative to the contact surface of the inner surface of the container in the region of 10 µm × 10 µm is determined unambiguously.

Consequently, the projection regions projecting from the base level by 0.8 nm **or more** in the contact surface of the inner surface of the container, as calculated from the projected area, is the projected area of the projection regions projecting from the base level of the inner surface of the container by 0.8 nm or more, as seen in the vertical direction relative to the inner surface of the container; and the recess regions recessing from the base level by 0.8 nm or more in the contact surface of the inner surface of the container, as calculated from the projected area, is the projected area of the recess regions recessing from the base level of the inner surface of the container by 0.8 nm or more, as seen in the vertical direction relative to the inner surface of the container.

**In** the contact surface kept in contact with the composition for organic electroluminescent elements in the inner surface of the glass container, the areal ratio of the surface projection/recess part of being the total of the projection regions projecting from the base level by 0.8 nm or more and the recess regions recessing from the base level by 0.8 nm or more, as calculated from the projected area, is 0.2% or more. Concretely, it is desirable that the areal ratio is determined as the areal ratio of the surface projection/recess part indicated by the following (ii), through AFM shown by the following (i), relative to the contact surface of the inner surface of the container that is kept in contact with the composition for organic electroluminescent elements.

In the contact surface kept in contact with the composition for organic electroluminescent elements in the inner surface of the glass container, the areal ratio of the surface recess part of the recess regions recessing from the base level by 0.8 nm or more, as calculated from the projected area, is 0.1% or more. Concretely, it is desirable that the areal ratio is determined as the areal ratio of the surface recess part indicated by the following (iii), through AFM shown by the following (i).

In the contact surface kept in contact with the composition for organic electroluminescent elements in the inner surface of the glass container, the total of the number of the projection regions projecting from the base level by 0.8 nm or more and the number of the recess regions recessing from the base level by 0.8 nm or more in an arbitrarily-selected region of 10 µm × 10 µm is 5 or more. Concretely, it is desirable that the total is determined as the surface projection/recess density shown by the following (iv), through AFM shown by the following (i).
(i) In arbitrary two sites of the contact surface of the glass container, the AFM image of a region of 10 µm × 10 µm arbitrarily selected for each site is referred to as one sample. Each one sample is sectioned into 256 × 256 sections, and the height information data are measured in every section.
(ii) The total area of the projection regions higher by 0.8 nm or more than the base level and the recess regions lower by 0.8 nm or more than the base level, as detected in one sample, is calculated as the percentage relative to the area (10 µm × 10 µm) of one sample, and the mean value of all the samples is calculated to be the areal ratio of the surface projection/recess part.
(iii) The total area of the recess regions lower by 0.8 nm or more than the base level, as detected in one sample, is calculated as the percentage relative to the area (10 µm × 10 µm) of one sample, and the mean value of all the samples is calculated to be the areal ratio of the surface recess part.
(iv) The number of the projection regions higher by 0.8 nm or more than the base level and the number of the recess regions lower by 0.8 nm or more than the base level, as detected in one sample (10 µm × 10 µm), is totaled, and the mean value of all the samples is calculated to be the surface projection/recess density.

Here, the projection region higher by 0.8 nm or more than the base level means a region of one projection section or an aggregation of plural continuing projection sections each higher by 0.8 nm or more than the base level, and the surrounding thereof is not such a projection section higher by 0.8 nm or more.

The recess region lower by 0.8 nm or more than the base level means a region of one recess section or an aggregation of plural continuing recess sections each lower by 0.8 nm or more than the base level, and the surrounding thereof is not such a recess section lower by 0.8 nm or more.

The base level is a plane of a flat region or a plane defined by the average of the projections and the recesses in the region being analyzed. Preferred is the plane defined by the average of the projections and the recesses in the region being analyzed, as simple and is reproducible.

For observing the contact surface, preferred is AFM as reproducible.

The advantageous effects of the present invention using the glass container, of which the contact surface has the above-mentioned characteristic feature of the surface projection/recess profile, are as mentioned below.

In case where meta impurities exist in the composition of the present invention, they may aggregate with time during long-term storage of the composition and may form a foreign substance having a size of, for example, 0.1 µm or more. In an organic electroluminescent element device of one application use of the composition of the present invention, the thickness of the organic layer is on a level of from a few nm to several tens nm or several hundred nm or so. In this, consequently, even a foreign substance having such a size would have some influence on the electric properties of the membrane, therefore causing electric short circuit to form display defects.

In case where the composition of the present invention contains such minor contaminating metal impurities, the glass container in the present invention can trap the impurities on the surface projections and recesses in the contact surface thereof during storage of the composition in the container, and therefore the container can function as a metal-carrying container capable of preventing aggregation.

In order that the glass container in the present invention can sufficiently exhibit the metal-trapping function thereof, it is desirable that the contact surface of the glass container has optimum projections and recesses, and also preferably, the contact surface thereof has polarity.

When the areal ratio of the surface projection/recess part of the contact surface of the glass container in the present invention is 0.2% or more, then the surface projections and recesses of the container can sufficiently express the effect thereof to trap foreign substances that may exist in the composition. From the viewpoint of the foreign substance-trapping effect, the areal ratio of the surface projection/recess part is preferably larger, and is preferably 0.5% or more, more preferably 0.7% or more.

The areal ratio of the surface projection/recess part of the glass container is generally 20% or less, because stains adhering to the container could be readily washed away, because the solution stored in the container would hardly adhere and remain on the wall surface of the container when the solution is used, and therefore the utilization efficiency of the solution in the container could be high, and because the container components would hardly dissolve out.

For securing the foreign substance-trapping effect of the surface projection/recess part of the container, it is especially desirable that the areal ratio of the surface recess part, which indicates the abundance of the recesses capable of taking and trapping foreign substances therein, is 0.1% or more, more preferably 0.3% or more.

The areal ratio of the surface recess part in the contact surface of the glass container is generally 30% or less, because stains adhering to the container could be readily washed away, because the solution stored in the container would hardly adhere and remain on the wall surface of the container when the solution is used, and therefore the utilization efficiency of the solution in the container could be high, and because the container components would hardly dissolve out.

From the viewpoint of the foreign substance-trapping effect of the surface projections and recesses of the container, the surface projection/recess density that indicates the number of the surface projections and recesses per unit area is preferably higher, and is preferably 5 or more, more preferably 7 or more, even more preferably 10 or more.

The surface projection/recess density of the contact surface of the glass container is generally 80 or less and is preferably 50 or less, because stains adhering to the container could be readily washed away, because the solution stored in the container would hardly adhere and remain on the wall surface of the container when the solution is used, and therefore the utilization efficiency of the solution in the container could be high, and because the container components would hardly dissolve out.

The upper limit of the height of the projection and the upper limit of the depth of the recess are not specifically defined. The upper limit of the height of the projection from the base level is generally 7 nm or less, and the upper limit of the depth of the recess from the base level is generally 7 nm or less.

Regarding the size of one projection region and the size of one recess region in the contact surface of the glass container, it is desirable that the diameter (the length of the part of the longest distance between two parallel lines that are drawn to sandwich the projected projection/recess area) of the hillock (projection) or the hollow (recess) is from 0.05 to 3 µm. The projection/recess diameter is preferably 0.1 µm or more, more preferably 0.5 µm or more.

In case where an AFM image of 10 µm × 10 µm is referred to as one sample and where one sample is sectioned into 256 × 256 sections and the height information data of each sample are measured, the diameter is defined by the length of the part of the longest distance between two parallel lines that are drawn to be tangential to the side or the apex of the projection region or the recess region expressed as an aggregation of sections (one section is a square of 0.039 µm × 0.039 µm).

When the diameter of the projection/recess is smaller, the surface area of the contact surface is smaller and therefore the metal-trapping effect is lower. Consequently, increasing the surface area of the contact surface enhances the metal-trapping effect.

When the diameter of the hollows is too small, then the probability of the foreign substance in the composition going into the hollows may be small, and therefore the metal-trapping efficiency may lower. In consideration of the thickness of the layer to be formed of the composition, the foreign substance that would be problematic when existing in the composition would be one having a size of 0.01 µm or more.

The surface projection/recess of the glass container is preferably one capable of effectively trapping such foreign substances that may be formed in the composition during storage.

It is desirable that all the contact surface of the glass container in the present invention satisfies the above-mentioned areal ratio of the surface projection/recess part, and preferably satisfies the above-mentioned areal ratio of the surface recess part and satisfies the above-mentioned surface projection/recess density.

**In** case where at least 30% of the contact surface, more preferably at least 50% of the contact surface satisfies the above-mentioned areal ratio of the surface projection/recess part, and further satisfies the above-mentioned areal ratio of the surface recess part and the above-mentioned surface projection/recess density, then the glass container of the type secures the foreign substance-trapping effect in the present invention.

Also for fully securing the foreign substance-trapping effect of the glass container in the present invention during storage of the composition of the present invention in the container, it is desirable that the composition of the present invention is sealed up and stored in the glass container of the type at least for 16 hours, especially at least for 1 day or more.

When the storage term is too short and in a case where a highly-purified composition is stored, the possibility of metal aggregation to form a foreign substance would be low. Accordingly, in the case, the foreign substance-trapping effect of the glass container could not be realized. On the other hand, however, when the storage term is too long and in a case where a composition having poor stability is stored, the degradation of the composition such as aggregation or decomposition thereof may occur and develop.

As the material for a general container for storage of a composition for organic electroluminescent elements, there may be mentioned plastic containers (resin containers), glass containers, metal containers.

Metal containers have a risk of metal release from the metal surface; and plastic containers have a risk of absence of heat resistance, chemical resistance, etc. From the viewpoint of having no such risks and facilitating confirmation of contents, and from the viewpoint of the safety, glass containers are preferably used in the present invention.

Regarding the material of glass of the glass containers, preferred is borosilicate glass from the viewpoint that the glass material of the type releases few ions into the composition of the present invention. Soda glass may also be used as the glass material for the glass containers. However, soda glass releases a large amount of Na from glass, and therefore borosilicate glass is preferred.

The surface projection/recess of the glass container is considered to be covered with mainly a silanol group. The glass container that satisfies the above-mentioned areal ratio of the surface projection/recess part and further satisfies the areal ratio of the surface recess part and the surface projection/recess density can enjoy an increased chemical effect of trapping metals, since the surface area of the silanol group is enlarged.

**In** addition, owing to the synergistic effect with the physical binding force of the surface projection/recess that forms three-dimensional pockets capable of trapping ions and foreign substances, metal ions can be trapped on the contact surface of the container. Accordingly, the container can prevent the composition from forming aggregations to be foreign substances therein.

Even if any foreign substance is formed, it may be trapped on the contact surface of the container, and the foreign substance can be prevented from freely floating in the composition. When the composition of the type is used for film formation, the formed film can be prevented from being contaminated from foreign substances.

For forming on the contact surface of the container the surface projections/recesses satisfying the above-mentioned areal ratio of the surface projection/recess part and further satisfying the areal ratio of the surface recess part and the surface projection/recess density, the temperature increase profile and the cooling speed may be suitably controlled in the heating and cooling step in the process of producing the glass tube to be the container. According to a sand-blasting method using particles, the surface of the formed glass container may be roughened, and the method is effective herein.

Commercially-available glass containers may be analyzed through AFM as mentioned above, and the glass containers having the surface projection/recess profile that satisfies the above-mentioned areal ratio of the surface projection/recess part and further satisfying the areal ratio of the surface recess part and the surface projection/recess density may be selected for use in the present invention.

### <Anion Component>

As described above, Zn, if any, in the composition may form an insoluble precipitate, after reacted with an anion component. **In** particular, the salt to be formed through ionic bonding is generally insoluble in organic solvents, and precipitates in organic solvents. Accordingly, it is desirable that anion components, especially anion components containing sulfur (S) as the constituent ingredient are reduced. Sulfur (S) reduction is described below.

### <Description of S>

It is desirable that the composition of the present invention has a reduced S content (S concentration) of less than 20 ppm, more preferably less than 5 ppm, even more preferably less than 1 ppm.

S to be contained in the composition of the present invention is generally one derived from organic compounds, and in general, the S component contained in the organic solvents used in preparing the composition would be brought into the composition.

In the present invention, the reason why S contained in an organic solvent is brought into the composition is as mentioned below.

The composition of the present invention is prepared by dissolving an aromatic amine polymer in an organic solvent. Regarding the necessary properties of the organic solvent to be used in the composition of the present invention for dissolving such aromatic amine polymer therein, it is desired that the solvent has not a little polarity.

In producing an organic solvent having a polar group, used are a catalyst using sulfuric acid or a sulfuric acid derivative and a reagent for introducing a polar group.

For example, an ester organic solvent is synthesized using an alcohol and a catalytic amount of an acid such as sulfuric acid, along with the starting material of a carboxylic acid. As the case may be, the solvent of the type may be produced by reacting a starting carboxylic acid and a sulfate ester such as dimethyl sulfate, diethyl sulfate, dibutyl sulfate, etc.

When purification is insufficient after the reaction, then sulfuric acid or a sulfate ester may remain in the produced organic solvent.

When a composition is prepared using the organic solvent that contains such remaining sulfuric acid or remaining sulfate ester, then the composition shall contain S. Sulfuric acid in the composition may directly form a complex with a metal ion therein, and diethyl sulfate therein may gradually decompose to be sulfuric acid and may then form a complex with a metal ion. The formed complex precipitates as a foreign substance in the composition.

Sulfuric acid and a sulfate ester are compared. In general, sulfuric acid can be readily removed in a washing step with water, but a sulfate ester is hardly removed by washing with water and, as the case may be, the ester could not be removed even in separation purification through distillation.

These would not provide a problem just after the preparation of the composition, but with the lapse of time, these would prove some problem. In particular, it is desirable to use an organic solvent in which the S content derived from an organic compound, for example, a sulfate ester such as diethyl sulfate is reduced.

Reducing the S concentration in the composition of the present invention prevents the metal contained in the composition from precipitating to form a foreign substance, and therefore realizes a composition in which the content of the foreign substance is reduced and which is free from troubles during film formation.

Preferably, in the composition of the present invention, the amount of the foreign substances to be formed of S and the metal component in the composition is smaller. When the composition is filtered through a filter having a pore size of 0.1 µm, it is desirable that particles having a long diameter of 0.5 µm or more do not remain on the filter.

The metal component in the composition to form a complex to be a foreign substance includes those that may inevitably mix in the composition from the solid materials such as the aromatic amine polymer to constitute the composition and from other materials such as organic solvent, etc.; from the containers to be used for mixing the materials in preparing the composition; from the ambient environments in mixing the materials to prepare the composition; and further from the containers in which the composition is put and stored. Of those, in particular, Zn may readily form foreign substances, and therefore, it is desirable that, in the composition of the present invention, the Zn content is small, and the Zn content is preferably less than 0.5 ppm.

### <Method for Reducing S>

A method for purifying an organic solvent is described below in order to reduce the S content in the present invention to less than 20 ppm.

As described above, the S content in the composition of the present invention is preferably less than 20 ppm, more preferably less than 5 ppm, even more preferably less than 1 ppm. In producing the composition of the present invention, as the method for reducing the S content in the organic solvent for use in preparing the composition, there are mentioned a washing method with water, and a method of using an ion remover.

### (Method of Using Ion Remover)

As the method of reducing the S concentration using an ion remover, there is mentioned a method of bringing the organic solvent into contact with an ion-exchange resin.

As the ion-exchange resin, usable is an acidic cation-exchange resin or a basic anion-exchange resin. Of those, suitably used here is a basic anion-exchange resin for removing an S component such as SO₄²⁻, etc.

The basic anion-exchange resin comprises, for example, various types of polymers such as a styrenic polymer or an acrylic polymer as the substrate and has various types of ion-exchange groups (functional groups) such as a quaternary ammonium base (quaternary amine), a tertiary amine, a primary or secondary polyamine as introduced into the main chain thereof, or that is, the resin is modified with such an ion-exchange group.

The basic anion-exchange resin includes a strongly-basic anion-exchange resin and a weakly-basic anion-exchange resin.

The strongly-basic anion-exchange resin comprises, for example, a styrenic polymer as the substrate and has a quaternary ammonium base (quaternary amine) as the ion-exchange group (functional group) therein, and the resin well ion-exchanges anions (negative ions) as impurities to trap them and remove them from the liquid being processed.

Here, the anions as impurities to be removed include inorganic ions and organic ions such as a sulfate ion (SO₄²⁻), a formate ion (HCO₂⁻), an oxalate ion (C₂O₄²⁻), an acetate ion (CH₃COO⁻), an F⁻ ion, a Cl⁻ ion, a Br⁻ ion, an NO₃⁻ ion, etc.

Specific examples of such strongly-basic anion-exchange resins include Mitsubishi Chemical's "Diaion (registered trademark) NSA100" (trade name), "Diaion (registered trademark) SAN1" (trade name), etc.

The weakly-basic anion-exchange resin includes one comprising a styrenic polymer as the substrate and having a tertiary amine as the ion-exchange group (functional group), and one comprising an acrylic polymer as the substrate and having a primary or secondary polyamine as the ion-exchange group (functional group); and like the above-mentioned strongly-basic anion-exchange resin, this resin also well ion-exchanges anions such as a sulfate ion (sulfonate ion) to trap them and remove them from the liquid being processed.

Specific examples of the weakly-basic anion-exchange resins include Mitsubishi Chemical's "Diaion (registered trademark) WA20" (trade name), etc.

Also preferably, the above-mentioned basic anion-exchange resin is used for anion removal and, at the same time, an acidic cation-exchange resin is used for removing cationic impurities, thereby prolonging the life of the organic electroluminescent element produced using the composition of the present invention.

The acidic cation-exchange resin comprises, for example, a substrate of various polymers such as styrenic, acrylic, or methacrylic polymers, in which various types of ion-exchange groups (functional groups) such as -SO₃M (-SO₃H), -COOM, or -N=(CH₂COOM)₂ are introduced into the main chain, or that is, the main chain is modified with such an ion-exchange group. M in the ion-exchange groups (functional groups) is a metal element.

The acidic cation-exchange resin includes a strongly-acidic cation-exchange resin and a weakly-acidic cation-exchange resin. The strongly-acidic cation-exchange resin comprises a styrenic polymer as the substrate and has a sulfonic acid group (-SO₃H) as the ion-exchange group (functional group) therein, and this well ion-exchanges cations (positive ions) as impurities to trap them and remove them from the liquid being processed.

Here, the cations as impurities to be removed include Zn as well as other various types of metal ions and P, Si, etc. The metal ions include ions of metals belonging to Group Ia, Group IIa, Group VIa, Group VIIa and Group IIb of the Periodic Table, more concretely Ca, Cr, Fe, Pd, Na, Mg, Ni, Sn, K, etc. Specific examples of such strongly-acidic cation-exchange resins include Mitsubishi Chemical's "Diaion (registered trademark) SK110" (trade name), "Diaion (registered trademark) SKN1" (trade name), etc.

The weakly-acidic cation-exchange resin includes one comprising an acrylic polymer as the substrate and having an acrylic acid group as the ion-exchange group (functional group) therein, and one comprising a methacrylic polymer as the substrate and having a methacrylic acid group as the ion-exchange group (functional group) therein. Like the above-mentioned strongly-acidic cation-exchange resin, the weakly-acidic cation-exchange resin well ion-exchanges cations such as metal ions to trap them and remove them from the liquid being processed.

When the weakly-acidic cation-exchange resin is used especially in an amount excessive over the donor polymer in the liquid being processed, and when brought into contact with the liquid, the resin can selectively adsorb (ion-exchange) the low-molecular side component of the donor polymer to remove the component from the liquid being processed, like the above-mentioned strongly-acidic cation-exchange resin. Specific examples of the weakly-acidic cation-exchange resin of the type include Mitsubishi Chemical's "Diaion (registered trademark) WK100" (trade name), etc.

These ion-exchange resins are not specifically defined in point of the morphology thereof, and various types of ion-exchange resins are usable here. For example, granular or fibrous resins, or woven or nonwoven fabrics of such fibrous resins, and further various compact bodies shaped in various forms are usable here.

As the ion remover, an inorganic ion-exchange material is also preferably used here. The inorganic ion-exchange material comprises a metal salt such as a metal oxide, and includes a type that adsorbs a cation for ion exchange; a type that adsorbs an anion for ion exchange; and a type that adsorbs both a cation and an anion for ion exchange.

The inorganic ion-exchange material of the type of cation exchange includes antimony pentoxide (Sb₂O₅) hydrate (for example, Toa Gosei's "IXE (registered trademark)-300" (trade name)), titanium phosphate (for example, Toa Gosei's "IXE (registered trademark)-400" (trade name)), zirconium phosphate (for example, Toa Gosei's IXE (registered trademark)-100" (trade name)), etc.

The inorganic ion-exchange material of the type of anion exchange includes bismuth oxide hydrate (for example, Toa Gosei's "IXE (registered trademark)-500" (trade name)), lead phosphate hydroxide (for example Toa Gosei's "IXE (registered trademark)-1000" (trade name)), etc. In particular, bismuth oxide hydrate has a high adsorption selectivity for a sulfate ion (SO₄²⁻).

As the contact method with such an ion remover, there may be mentioned a method comprising adding an ion remover to the organic solvent to be purified, then mixing and fully stirring them, and thereafter removing the ion remover through filtration, and a method of introducing the organic solvent to be purified into a column filled with an ion remover.

### (Washing Method with Water)

The organic solvent may be purified by thoroughly washing it with water.

However, it is still difficult to remove organic ions even according to the method of using an ion remover or according to the washing method with water, and therefore in preparing the composition of the present invention, it is desirable that the organic solvents to be used and the other materials are not processed using an organic S-containing compound.

In the present invention, the organic solvent to be used in preparing the composition is purified in the manner as mentioned above, whereby the composition can be prevented from being contaminated with S, and the S concentration in the composition of the present invention can be controlled to be less than 20 ppm, preferably less than 5 ppm, more preferably less than 1 ppm. The S concentration in the composition of the present invention is preferably smaller, and it is desirable that the S concentration therein is less than the detection limit in the process of analyzing the composition for the S concentration therein to be mentioned below.

When the S concentration in the composition is 20 ppm or more, then uniform film formation could not be realized owing to formation of S-caused foreign substances, and the organic electroluminescent element produced using the composition may be troubled by short circuit, dark spots, etc., and therefore it is impossible to obtain an organic electroluminescent element having a long driving life.

The S concentration in the composition of the present invention can be measured according to an ICP (spectrometry) method, as described in the section of Examples to be given hereinunder.

For markedly realizing the S concentration-reducing effect in producing the composition of the present invention, the present invention is especially effective in a case where an ester organic solvent such as ethyl benzoate, amyl benzoate, or butyl benzoate that may be readily contaminated with S is used in producing the composition.

### <Aromatic Amine Polymer>

The aromatic amine polymer for use in the composition for organic electroluminescent elements of the present invention is described below.

The aromatic amine polymer to be contained in the composition for organic electroluminescent elements of the present invention is a polymer compound having at least an aromatic amino group in the repeating unit therein and having a weight-average molecular weight of from 3,000 to 1,000,000.

Preferably, the aromatic amine polymer to be contained in the composition for organic electroluminescent elements of the present invention is a polymer compound having at least a triarylamine group in the repeating unit therein and having a weight-average molecular weight of from 3,000 to 1,000,000.

### (Regarding Molecular Weight)

The weight-average molecular weight (Mw) of the aromatic amine polymer in the present invention is 3,000 or more and is 1,000,000 or less, and is favorable for use in organic electroluminescent elements.

When the weight-average molecular weight of the aromatic amine polymer falls within the above range, then the solubility of the aromatic amine polymer in an organic solvent is good in wet film formation, and a uniform film is easy to form, and in addition, high-molecular-weight impurities are hardly formed, and for these reasons, the polymer can be readily purified and is free from industrial disadvantage.

On the other hand, when the weight-average molecular weight is lower than the range, then the glass transition temperature, the melting point and the vaporization temperature of the polymer may lower, and therefore the heat resistance thereof would be markedly degraded.

**In** case where a layer containing the aromatic amine polymer is formed according to a wet film formation method, the weight-average molecular weight of the polymer is preferably 100,000 or less, more preferably 60,000 or less, from the viewpoint of the solubility, the film formability and the heat resistance thereof. Similarly, the lower limit is preferably 5,000 or more, more preferably 10,000 or more.

The number-average molecular weight (Mn) of the aromatic amine polymer in the present invention is generally 2,500,000 or less, preferably 750,000 or less, more preferably 400,000 or less, and is generally 500 or more, preferably 1,500 or more, more preferably 3,000 or more.

The dispersion degree (Mw/Mn) of the aromatic amine polymer in the present invention is generally 10 or less, preferably 2.5 or less, more preferably 2.0 or less, and is preferably 1.0 or more, more preferably 1.1 or more, even more preferably 1.2 or more.

Falling within the above range is preferred, since the aromatic amine polymer is easy to purify, and since the solubility in organic solvent and the charge transportability of the polymer are good.

In the present invention, the weight-average molecular weight (and number-average molecular weight) may be determined through SEC (size exclusion chromatography) analysis. In SEC, a high-molecular-weight component takes a shorter elution time, and the low-molecular-weight component takes a longer elution time. Using a calibration curve drawn from the elution time of polystyrene (standard sample) having a known molecular weight, the elution time for the sample is converted into the molecular weight thereof, and accordingly, the weight-average molecular weight (number-average molecular weight) of the analyzed sample is thereby calculated.

### (Regarding Preferred Repeating Unit)

The aromatic amine polymer to be contained in the composition for organic electroluminescent elements of the present invention is preferably a polymer containing a repeating unit represented by the following formula (2): 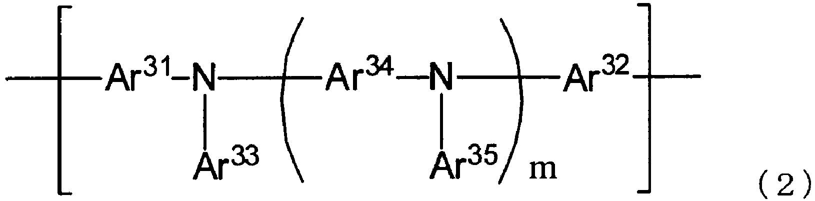 (In the formula, m indicates an integer of from 0 to 3, Ar³¹ and Ar³² each independently represent a direct bond, a divalent aromatic hydrocarbon-cyclic group optionally having a substituent, or a divalent aromatic heterocyclic group optionally having a substituent, Ar³³ to Ar³⁵ each independently represent an aromatic hydrocarbon-cyclic group optionally having a substituent, or an aromatic heterocyclic group optionally having a substituent. Here, Ar³³ and Ar³⁵ each are a monovalent group, and Ar³⁴ is a divalent group. However, Ar³¹ and Ar³² are not a direct bond at the same time.)

The aromatic hydrocarbon-cyclic group optionally having a substituent includes, for example, a 6-membered, single ring or 2- to 5-condensed ring having one or two free atomic valences, such as a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a fluoranthene ring, and a fluorene ring having one or two free atomic valences.

Here, in the present invention, the free atomic valence is one capable of forming a bond with any other free atomic valence, as described in Organic Chemistry, Biochemical Nomenclature (Vol. 1) (revised version of 2nd edition, issued by Nanko-do in 1992).

The aromatic heterocyclic group optionally having a substituent includes, for example, a 5- or 6-membered, single ring or 2- to 4-condensed ring having one or two free atomic valences, such as a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzimidazole ring, a perimidine ring, a quinazoline ring, a quinazolinone ring, and an azulene ring having one or two free atomic valences.

From the viewpoint of the solubility in organic solvent and the heat resistance, preferably, Ar³¹ to Ar³⁵ each are independently one ring selected from a group consisting of a benzene ring, a naphthalene ring, an anthracene ring, a phenanthrene ring, a triphenylene ring, a pyrene ring, a thiophene ring, a pyridine ring and a fluorene ring, optionally having a substituent and having one or two free atomic valences.

Also preferably, Ar³¹ to Ar³⁵ each are a group formed by bonding one or more rings selected from the above-mentioned group, via a direct bond or a group -CH=CH-, more preferably a biphenyl group or a terphenyl group.

From the viewpoint of the stability of organic electroluminescent elements, even more preferred is a benzene ring, a fluorene ring, a biphenyl group or a terphenyl group having one or two free atomic valences.

As the aromatic hydrocarbon-cyclic group optionally having a substituent and the aromatic heterocyclic group optionally having a substituent, for example, there are mentioned the groups listed in the following (Substituent Family Z).

### <Substituent Family Z>

An alkyl group preferably having from 1 to 24 carbon atoms, more preferably from 1 to 12 carbon atoms, such as a methyl group, an ethyl group, etc.;
An alkenyl group preferably having from 2 to 24 carbon atoms, more preferably from 2 to 12 carbon atoms, such as a vinyl group, etc.;
An alkynyl group preferably having from 2 to 24 carbon atoms, more preferably from 2 to 12 carbon atoms, such as an ethynyl group, etc.;
An alkoxy group preferably having from 1 to 24 carbon atoms, more preferably from 1 to 12 carbon atoms, such as a methoxy group, an ethoxy group, etc.;
An aryloxy group preferably having from 4 to 36 carbon atoms, more preferably from 5 to 24 carbon atoms, such as a phenoxy group, a naphthoxy group, a pyridyloxy group, etc.;
An alkoxycarbonyl group preferably having from 2 to 24 carbon atoms, more preferably from 2 to 12 carbon atoms, such as a methoxycarbonyl group, an ethoxycarbonyl group, etc.;
A dialkylamino group preferably having from 2 to 24 carbon atoms, more preferably from 2 to 12 carbon atoms, such as a dimethylamino group, a diethylamino group, etc.;
A diarylamino group preferably having from 10 to 36 carbon atoms, more preferably from 12 to 24 carbon atoms, such as a diphenylamino group, a ditolylamino group, an N-carbazolyl group, etc.;
An arylalkylamino group preferably having from 6 to 36 carbon atoms, more preferably from 7 to 24 carbon atoms, such as a phenylmethylamino group, etc.;
An acyl group preferably having from 2 to 24 carbon atoms, more preferably from 2 to 12 carbon atoms, such as an acetyl group, a benzoyl group, etc.;
a halogen atom, such as a fluorine atom, a chlorine atom, etc.;
A haloalkyl group preferably having from 1 to 12 carbon atoms, more preferably from 1 to 6 carbon atoms, such as a trifluoromethyl group, etc.;
An alkylthio group preferably having from 1 to 24 carbon atoms, more preferably from 1 to 12 carbon atoms, such as a methylthio group, an ethylthio group, etc.;
An arylthio group preferably having from 4 to 36 carbon atoms, more preferably from 5 to 24 carbon atoms, such as a phenylthio group, a naphthylthio group, a pyridylthio group, etc.;
A silyl group preferably having from 2 to 36 carbon atoms, more preferably from 3 to 24 carbon atoms, such as a trimethylsilyl group, a triphenylsilyl group, etc.;
A siloxy group preferably having from 2 to 36 carbon atoms, more preferably from 3 to 24 carbon atoms, such as a trimethylsiloxy group, a triphenylsiloxy group, etc.;
A cyano group;
An aromatic hydrocarbon-cyclic group preferably having from 6 to 36 carbon atoms, more preferably from 6 to 24 carbon atoms, such as a phenyl group, a naphthyl group, etc.;
An aromatic heterocyclic group preferably having from 3 to 36 carbon atoms, more preferably from 4 to 24 carbon atoms, such as a thienyl group, a pyridyl group, etc.

The above-mentioned substituents may further have a substituent, and examples of the substituent include those exemplified hereinabove for the substituent family Z.

The molecular weight of the substituent that the aromatic hydrocarbon-cyclic group and the aromatic heterocyclic group of Ar³¹ to Ar³⁵ may have is preferably 500 or less, more preferably 250 or less including the group that has the substituent.

From the viewpoint of the solubility in organic solvent, the substituent that the aromatic hydrocarbon-cyclic group and the aromatic heterocyclic group of Ar³¹ to Ar³⁵ may have is each independently preferably an alkyl group having from 1 to 12 carbon atoms, an alkoxy group having from 1 to 12 carbon atoms, an aromatic hydrocarbon-cyclic group having from 6 to 24 carbon atoms, or an aromatic heterocyclic group having from 4 to 24 carbon atoms, more preferably a methyl group, an ethyl group, a phenyl group or a naphthyl group; and from the viewpoint of the stability of organic electroluminescent elements, more preferred is a phenyl group or a naphthyl group.

When m is 2 or more, the repeating unit represented by the formula (2) has two or more Ar³⁴'s and Ar³⁵'s. In the case, these plural Ar³⁴'s and Ar³⁵'s may be the same or different, and Ar³⁴'s and Ar³⁵'s may bond to each other via a direct bond or a linking group to form a cyclic structure.

In the formula (2), m indicates an integer of 0 or more and 3 or less.

When m is 0, the case is preferred since the solubility of the aromatic amine polymer of the type in an organic solvent is increased and the film formability of the polymer is also increased.

When m is 1 more and 3 or less, the case is also preferred since the hole transportability of the aromatic amine polymer of the type is increased.

In accordance with the intended use and the situation, various compounds having a different value m may be employed.

### (Conjugated Polymer)

The aromatic amine polymer in the present invention is preferably a conjugated polymer, as comprising a repeating unit having a conjugated structure, and therefore having a sufficient charge transportability and a sufficient solubility in organic solvents.

More concretely, preferred is a polymer that comprises a repeating unit represented by the above-mentioned formula (2).

### (Nonconjugated Group)

Also preferably, the aromatic amine polymer in the present invention is a polymer that comprises a repeating unit represented by the following formula (3): 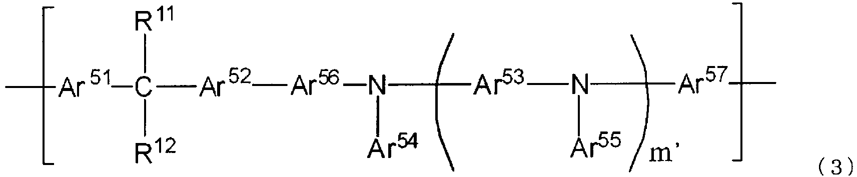 (In the formula, Ar⁵¹ to Ar⁵³ each independently represent a divalent aromatic group optionally having a substituent, Ar⁵⁴ and Ar⁵⁵ each independently represent an aromatic group optionally having a substituent, Ar⁵⁶ and Ar⁵⁷ each independently represent a direct bond, or a divalent aromatic group optionally having a substituent, R¹¹ and R¹² each independently represent a hydrogen atom, an alkyl group optionally having a substituent, an alkoxy group optionally having a substituent, or an aromatic group optionally having a substituent, m' indicates an integer of from 0 to 5, R¹¹ and R¹² may bond to each other to form a cyclic structure.)

Concretely, Ar⁵¹, Ar⁵², Ar⁵³, Ar⁵⁶ of a divalent aromatic group optionally having a substituent, and Ar⁵⁷ of a divalent aromatic group optionally having a substituent are the same groups as those of the above-mentioned Ar³¹ and Ar³².

Ar⁵⁴, Ar⁵⁵, R¹¹ of an aromatic group, and R¹² of an aromatic group are the same groups as those of the above-mentioned Ar³³ and Ar³⁵

The substituent that Ar⁵¹ to Ar⁵⁷, R¹¹ and R¹² may have is the same as in the above-mentioned substituent family Z.

In case where R¹¹ and R¹² each are an aromatic group optionally having a substituent, R¹¹ and R¹² are the same groups as those of the above-mentioned Ar³³ and Ar³⁵

From the viewpoint of the solubility, R¹¹ and R¹² each are preferably an alkyl group having from 1 to 12 carbon atoms or an alkoxy group having from 1 to 12 carbon atoms, more preferably an alkyl group having from 1 to 12 carbon atoms.

### (Insolubilizing Group)

When the aromatic amine polymer in the present invention is a conjugated polymer, it is desirable that the polymer further has an insolubilizing group from the viewpoint that the polymer of the type facilitates lamination and realizes surface smoothness in film formation. In other words, it is desirable that the aromatic amine polymer in the present invention is a conjugated polymer having an insolubilizing group.

The insolubilizing group is a group that reacts through heating and/or irradiation with active energy rays such as light, and the group has an effect of lowering the solubility in organic solvent and water of the polymer after reaction as compared with that before reaction.

In the present invention, the insolubilizing group is preferably a dissociating group or a crosslinking group.

The aromatic amine polymer has, as the substituent therein, a group that contains an insolubilizing group, in which the position of the insolubilizing group may be in the repeating unit represented by the formula (2), or in any other part than the repeating unit represented by the formula (2), for example, in the terminal group.

The aromatic amine polymer having a dissociating group may be hereinafter referred to as a "dissociating polymer", and the aromatic amine polymer having a crosslinking group may be as a "crosslinking polymer".

### <Dissociating Group>

The dissociating group is a group that exhibits solubility in organic solvent, and is a group capable of thermally dissociating from the group to which it bonds (for example, hydrocarbon ring) at 70°C or higher. After the dissociating group has dissociated from the polymer, the solubility of the polymer in organic solvent lowers.

However, the dissociating group does not include a group to which, after having dissociated, any other atom may bond, for example, a group that may dissociate through hydrolysis. The group capable of dissociating through hydrolysis has an active proton after dissociation. The active proton, if any, in elements would have some negative influence on elements.

Preferably, the dissociating group bonds to a hydrocarbon ring, and the hydrocarbon ring is condensed with an aromatic hydrocarbon ring not having a polar group, and more preferably, the dissociating group is a group capable of thermally dissociating through retro Diels-Alder reaction.

Preferably, the thermally-dissociating temperature is 100°C or higher, more preferably 120°C or higher, and is preferably 300°C or lower, more preferably 240°C or lower.

Falling within the range, the polymer is easy to produce, and is difficult to decompose during film formation.

In particular, in addition, a group having a steric structure capable of preventing intermolecular stacking is preferred as excellent in solubility. Examples of dissociation reaction through which the dissociating group dissociates from the compound are shown below.

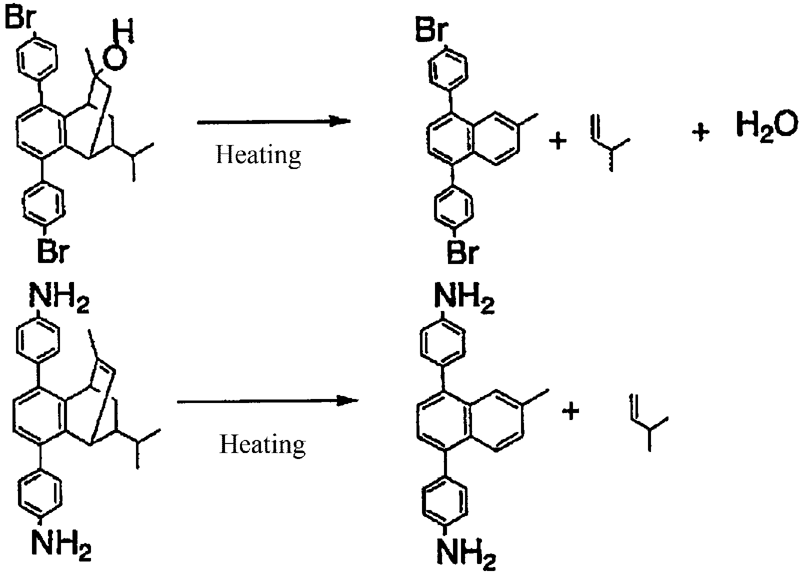

**In** the above-mentioned reaction formulae, the dissociating group is the part surrounded by the circle in the following structure.

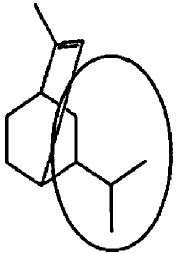

Examples of dissociation of such a dissociating group include, for example, sulfinylacetamide removal (see JACS, V124, No. 30, 2022, 8813), olefin removal, alcohol removal, alkyl removal (see H. Kwart and K. King, Department of Chemistry, University of Delaware, New York, Delaware 19771, pp. 415-447 (1967), O. Diels and K. Alder, Ber., 62, 554 (1929) and M. C. Kloetzel, Org. Reactions, 4, 6 (1948)), 1,3-dioxol removal (see N. D. Field, J. Am. Chem. Soc., 83, 3504 (1961)), diene removal (see R. Huisgen, M. Seidel, G. Wallbillich, and H, Knupfer, Tetrahedron, 17, 3 (1962)), isoxazol removal (see R. Huisgen and M. Christi, Angew. Chem. Intern. Ed. Engl., 5, 456 (1967)), triazole removal (see R. Kreher and J. Seubert, Z. Naturforach., 20B, 75 (1965)), etc.

Of the above, it is especially desirable that the hydrocarbon ring to which the dissociating group bonds is a ring containing an etheno group or an ethano group since the dissociating group in the case is more stable and since the compound of the type is easy to produce.

Before heat treatment, the dissociating group of the type can prevent intermolecular stacking owing to the highly-bulky molecular structure thereof, and the polymer of the type realizes good solubility in organic solvent.

In addition, the dissociating group dissociates from the polymer through heat treatment, and therefore the solubility in organic solvent in the compound after heated can be markedly lowered, and the organic layer containing the compound can be given organic solvent-resistant coatability.

Consequently, on the organic layer formed using the dissociating polymer in the present invention, an additional organic thin layer can be further laminated with ease according to a wet film formation method.

Specific examples of the group containing a dissociating group are mentioned below, to which, however, the present invention is not limited.

Specific examples of the case where the dissociating group-containing group is a divalent group are as shown in the following <Divalent Dissociating Group-Containing Group Family A>.

### <Divalent Dissociating Group-Containing Group Family A>

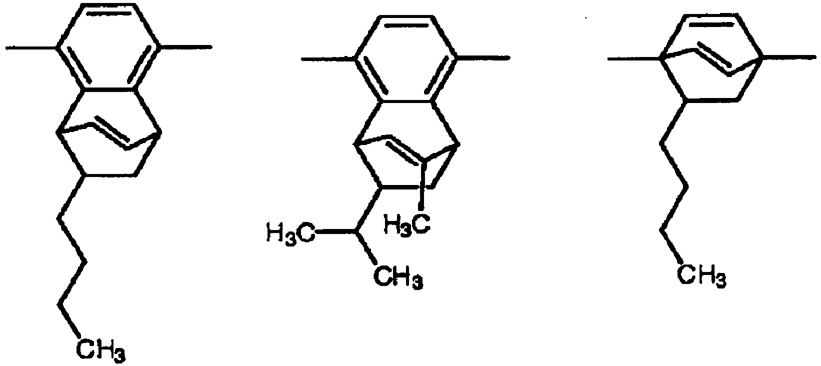

Specific examples of the case where the dissociating group is a monovalent group are as shown in the following <Monovalent Dissociating Group Family B>.

### <Monovalent Dissociating Group-Containing Group Family B>

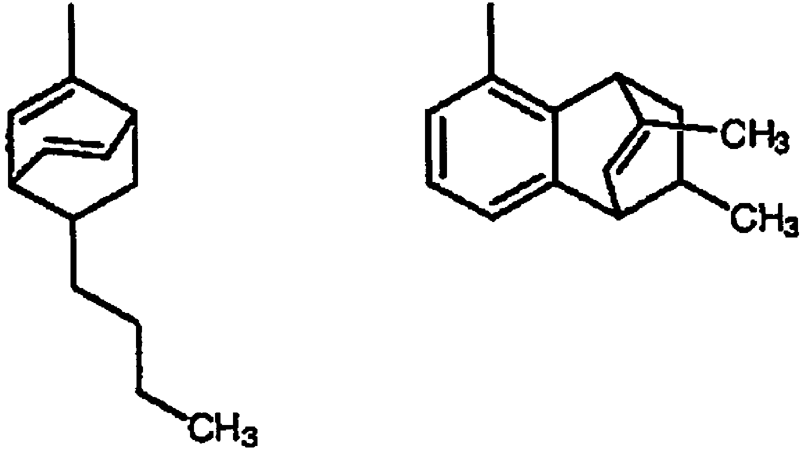

### <Alignment and Proportion of Repeating Unit>

The conjugated polymer having a dissociating group may be any one that has a dissociating group in the structure thereof, and the structure of the repeating unit therein is not specifically defined. Preferably, however, the repeating unit has an aromatic ring, and the dissociating group bonds to the hydrocarbon ring condensed with the aromatic ring.

In particular, especially preferred is a conjugated polymer having a dissociating group that contains repeating unit having a partial structure to which a dissociating group containing an etheno group or an ethano group bonds, from the viewpoint that the polymer of the type is excellent in film formability.

The etheno group or the ethano group is preferably contained in the hydrocarbon ring, and more preferably, the hydrocarbon ring is a 6-membered ring.

The conjugated polymer having a dissociating group in the present invention preferably contains a repeating unit having a partial structure represented by the following chemical formula (U3) or (U4), as the repeating unit having a partial structure to which the dissociating group bonds therein. In this case, the content of the repeating unit (U3) or (U4) in the polymer chain is preferably 10 mol% or more, more preferably 30 mol% or more.

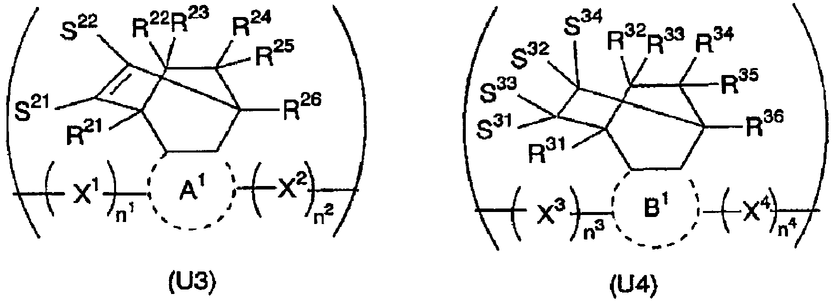

(In the formula (U3), the ring A¹ represents an aromatic ring optionally having a substituent, and the substituents may form a ring directly or via a divalent linking group.

S²¹, S²² and R²¹ to R²⁶ each independently represent a hydrogen atom, a hydroxyl group, an alkyl group optionally having a substituent, an aromatic hydrocarbon-cyclic group optionally having a substituent, an aromatic heterocyclic group optionally having a substituent, an aralkyl group optionally having a substituent, an alkoxy group optionally having a substituent, an aryloxy group optionally having a substituent, an acyl group optionally having a substituent, an alkenyl group optionally having a substituent, an alkynyl group optionally having a substituent, an acyloxy group optionally having a substituent, an arylamino group optionally having a substituent, a heteroarylamino group optionally having a substituent,, or an acylamino group optionally having a substituent.

X¹ and X² each independently represent a divalent aromatic hydrocarbon-cyclic group optionally having a substituent and having from 6 to 50 carbon atoms, or a divalent aromatic heterocyclic group optionally having a substituent and having from 5 to 50 carbon atoms.

n¹ and n² each independently indicate an integer of from 0 to 5.)

(In the formula (U4), the ring B¹ represents an aromatic ring optionally having a substituent, and the substituents may form a ring directly or via a divalent linking group.

S³¹ to S³⁴ and R³¹ to R³⁶ each are independently the same as S²¹ in the formula (U3).

X³ and X⁴ each are independently the same as X¹ in the formula (U3).

n³ and n⁴ each independently indicate an integer of from 0 to 5.)

The ring A¹ and the ring B¹ in the chemical formulae (U3) and (U4) each represent an aromatic ring to which a dissociating group bonds, and may be an aromatic hydrocarbon ring or an aromatic hetero ring, but is preferably an aromatic hydrocarbon ring as excellent in electrochemical stability and as capable of obstructing charge localization.

When the rings A¹ and B¹ each are an aromatic hydrocarbon ring, the nuclear carbon number of the aromatic hydrocarbon ring is generally 6 or more, and is generally 40 or less, preferably 30 or less, more preferably 20 or less.

When the rings A¹ and B¹ each are an aromatic hetero ring, the nuclear carbon number of the aromatic hetero ring is generally 3 or more, preferably 4 or more, more preferably 5 or more, and is generally 50 or less, preferably 30 or less, more preferably 20 or less.

The aromatic hydrocarbon ring includes, for example, a benzene ring, a naphthalene ring, an anthracene ring, a phenanthrene ring, a perylene ring, a tetracene ring, a pyrene ring, a benzopyrene ring, a chrysene ring, a benzochrysene ring, a triphenylene ring, a fluoranthene ring, a fluorene ring, etc.

Of the above, preferably, the rings A¹ and B¹ each are independently selected from a group consisting of a benzene ring, a naphthalene ring, an anthracene ring and a tetracene ring.

The aromatic hetero ring includes a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a quinoline ring, an isoquinoline ring, a quinoxaline ring, a perimidine ring, a quinazoline ring, a quinazolinone ring, etc.

The rings A¹ and B¹ in the chemical formulae (U3) and (U4) may also be a structure formed by linking from 1 to 10, the same one type or different two or more types of cyclic structure units, directly or via one or more divalent linking groups selected from an oxygen atom, a nitrogen atom, a sulfur atom, a linear group optionally containing a hetero atom and having a nuclear carbon number of from 1 to 20, and an aliphatic group having from 1 to 20 carbon atoms.

The cyclic structure units to be linked may be the same as the above-mentioned aromatic hydrocarbon rings or aromatic hetero rings, or may be different aromatic hydrocarbon rings or aromatic hetero rings. These aromatic hydrocarbon rings and aromatic hetero rings may have a substituent.

The substituent of the ring A¹ or the ring B¹ includes a linear or branched alkyl group having from 1 to 10 carbon atoms, such as a methyl group, an ethyl group, an n-propyl group, a 2-propyl group, an n-butyl group, an isobutyl group, a tert-butyl group, etc.; an alkenyl group having from 1 to 8 carbon atoms such as a vinyl group, an allyl group, a 1-butenyl group, etc.; an alkynyl group having from 1 to 8 carbon atoms such as an ethynyl group, a propargyl group, etc.; an aralkyl group having from 2 to 8 carbon atoms such as a benzyl group, etc.; an arylamino group such as a phenylamino group, a diphenylamino group, a ditolylamino group, etc.; a heteroarylamino group such as a pyridylamino group, a thienylamino group, a dithienylamino group, etc.; an acylamino group such as an acetylamino group, a benzoylamino group, etc.; an alkoxy group having from 1 to 8 carbon atoms such as a methoxy group, an ethoxy group, a butoxy group, etc.; an acyloxyl group having from 1 to 15 carbon atoms such as an acryloyloxyl group, a methylcarbonyloxyl group, an ethylcarbonyloxyl group, a hydroxycarbonylmethylcarbonyloxyl group, a hydroxycarbonylethylcarbonyloxyl group, a hydroxyphenylcarbonyloxyl group, etc.; an aryloxyl group having from 10 to 20 carbon atoms such as a phenyloxy group, a 1-naphthyloxy group, a 2-naphthyloxy group, etc.

These substituents may bond to form a cyclic structure, directly or via a divalent linking group such as -O-, -S-, >CO, >SO₂, -(C_{α}H_{2α})-, -O-(CβH_{2β})-, a substituted or unsubstituted alkylidene group having from 2 to 20 carbon atoms, an alkylene group optionally having a substituent and having from 2 to 20 carbon atoms, etc. α and β each indicate an integer of from 1 to 20.

The ring A¹ or the ring B¹ may be substituted with one alone or two or more different types of those substituents either singly or as combined in any desired manner.

In the chemical formula (U3) and the chemical formula (U4), preferably, S²¹, S²², R²¹ to R²⁶, S³¹ to S³⁴ and R³¹ to R³⁶ each are independently a hydrogen atom; a hydroxyl group; a linear or branched alkyl group having generally 1 or more and generally 50 or less, preferably 10 or less carbon atoms and optionally having a substituent, such as a methyl group, an ethyl group, an n-propyl group, a 2-propyl group, an n-butyl group, an isobutyl group, a tert-butyl group, etc.; an aromatic hydrocarbon-cyclic group optionally having a substituent and having a nuclear carbon number of generally 5 or more and 50 or less; an aromatic heterocyclic group optionally having a substituent and having a nuclear carbon number of from 5 to 40; an aralkyl group optionally having a substituent and having a nuclear carbon number of generally 6 or more, preferably 7 or more and generally 50 or less, preferably 8 or less, such as a benzyl group, etc.; an alkoxy group optionally having a substituent and having a carbon number of generally 1 or more and generally 50 or less, preferably 8 or less, such as a methoxy group, an ethoxy group, a butoxy group, etc.; an aryloxy group optionally having a substituent and having a nuclear carbon number of generally 5 or more, preferably 6 or more and generally 50 or less, preferably 15 or less, such as a phenyloxy group, a 1-naphthyloxy group, a 2-naphthyloxy group, etc.; an acyl group optionally having a substituent and having a nuclear carbon number of generally from 2 to 50; an alkenyl group optionally having a substituent and having a carbon number of generally from 1 to 8, such as a vinyl group, an allyl group, a 1-butenyl group, etc.; an alkynyl group optionally having a substituent and having a carbon number of generally from 1 to 8, such as an ethynyl group, a propargyl group, etc.; an acyloxy group optionally having a substituent and having a nuclear carbon number of generally 2 or more and generally 50 or less, preferably 15 or less, such as an acryloyloxyl group, a methylcarbonyloxyl group, an ethylcarbonyloxyl group, a hydroxycarobnylmethylcarbonyloxyl group, a hydroxycarbonylethylcarbonyloxyl group, a hydroxyphenylcarbonyloxyl group, etc.; an arylamino group optionally having a substituent and having a nuclear carbon number of generally from 6 to 50, such as a phenylamino group, a diphenylamino group, a ditolylamino group, etc.; a heteroarylamino group optionally having a substituent and having a nuclear carbon number of generally from 5 to 50, such as a pyridylamino group, a thienylamino group, a dithienylamino group, etc.; or an acylamino group optionally having a substituent and having a carbon number of generally from 2 to 50, such as an acetylamino group, a benzoylamino group, etc.

### (Proportion of Thermally-Dissociating Soluble Group)

The dissociating group may be contained in any other part than the repeating unit in the dissociating polymer. The number of the dissociating groups to be contained in the dissociating polymer chain is preferably 5 or more on average, more preferably 10 or more on average, even more preferably 50 or more on average.

Falling within the range is preferred in that the solubility in organic solvent of the organic layer formed using the dissociating polymer can be fully lowered.

Preferred examples of the dissociating polymer for use in the present invention are shown below, to which, however, the present invention is not limited.

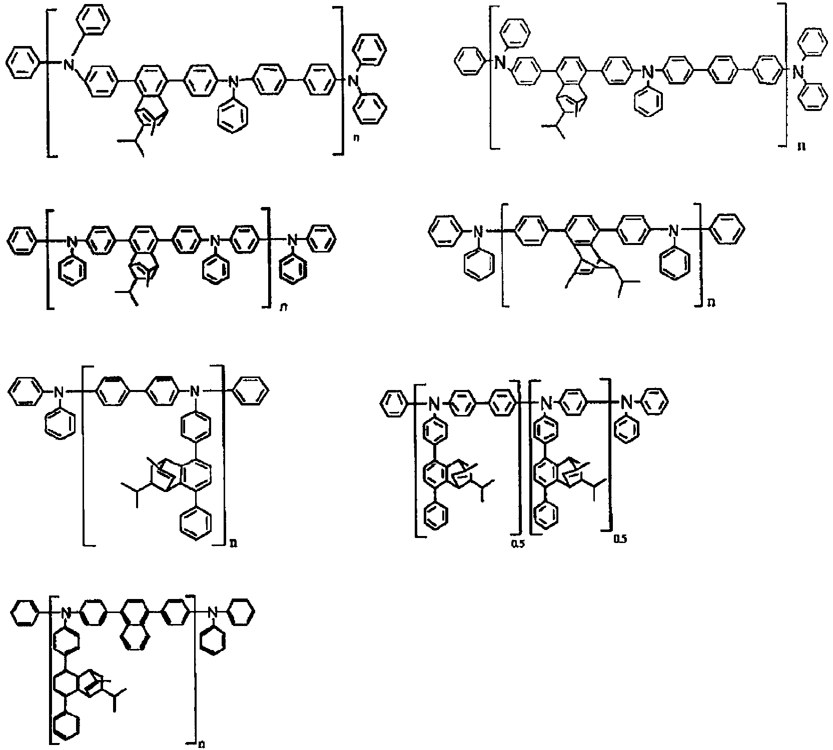

### (Crosslinking Group)

In case where the aromatic amine polymer in the present invention is a conjugated polymer, it is desirable that the polymer has a crosslinking group as the insolubilizing group therein from the viewpoint that, before and after the reaction to be caused by heat and/or irradiation with active energy rays (crosslinking reaction), there occurs a great difference in the solubility of the polymer in an organic solvent.

Here, the crosslinking group is a group to react with the same or different group in any other molecule existing near the group through heating and/or irradiation with active energy rays, thereby forming a new chemical bond.

As the crosslinking group, from the viewpoint of easy crosslinkability thereof, for example, there are mentioned the groups shown in the following crosslinking group family T

### <Crosslinking Group Family T>

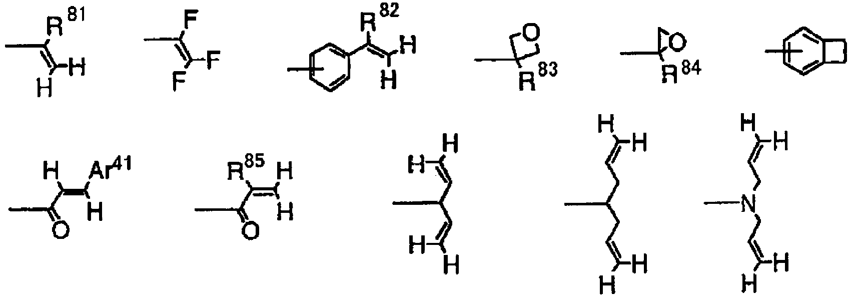

(In the formulae, R⁸¹ to R⁸⁵ each independently represent a hydrogen atom, or an alkyl group. Ar⁴¹ represents an aromatic hydrocarbon-cyclic group optionally having a substituent, or an aromatic heterocyclic group optionally having a substituent. The benzocyclobutene ring may have a substituent, and the substituents may bond to each other to form a ring.)

The crosslinking group is preferably a cyclic ether group such as an epoxy group, an oxetane group, or a group capable insolubilizing through cationic polymerization such as a vinyl ether group, from the viewpoint that the group has a high reactivity and can readily insolubilize. Above all, especially preferred is an oxetane group from the viewpoint that the cationic polymerization speed is easy to control; and also preferred is a vinyl ether group from the viewpoint that the group hardly forms a hydroxyl group that may worsen elements during cationic polymerization.

Also preferably, the crosslinking group is an arylvinylcarbonyl group such as a cinnamoyl group, or a group capable of undergoing cyclization addition reaction such as a benzocyclobutene ring having one free atomic valence, from the viewpoint of the ability thereof to further enhance the electrochemical stability of the polymer.

Of the crosslinking group of the type, especially preferred is a benzocyclobutene ring having one free atomic valence from the viewpoint that the structure after insolubilization is especially stable.

Concretely, preferred are groups represented by the following formula (5). 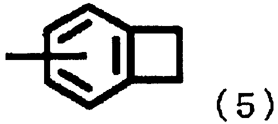 (The benzocyclobutene ring in the formula (5) may have a substituent. The substituents may bond to each other to form a ring.)

The crosslinking group may bond directly to the aromatic hydrocarbon-cyclic group or the aromatic heterocyclic group in the molecule, or may bond thereto via a divalent group. The divalent group may be one formed by linking from 1 to 30 groups selected from a group -O-, a group -C(=O)- and a group -CH₂- (optionally having a substituent) in any desired order, and preferably, the crosslinking group bonds to the aromatic hydrocarbon-cyclic group or the aromatic heterocyclic group via such a divalent group.

Specific examples of a crosslinking group bonding via such a divalent group, or that is, specific examples of the a group that contains a crosslinking group are as shown in the following <Crosslinking Group-Containing Group Family T'>, to which, however, the present invention is not limited.

### <Crosslinking Group-Containing Group Family T'>

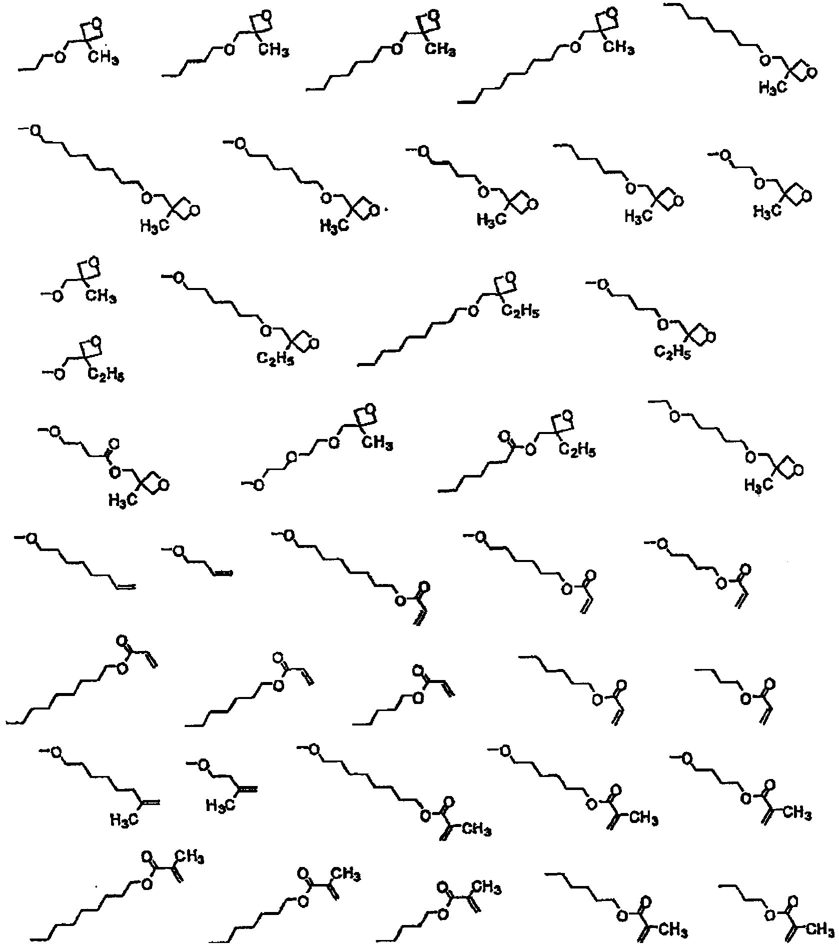

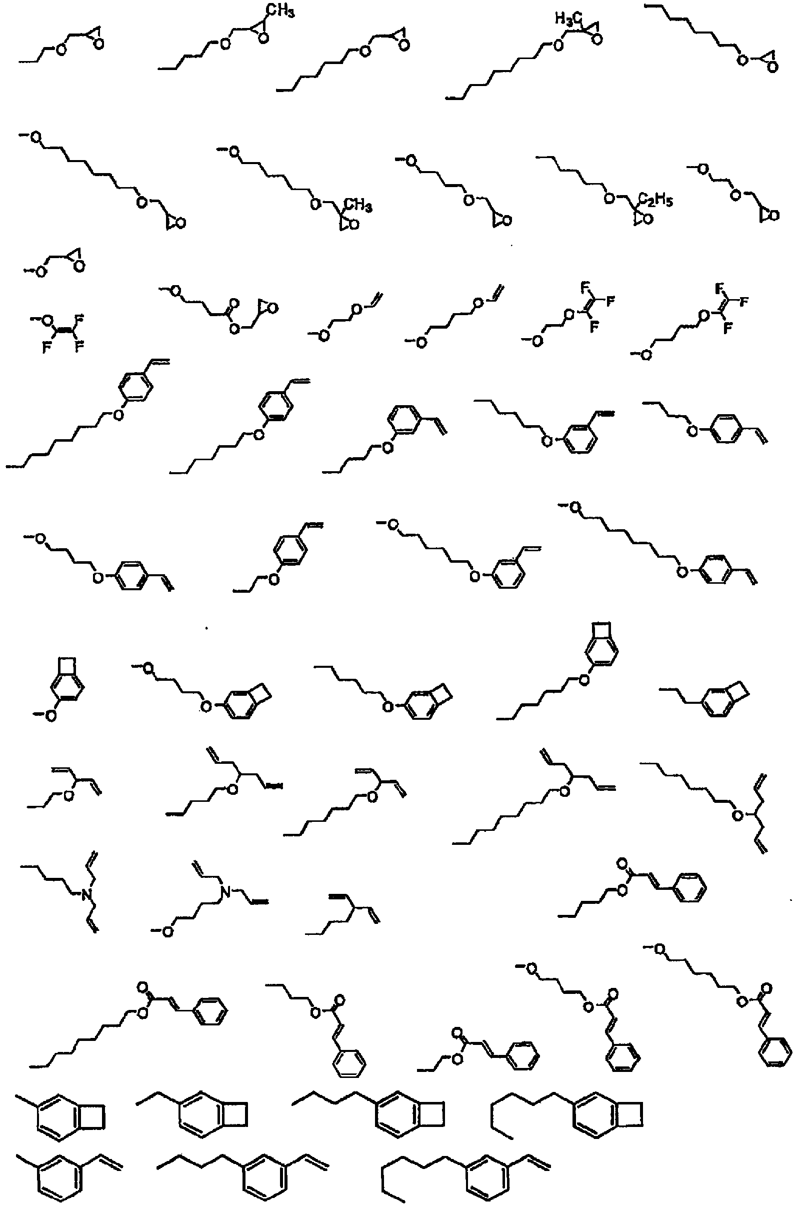

### (Proportion of Crosslinking Group)

The number of the crosslinking groups that the crosslinking polymer in the present invention has may be expressed as the number thereof per a molecular weight of 1,000.

When the number of the crosslinking groups that the crosslinking group has is expressed as the number thereof per a molecular weight of 1,000, the number is generally 3.0 or less per a molecular weight of 1,000, preferably 2.0 or less, more preferably 1.0 or less, and is generally 0.01 or more, preferably 0.05 or more.

Falling within the range is preferred, since a more flat film may be formed, and since the number of the unreacted crosslinking groups still remaining after film formation would hardly have some influence on the driving life of elements.

Here, the number of the crosslinking groups per a molecular weight of 1,000 of the crosslinking polymer is calculated from the molar ratio of the starting monomers and the structural formula of the crosslinking polymer, wherein the terminal group is excluded from the polymer.

For example, this is described in the case of the following compound.

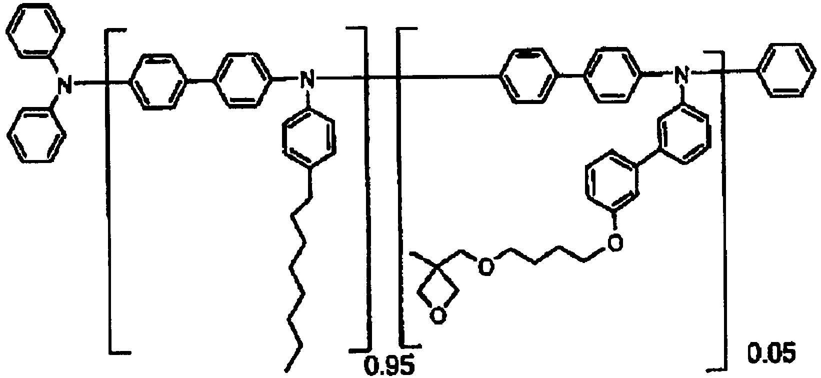

In the above compound, the molecular weight of the repeating unit excluding the terminal group is 362.33 on average, and the number of the crosslinking groups per one repeating unit is 0.05 on average. These are calculated in simple proportion, and the number of the crosslinking groups per a molecular weight of 1,000 is thus calculated as 0.138.

Preferred examples of the crosslinking polymer in the present invention are shown below, to which, however, the present invention is not limited.

### [Examples]

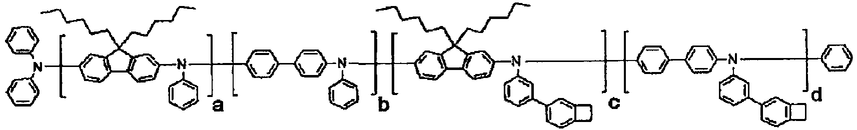

(In the above formula, for example, there is mentioned a case where a = 0.475, b = 0.475, c = 0.025, d = 0.025.) 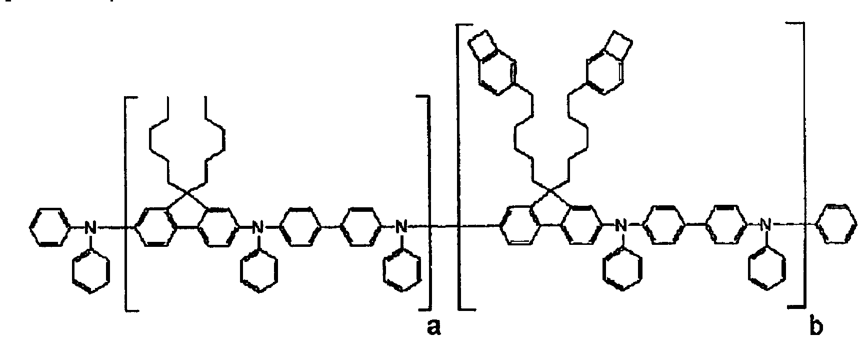 (In the above formula, for example, there is mentioned a case where a = 0.9, b = 0.1.) 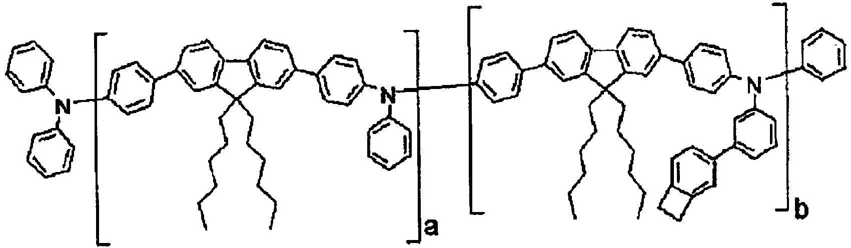 (In the above formula, for example, there is mentioned a case where a = 0.94, b = 0.06.) 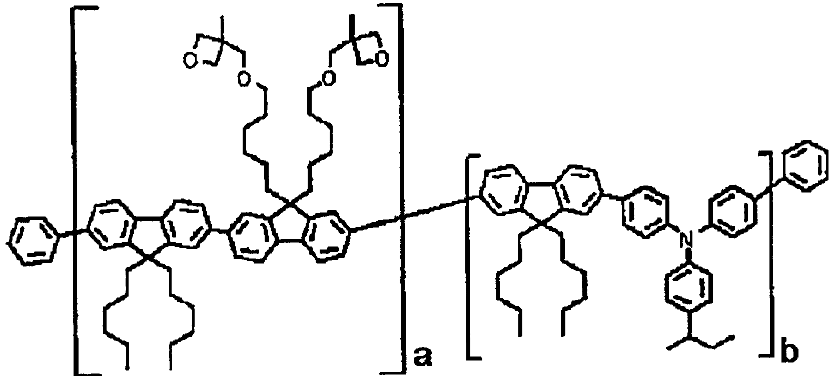 (In the above formula, for example, there is mentioned a case where a = 0.1, b = 0.9.) 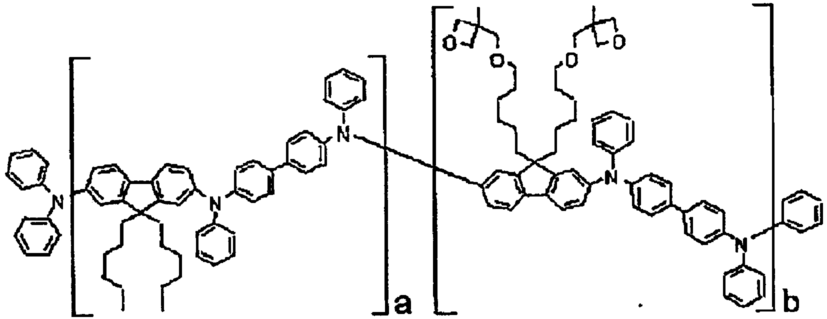 (In the above formula, for example, there is mentioned a case where a = 0.9, b = 0.1.) 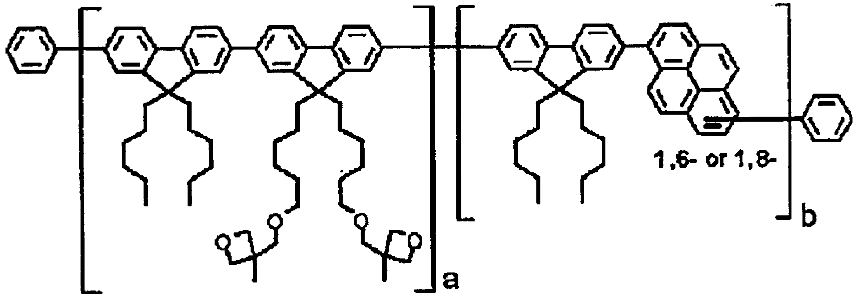 (In the above formula, for example, there is mentioned a case where a = 0.1, b = 0.9.) 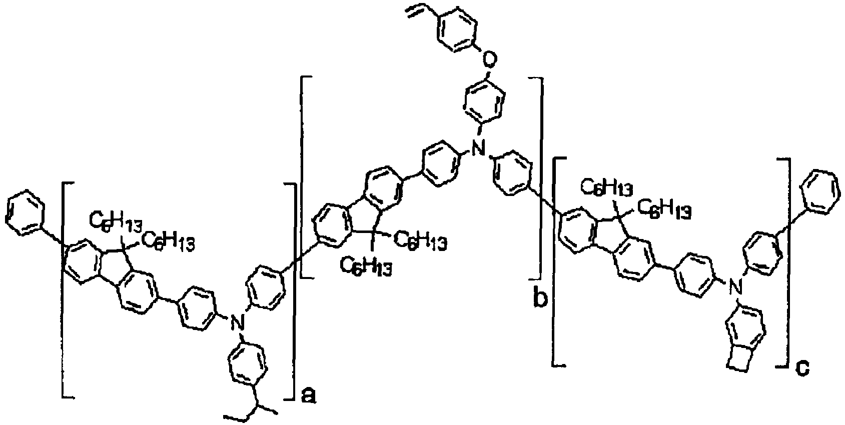 (In the above formula, for example, there is mentioned a case where a = 0.8, b = 0.1, c = 0.1.) 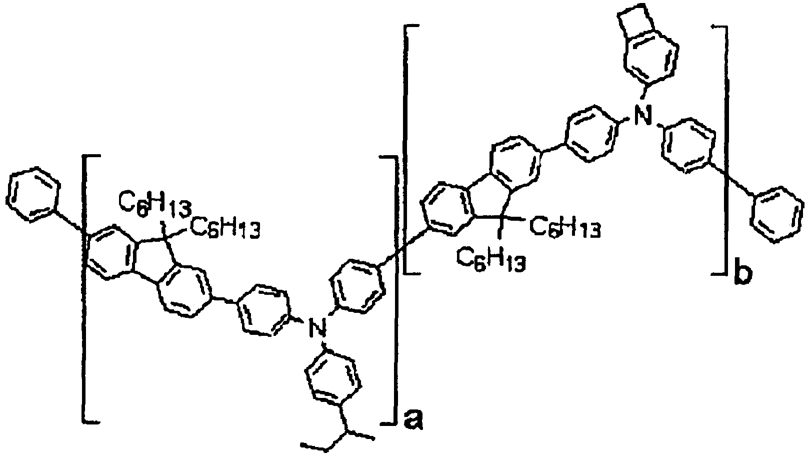 (In the above formula, for example, there is mentioned a case where a = 0.8, b = 0.2.) 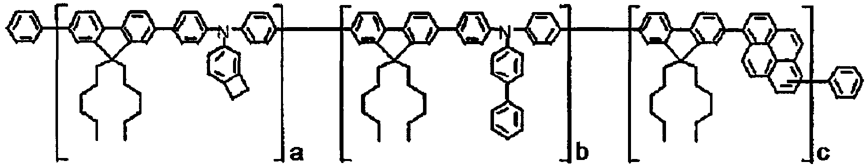 (In the above formula, for example, there is mentioned a case where a = 0.2, b = 0.5, c = 0.3.) 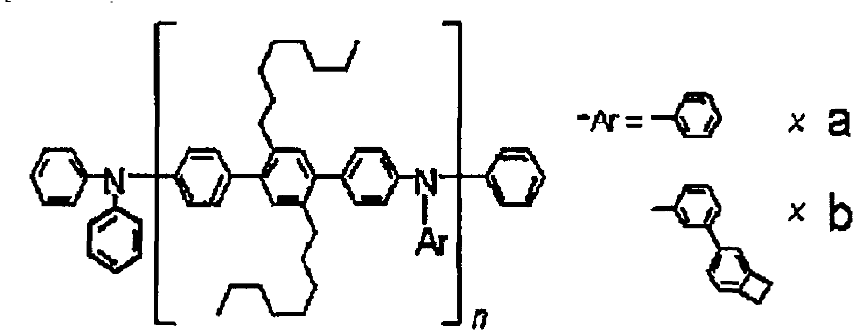 (In the above formula, for example, there is mentioned a case where a = 0.9442, b = 0.0558.) 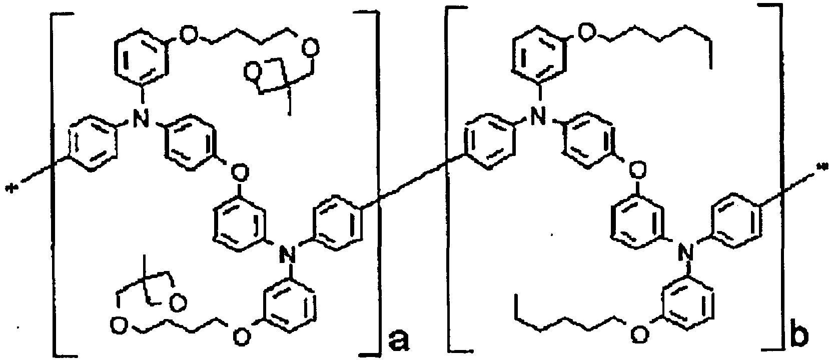 (In the above formula, for example, there is mentioned a case where a = 0.1, b = 0.9.) 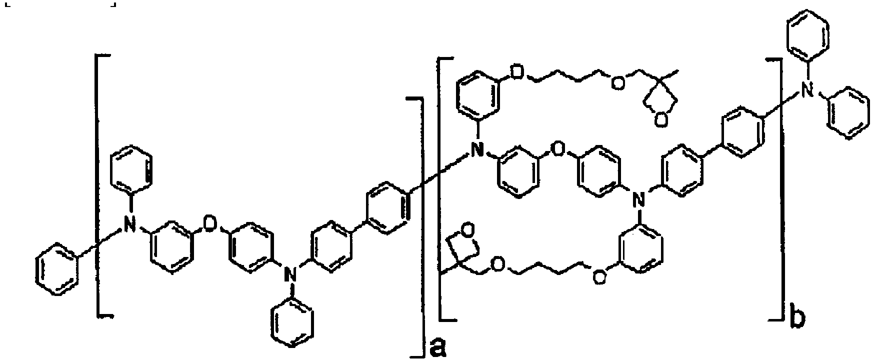 (In the above formula, for example, there is mentioned a case where a = 0.9, b = 0.1.) 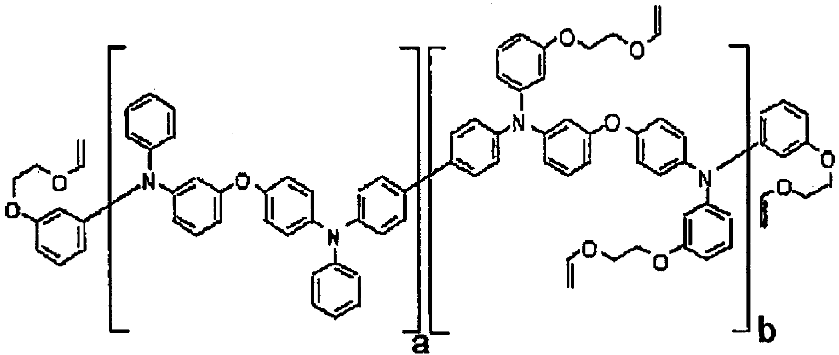 (In the above formula, for example, there is mentioned a case where a = 0.94, b = 0.06.) 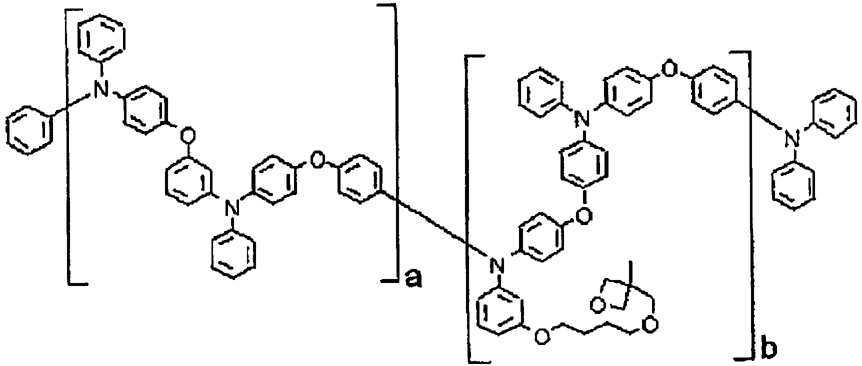 (In the above formula, for example, there is mentioned a case where a = 0.9, b = 0.1.) 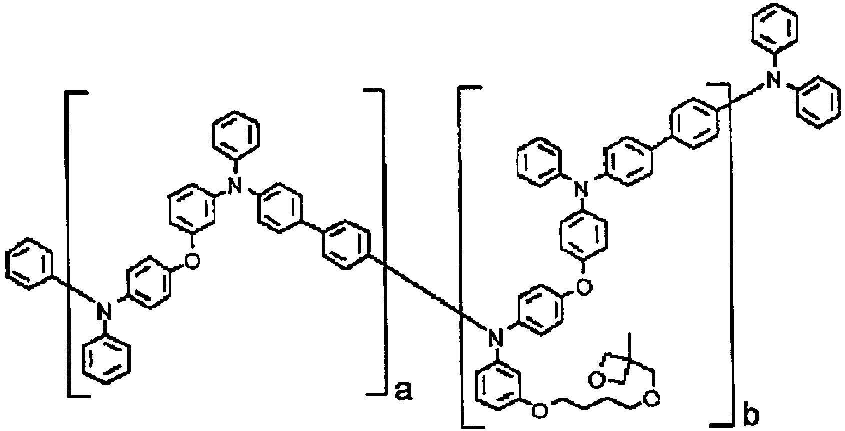 (In the above formula, for example, there is mentioned a case where a = 0.9, b = 0.1.)

### (Conjugated Polymer Having Especially Preferred Crosslinking Group)

The crosslinking polymer in the present invention is preferably a conjugated polymer having at least one repeating unit selected from the following repeating unit family C and at least one repeating unit selected from the following repeating unit family D, from the viewpoint that the polymer of the type has high charge transportability and excellent oxidation reduction stability.

### <Repeating Unit Family C>

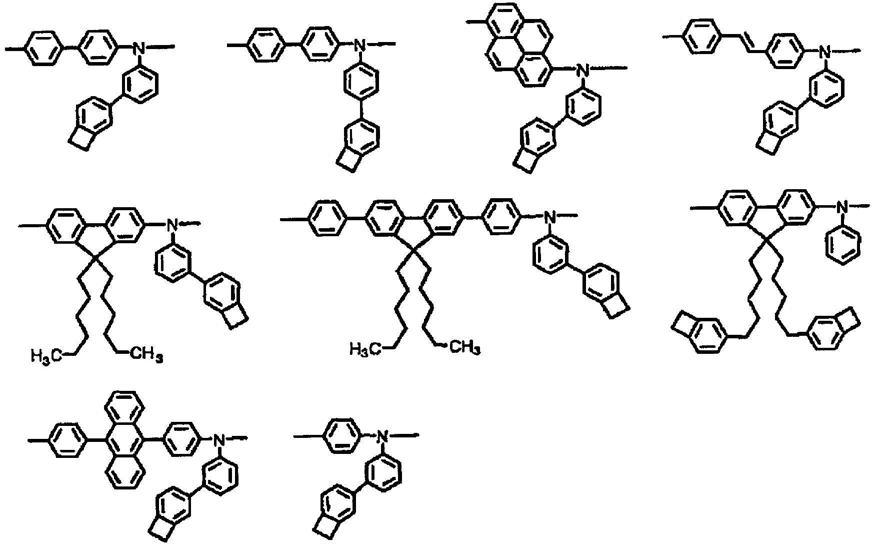

### <Repeating Unit Family D>

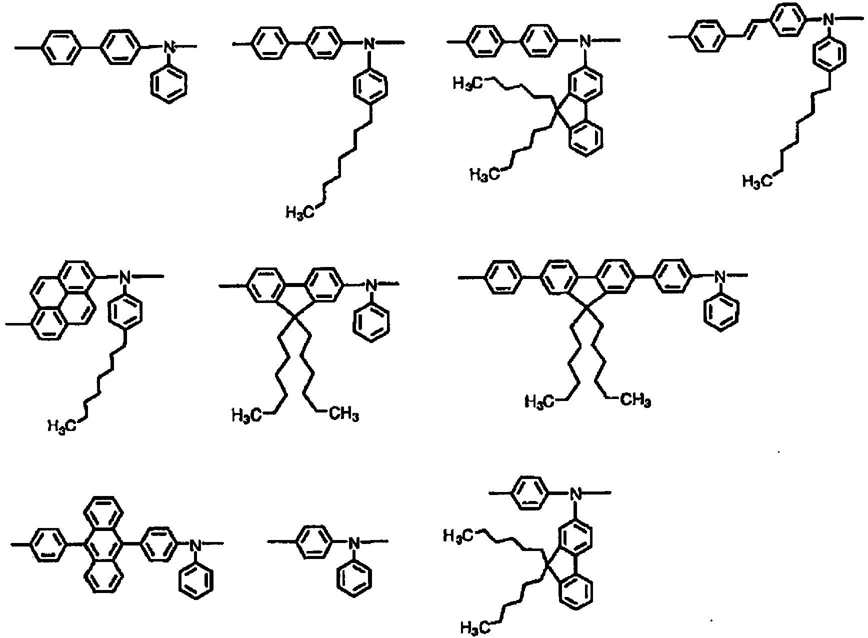

### (Glass Transition Temperature, Other Physical Properties)

The glass transition temperature of the crosslinking polymer in the present invention is generally 50°C or higher, and is preferably 80°C or higher from the viewpoint of the driving stability including the heat resistance of organic electroluminescent elements, more preferably 100°C or higher, and is generally 300°C or lower.

The ionization potential of the conjugated polymer is generally 4.5 eV or more, preferably 4.8 eV or more, and is generally 6.0 eV or less, preferably 5.7 eV or less, from the viewpoint that the polymer has excellent charge transportability.

### (Advantage of Crosslinking Group-Having Conjugated Polymer)

In a case of a composition for charge transport film in a solution state, the molecular movement of the crosslinking group is larger than that in a solid state since the composition is a solution. In this, in the aggregation state of the crosslinking polymer, when the crosslinking groups are kept existing extremely close to each other, then it may be presumed that the probability that the polymer would be crosslinked in the aggregation state even at a temperature lower than the heating temperature for insolubilization to be mentioned below, owing to the suitable molecular movement thereof, would be high.

In a case of a uniform solution not in an aggregation state, the molecular movement of the crosslinking polymer molecules themselves is large, and therefore the crosslinking groups are not kept existing extremely close to each other, and consequently in the case, there is little possibility that the polymer would be crosslinked in the solution state at a temperature lower than the heating temperature for insolubilization to be mentioned below.

### (Regarding Nonconjugated Polymer)

The aromatic amine polymer in the present invention may also be a nonconjugated polymer as another preferred case. The reason is because, when the amine site forms a cation radical with an electron-accepting compound, the cation radical would hardly move in the absence of voltage application since the main chain is not conjugated. In other words, the cation radicals are uniformly distributed in the polymer chain, and the cation radicals could move in the polymer chain so that there would hardly occur aggregation owing to polymer localization, and the case is therefore preferred.

The nonconjugated polymer preferably has a repeating unit represented by the above-mentioned formula (2) and/or a repeating unit represented by the formula (3). Also preferably, the nonconjugated polymer is a polymer containing a repeating unit represented by the following formula (1) owing to the reason that the hole injection/transport capability thereof is high. 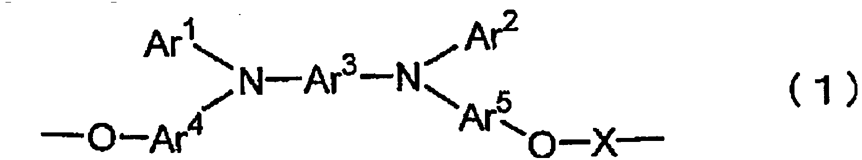 (In the formula (1), Ar¹ and Ar² each independently represent an aromatic hydrocarbon-cyclic group optionally having a substituent, or an aromatic heterocyclic group optionally having a substituent. Ar³ to Ar⁵ each independently represent a divalent aromatic hydrocarbon-cyclic group optionally having a substituent, or a divalent aromatic heterocyclic group optionally having a substituent. Of Ar¹ to Ar⁵, two groups bonding to the same N atom may bond to each other to form a ring. X represents a divalent linking group.)

As Ar¹ and Ar², preferred is a benzene ring, a naphthalene ring, a phenanthrene ring, a thiophene ring or a pyridine ring optionally having a substituent and having one free atomic valence, from the viewpoint of the solubility, the heat resistance and the hole injection/transport capability of the aromatic amine polymer, and also preferred is a phenyl group or a naphthyl group.

From the viewpoint of the heat resistance and the hole injection/transport capability including the oxidation reduction potential of the polymer, Ar³ to Ar⁵ are each independently preferably a benzene ring, a naphthalene ring, a triphenylene ring or a phenanthrene ring having two free atomic valences, and also preferred is a phenylene group, a biphenylene group or a naphthylene group.

The substituent that the aromatic hydrocarbon-cyclic group and the aromatic heterocyclic group may have in Ar¹ to Ar⁵ has the same meaning as that of the above-mentioned (substituent family Z). Preferred groups of those are also the same.

The molecular weight of the substituent is generally 400 or less, preferably 250 or less or so.

### (Linking Group X)

In the repeating unit represented by the formula (1), the linking group X is preferably a divalent linking group selected from the following linking group family X'.

### <Linking Group Family X'>

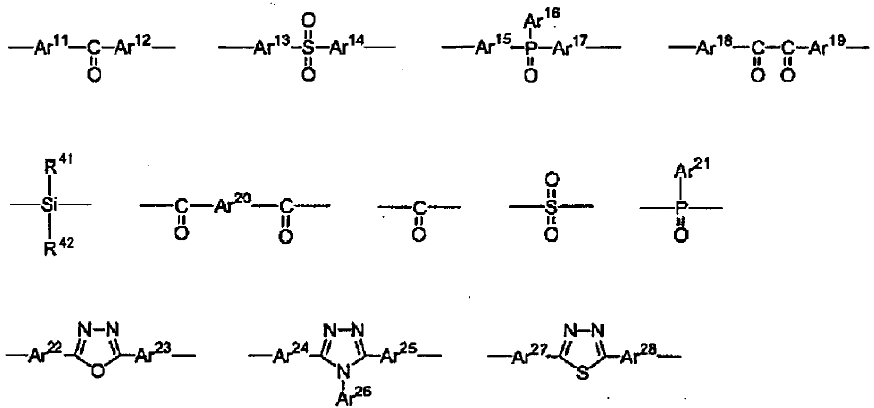

(In the formulae, Ar¹¹ to Ar²⁸ each independently represent an aromatic hydrocarbon-cyclic group optionally having a substituent, or an aromatic heterocyclic group optionally having a substituent. R⁴¹ and R⁴² each independently represent a hydrogen atom or an arbitrary substituent.)

Here, Ar¹⁶, Ar²¹ and Ar²⁶ include the same groups as those for Ar¹ in the formula (1). Ar¹¹ to Ar¹⁵, Ar¹⁷ to Ar²⁰, Ar²² to Ar²⁵, Ar²⁷ and Ar²⁸ each independently include the same groups as those for Ar³ in the formula (1).

R⁴¹ and R⁴² each independently represent a hydrogen atom or a substituent. Examples of the substituent include an alkyl group, an alkenyl group, an alkynyl group, an alkoxy group, a silyl group, a siloxy group, an aromatic hydrocarbon-cyclic group, an aromatic heterocyclic group, etc. As specific examples and preferred examples of these groups, there are mentioned those exemplified hereinabove in the (substituent family Z).

The substituent that the aromatic hydrocarbon-cyclic group and the aromatic heterocyclic group may have in Ar¹¹ to Ar²⁸ includes those exemplified in the section of the above-mentioned (substituent family Z).

In the aromatic amine polymer for use in the present invention, the formula (1) is preferably a repeating unit represented by the following formula (1-1) because of the reason that the polymer of the type has extremely high hole injection/transport capability. More preferably, the repeating unit is one represented by the following formula (1-2). 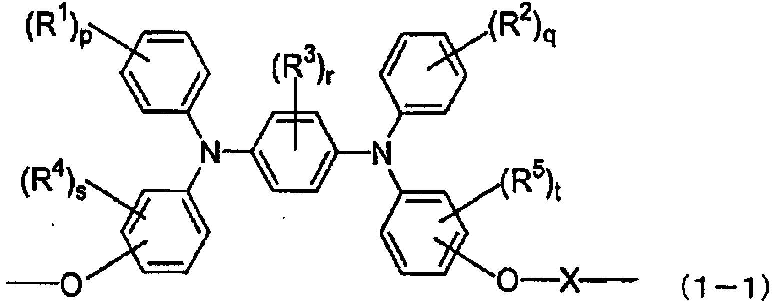 (In the formula, R¹ to R⁵ each independently represent an arbitrary substituent. p and q each independently indicate an integer of from 0 to 5. r, s and t each independently indicate an integer of from 0 to 4. X has the same meaning as that of X in the formula (1).)

In the formula (1-1), specific examples of R¹ to R⁵ correspond to examples of the substituent that the above-mentioned Ar¹ to Ar⁵ may have, or that is, to those exemplified in the above-mentioned (substituent family Z). 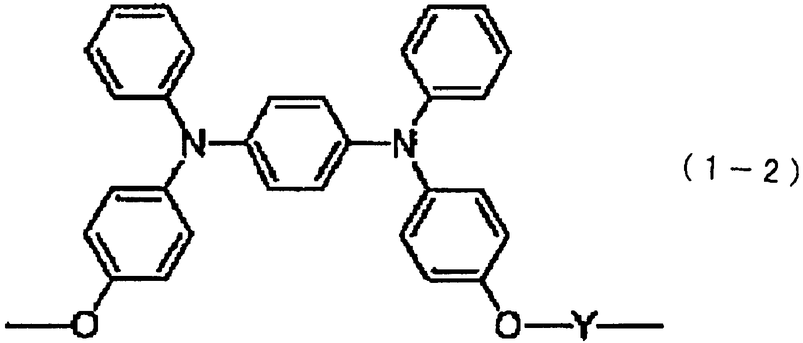 (In the formula, Y represents a linking group selected from the following linking group family X".)

### <Linking Group Family X">

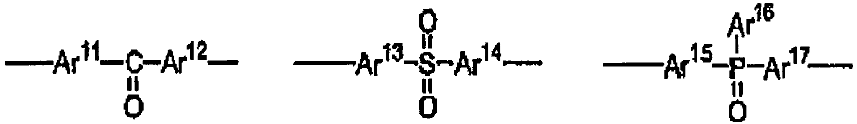

(In the formulae, Ar¹¹ to Ar¹⁷ each have the same meanings as those of Ar¹¹ to Ar¹⁷ in the above-mentioned <linking group family X'>. Preferred examples are also the same.)

### (Examples of Repeating Units of Aromatic Amine Polymer)

Preferred examples of the repeating units constituting the aromatic amine polymer in the present invention are shown below, to which, however, the present invention is not limited.

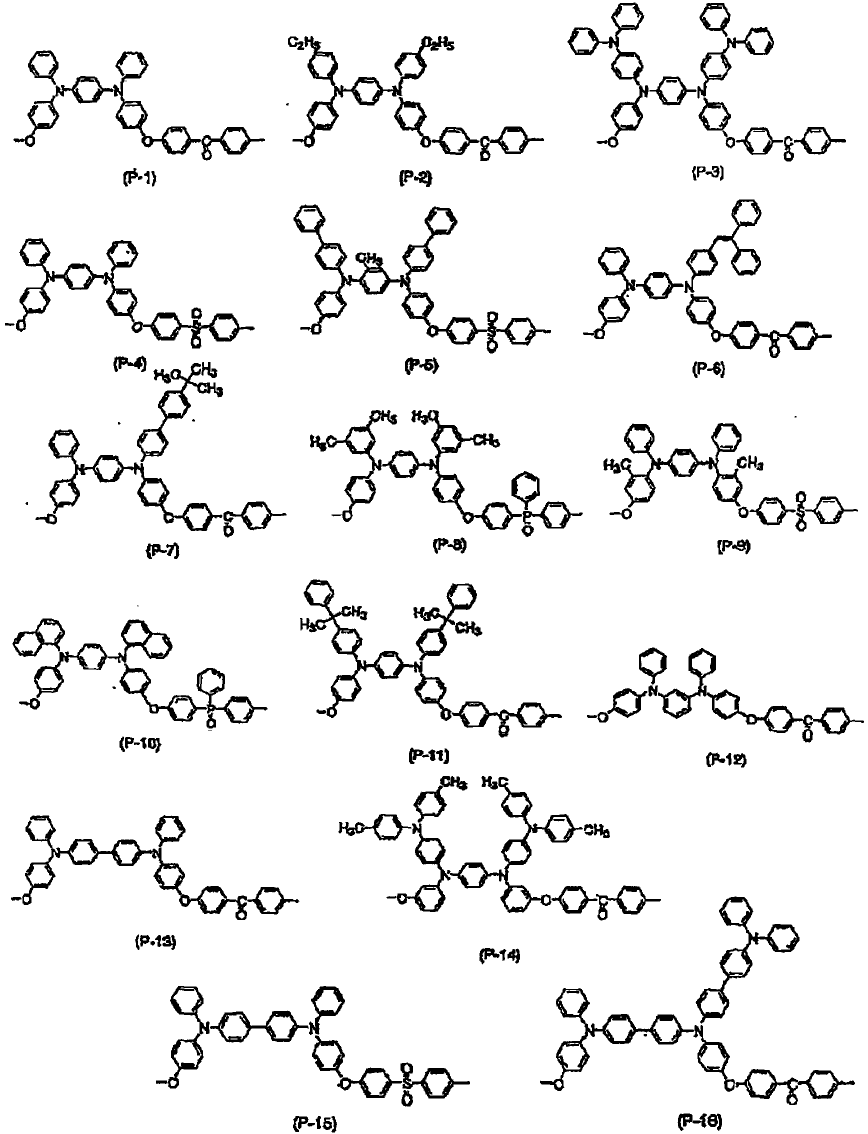

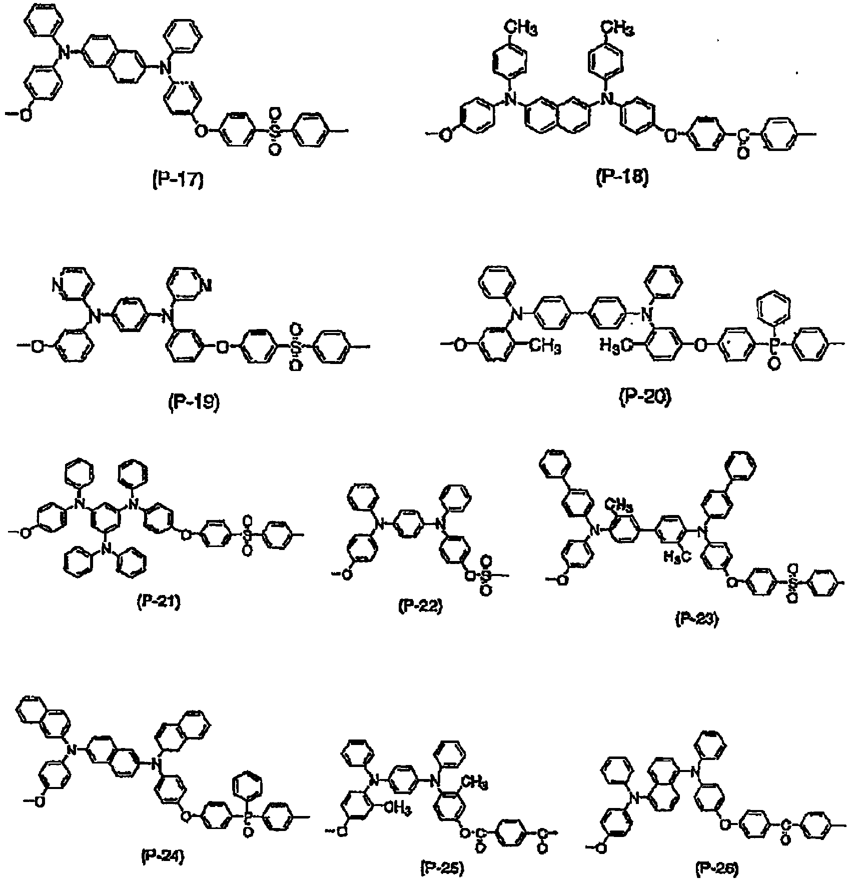

Of the above-mentioned examples, preferred are the repeating units represented by (P-1) to (P-11), (P-13) to (P-18), (P-20), (P-21), (P-23), (P-25) or (P-26), from the viewpoint of the heat resistance and the charge transportability of the polymer. More preferred are the repeating units represented by (P-1), (P-3), (P-4), (P-6), (P-9) or (P-10); and most preferred are the repeating units represented by (P-1) or (P-4).

The aromatic amine polymer in the present invention may be a polymer containing two or more different types of repeating units.

Ar¹ to Ar⁵ or the linking group X in the repeating unit represented by the formula (1) may differ to provide different repeating units.

### (Insolubilizing Group)

The polymer containing a repeating unit represented by the formula (1) may further has an insolubilizing group from the viewpoint that the polymer of the type is easy to laminate and realizes excellent surface smoothness in film formation. The insolubilizing group is the same as above.

The content of the aromatic amine polymer in the composition for organic electroluminescent elements of the present invention is generally 1% by weight or more, preferably 2% by weight or more, and is generally 6% by weight or less, preferably 5% by weight or less.

When the content of the aromatic amine polymer is too small, then the charge transportability would be insufficient. However, when too large, then the solubility of the aromatic amine polymer in organic solvent would lower. In case where two or more different types of aromatic amine polymers are used as combined, the total content of those polymers is controlled to fall within the above-mentioned range.

### <Electron-Accepting Compound>

The electron-accepting compound is preferably an oxidative compound having the ability of receiving one electron from the above-mentioned hole-transporting compound. Concretely, preferred is a compound having an electron affinity of 4 eV or more, and more preferred is a compound having 5 eV or more.

The electron-accepting compound of the type includes, for example, one or more compounds selected from a group consisting of triarylboron compounds, metal halides, Lewis acids, organic acids, onium salts, salts of arylamines and metal halides, and salts of arylamines and Lewis acids.

The electron-accepting compound to be contained in the composition for organic electroluminescent elements of the present invention is preferably an ionic compound having a structure where at least one organic group bonds to an element belonging to Groups 15 to 17 of the Long Periodic Table (hereinafter unless otherwise specifically indicated, "Periodic Table" means Long Periodic Table) via a carbon atom. More preferred is a compound represented by any of the following formulae (I-1) to (I-3):

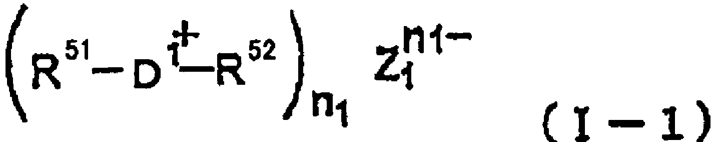

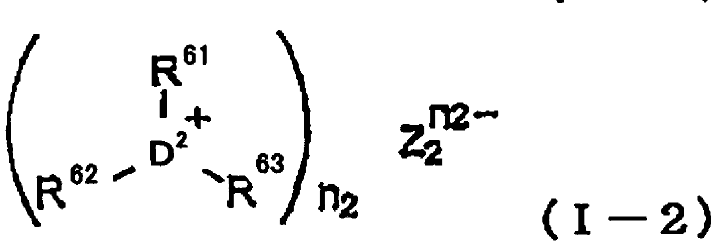

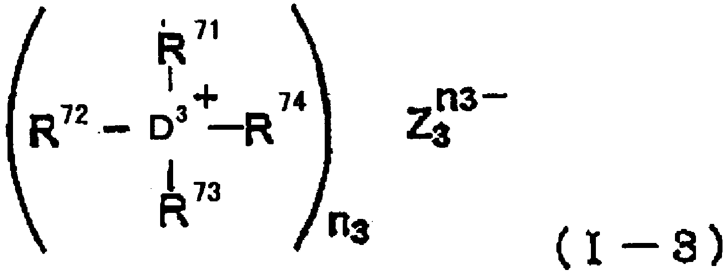

In the formulae (I-1) to (I-3), R⁵¹, R⁶¹ and R⁷¹ each independently represent an organic group bonding to D¹ to D³ via a carbon atom, R⁵², R⁶², R⁶³ and R⁷² to R⁷⁴ each independently represent a substituent. Of R⁵¹ to R⁷⁴, two or more neighboring groups may bond to each other to form a ring.

R⁵¹, R⁶¹ and R⁷¹ each may be any organic group having a carbon atom at the bonding part to D¹ to D³, and not detracting from the advantageous effects of the present invention, the group is not specifically defined in point of the type thereof. The organic group in the present invention is a group containing at least one carbon atom.

The molecular weight of R⁵¹, R⁶¹ and R⁷¹ generally falls within a range of 1,000 or less, preferably 500 or less, as a value including the substituent thereof.

Preferred examples of R⁵¹, R⁶¹ and R⁷¹ include an alkyl group, an alkenyl group, an alkynyl group, an aromatic hydrocarbon-cyclic group and an aromatic heterocyclic group, from the viewpoint of delocalization of positive charges. Above all, preferred are an aromatic hydrocarbon-cyclic group and an aromatic heterocyclic group, as capable of delocalizing positive charges and thermally stable.

The aromatic hydrocarbon-cyclic group includes a 5- or 6-membered, single ring or 2- to 5-condensed ring having one free atomic valence and capable of delocalizing positive charges on the group.

Specific examples of the group include a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a and fluorene ring having one free atomic valence.

The aromatic heterocyclic ring includes a 5- or 6-membered, single ring or 2- to 4-condensed ring having one free atomic valence and capable of delocalizing positive charges on the group.

Specific examples of the group include a furan ring, a benzofuran ring, a thiophene ring, a benzothiophene ring, a pyrrole ring, a pyrazole ring, a triazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzimidazole ring, a perimidine ring, a quinazoline ring, a quinazolinone ring, an azulene ring having one free atomic valence.

The alkyl group includes a linear, branched or cyclic alkyl group having generally one or more carbon atoms and generally 12 or less carbon atoms, preferably 6 or less carbon atoms.

Specific examples of the group include a methyl group, an ethyl group, an n-propyl group, a 2-propyl group, an n-butyl group, an isobutyl group, a tert-butyl group, a cyclohexyl group, etc.

The alkenyl group includes one having a carbon number of generally 2 or more and generally 12 or less, preferably 6 or less. Specific examples of the group include a vinyl group, an allyl group, a 1-butenyl group, etc.

The alkynyl group includes one having a carbon number of generally 2 or more and generally 12 or less, preferably 6 or less. Specific examples of the group include an ethynyl group, a propargyl group, etc.

The type of R⁵², R⁶², R⁶³ and R⁷² to R⁷⁴ is not specifically defined, not detracting from the advantageous effects of the present invention.

The molecular weight of R⁵², R⁶², R⁶³ and R⁷² to R⁷⁴ is generally within a range of 1,000 or less, preferably 500 or less, as a value including the substituent thereof.

Examples of R⁵², R⁶², R⁶³ and R⁷² to R⁷⁴ include a hydrogen atom, an alkyl group, an alkenyl group, an alkynyl group, an aromatic hydrocarbon-cyclic group, an aromatic heterocyclic group, an amino group, an alkoxy group, an aryloxy group, an acyl group, an alkoxycarbonyl group, an aryloxycarbonyl group, an alkylcarbonyloxy group, an alkylthio group, an arylthio group, a sulfonyl group, an alkylsulfonyl group, an arylsulfonyl group, a sulfonyloxy group, a cyano group, a hydroxyl group, a thiol group, a silyl group, etc.

Of those, preferred is an organic group having a carbon atom at the bonding part to D¹ to D³, from the viewpoint of large electron acceptability thereof, like R⁵¹, R⁶¹ and R⁷¹. Preferred examples of the group of the type include an alkyl group, an alkenyl group, an alkynyl group, an aromatic hydrocarbon-cyclic group and an aromatic heterocyclic group. Especially preferred are an aromatic hydrocarbon-cyclic group and an aromatic heterocyclic group, as having large electron acceptability and thermally stable.

The alkyl group, the alkenyl group, the alkynyl group, the aromatic hydrocarbon-cyclic group and the aromatic heterocyclic group are the same as those mentioned hereinabove for R⁵¹, R⁶¹ and R⁷¹. The amino group includes an alkylamino group, an arylamino group, an acylamino group, etc.

The alkylamino group includes an alkylamino group having one or more alkyl groups each having a carbon number of generally 1 or more and generally 12 or less, preferably 6 or less. Specific examples of the group include a methylamino group, a dimethylamino group, a diethylamino group, a dibenzylamino group, etc.

The arylamino group includes an arylamino group having one or more of aromatic hydrocarbon-cyclic groups and aromatic heterocyclic groups each having a carbon number of generally 3 or more, preferably 4 or more and generally 25 or less, preferably 15 or less. Specific examples of the group include a phenylamino group, a diphenylamino group, a tolylamino group, a pyridylamino group, a thienylamino group, etc.

The acylamino group includes an acylamino group having one or more acyl groups each having a carbon number of generally 2 or more and generally 25 or less, preferably 15 or less. Specific examples of the group include an acetylamino group, a benzoylamino group, etc.

The alkoxy group includes an alkoxy group having a carbon number of generally 1 or more and generally 12 or less, preferably 6 or less. Specific examples of the group include a methoxy group, an ethoxy group, a butoxy group, etc.

The aryloxy group includes an aryloxy group having an aromatic hydrocarbon-cyclic group or an aromatic heterocyclic group having a carbon number of generally 3 or more, preferably 4 or more and generally 25 or less, preferably 15 or less. Specific examples of the group include a phenyloxy group, a naphthyloxy group, a pyridyloxy group, a thienyloxy group, etc.

The acyl group includes an acyl group having a carbon number of generally 1 or more and generally 25 or less, preferably 15 or less. Specific examples of the group include a formyl group, an acetyl group, a benzoyl group, etc.

The alkoxycarbonyl group includes an alkoxycarbonyl group having a carbon number of generally 2 or more and generally 10 or less, preferably 7 or less. Specific examples of the group include a methoxycarbonyl group, an ethoxycarbonyl group, etc.

The aryloxycarbonyl group includes one having an aromatic hydrocarbon-cyclic group or an aromatic heterocyclic group having a carbon number of generally 3 or more, preferably 4 or more and generally 25 or less, preferably 15 or less. Specific examples of the group include a phenoxycarbonyl group, a pyridyloxycarbonyl group, etc.

The alkylcarbonyloxy group includes an alkylcarbonyloxy group having a carbon number of generally 2 or more and generally 10 or less, preferably 7 or less. Specific examples of the group include an acetoxy group, a trifluoroacetoxy group, etc.

The alkylthio group includes an alkylthio group having a carbon number of generally 1 or more and generally 12 or less, preferably 6 or less. Specific examples of the group include a methylthio group, an ethylthio group, etc.

The arylthio group includes an arylthio group having a carbon number of generally 3 or more, preferably 4 or more and generally 25 or less, preferably 14 or less. Specific examples of the group include a phenylthio group, a naphthylthio group, a pyridylthio group, etc.

Specific examples of the alkylsulfonyl group and the arylsulfonyl group include a mesyl group, a tosyl group, etc.

Specific examples of the sulfonyloxy group include a mesyloxy group, a tosyloxy group, etc.

Specific examples of the silyl group include a trimethylsilyl group, a triphenylsilyl group, etc.

The groups exemplified hereinabove for R⁵¹, R⁶¹, R⁷¹ as well as R⁵², R⁶², R⁶³ and R⁷² to R⁷⁴ may be further substituted with any other substituent, not contradictory to the effects of the present invention.

The type of the substituent is not specifically defined. Examples of the substituent include, in addition to the groups exemplified hereinabove for R⁵¹, R⁶¹, R⁷¹ as well as R⁵², R⁶², R⁶³ and R⁷² to R⁷⁴, a halogen atom, a cyano group, a thiocyano group, a nitro group, etc. Above all, preferred are an alkyl group, an alkenyl group, an alkynyl group, an alkoxy group, an aryloxy group, an aromatic hydrocarbon-cyclic group and an aromatic heterocyclic group, from the viewpoint that these would not obstruct the heat resistance and the electron acceptability of ionic compounds (electron-accepting compounds).

In the formulae (I-1) to (I-3), D¹ and D² each represent an element of Period 3 and later of the Periodic Table (Period 3 to Period 6), and D³ represents an element of Period 2 and later of the Periodic Table (Period 2 to Period 6); and D¹ is an element belonging to Group 17 of the Long Periodic Table, D² is an element belonging to Group 16, and D³ is an element belong to Group 15.

Above all, from the viewpoint of electron acceptability and easy availability, it is desirable that D¹ to D³ are all elements before Period 5 of the Periodic Table.

Specifically, D¹ is preferably an iodine atom, a bromine atom or a chlorine atom, D² is preferably a tellurium atom, a selenium atom or a sulfur atom, and D³ is preferably an antimony atom, an arsenic atom, a phosphorus atom or a nitrogen atom.

In particular, from the viewpoint of electron acceptability and compound stability, preferred are electron-accepting compounds of the formula (I-1) where D¹ is a bromine atom or an iodine atom, electron-accepting compounds of the formula (I-2) where D² is a selenium atom or a sulfur atom, and electron-accepting compounds of the formula (I-3) where D³ is a nitrogen atom. Above all, most preferred are electron-accepting compounds of the formula (I-1) where D¹ is an iodine atom, and electron-accepting compounds of the formula (I-3) where D³ is a nitrogen atom.

In the formulae (I-1) to (I-3), Z₁ⁿ¹⁻ to Z₃ⁿ³⁻ each independently represent a counter anion.

The type of the counter anion is not specifically defined. The anion may be a monoatomic ion or a complex ion. However, when the size of the counter anion is larger, then negative charges may delocalize and with that, positive charges may also delocalize to increase the electron acceptability of the compound, and consequently, preferred here is a complex ion rather than a monoatomic ion.

n₁ to n₃ each independently indicate an arbitrary positive integer corresponding to the ionic valence of the counter anion Z₁ⁿ¹⁻ to Z₃ⁿ³⁻, respectively. The value of n₁ to n₃ is not specifically defined, but is preferably 1 or 2 most preferably 1.

Specific examples of Z₁ⁿ¹⁻ to Z₃ⁿ³⁻ include a hydroxide ion, a fluoride ion, a chloride ion, a bromide ion, an iodide ion, a cyanide ion, a nitrate ion, a nitrite ion, a sulfate ion, a sulfite ion, a perchlorate ion, a perbromate ion, a periodate ion, a chlorate ion, a chlorite ion, a hypochlorite ion, a phosphate ion, a phosphite ion, a hypophosphite ion, a borate ion, an isocyanate ion, a hydrosulfide ion, a tetrafluoroborate ion, a hexafluorophosphate ion, a hexachloroantimonate ion; a carboxylate ion such as acetate ion, a trifluoroacetate ion, an benzoate ion, etc.; a sulfonate ion such as a methanesulfonate ion, a trifluoromethanesulfonate ion, etc.; an alkoxy ion such as a methoxy ion, a t-butoxy ion, etc. Preferred are a tetrafluoroborate ion and a hexafluoroborate ion.

The counter anions Z₁ⁿ¹⁻ to Z₃ⁿ³⁻ are preferably complex ions represented by any of the following formulae (I-4) to (I-6) from the viewpoint of the compound stability and the solubility in organic solvent; and more preferred are complex ions represented by the formula (I-6) from the viewpoint that the size is large and therefore negative charges could delocalize and with that positive charges could also delocalize to thereby enhance the electron acceptability of the compound.

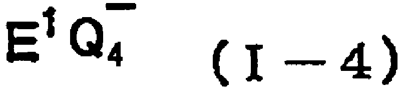

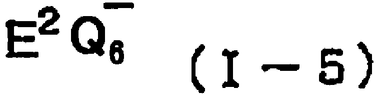

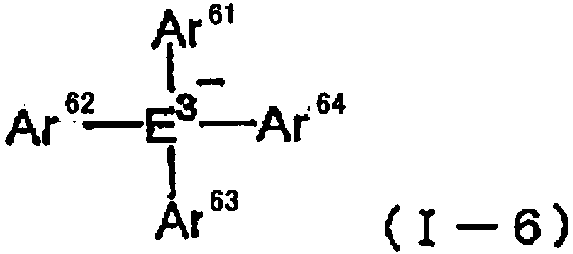

In the formulae (I-4) and (I-6), E¹ and E³ each independently represent an element belonging to Group 13 of the Long Periodic Table. Above all, preferred is a boron atom, an aluminium atom or a gallium atom. Especially preferred is a boron atom from the viewpoint of compound stability, and easiness in production and purification of compound.

In the formula (I-5), E² represents an element belong to Group 15 of the Long Periodic Table. Above all, preferred is a phosphorus atom, an arsenic atom or an antimony atom. More preferred is a phosphorus atom form the viewpoint of compound stability, easiness in production and purification of compound and low toxicity of compound.

In the formulae (I-4) and (I-5) Q₄ and Q₆ each independently represent a halogen atom such as a fluorine atom, a chlorine atom, a bromine atom, etc., and from the viewpoint of compound stability and easiness in production and purification of compound, preferred is a fluorine atom or a chlorine atom, and most preferred is a fluorine atom.

**In** the formula (I-6), Ar⁶¹ to Ar⁶⁴ each independently represent an aromatic hydrocarbon-cyclic group or an aromatic heterocyclic group. Examples of the aromatic hydrocarbon-cyclic group and the aromatic heterocyclic group are the same as those exemplified hereinabove for R⁵¹, including a 5- or 6-membered single ring or 2- to 4-condensed ring having one free atomic valence.

Above all, from the viewpoint of compound stability and heat resistance, preferred are a benzene ring, a naphthalene ring, a pyridine ring, a pyrazine ring, a pyridazine ring, a pyrimidine ring, a triazine ring, a quinoline ring and an isoquinoline ring having one free atomic valence.

The aromatic hydrocarbon-cyclic group and the aromatic heterocyclic group exemplified for Ar⁶¹ to Ar⁶⁴ may be further substituted with any other substituent, not contradictory to the effects of the present invention. The type of the substituent is not specifically defined, and any substituent is applicable, but preferred is an electron-attracting group.

Examples of the electron-attracting group preferred as the substituent that Ar⁶¹ to Ar⁶⁴ may have include a halogen atom such as a fluorine atom, a chlorine atom, a bromine atom, etc.; a cyano group; a thiocyano group; a nitro group; an alkylsulfonyl group such as a mesyl group, etc.; an arylsulfonyl group such as a tosyl group, etc.; an acyl group having a carbon number of generally 1 or more and generally 12 or less, preferably 6 or less, such as a formyl group, an acetyl group, a benzoyl group, etc.; an alkoxycarbonyl group having a carbon number of generally 2 or more and generally 10 or less, preferably 7 or less, such as a methoxycarbonyl group, an ethoxycarbonyl group, etc.; an aryloxycarbonyl group having an aromatic hydrocarbon-cyclic group or an aromatic heterocyclic group having a carbon number of generally 3 or more, preferably 4 or more and generally 25 or less, preferably 15 or less, such as a phenoxycarbonyl group, a pyridyloxycarbonyl group, etc.; an aminocarbonyl group; an aminosulfonyl group; a haloalkyl group of a linear, branched or cyclic alkyl group having a carbon number of generally 1 or more and generally 10 or less, preferably 6 or less and substituted with a halogen atom such as a fluorine atom, a chlorine atom, such as a trifluoromehtyl group, a pentafluoroethyl group, etc.

Above all, it is desirable that at least one group of Ar⁶¹ to Ar⁶⁴ has one or more substituents of fluorine atoms and/or chlorine atoms.

In particular, from the viewpoint of efficiently delocalizing negative charges and realizing suitable sublimability, most preferred is a perfluoroaryl group in which all hydrogen atoms of Ar⁶¹ to Ar⁶⁴ are substituted with fluorine atoms. Specific examples of the perfluoroaryl group include a pentafluorophenyl group, a heptafluoro-2-naphthyl group, a tetrafluoro-4-pyridyl group, etc.

The molecular weight of the electron-accepting compound in the present invention is generally 100 or more, preferably 300 or more, more preferably 400 or more and is generally 5,000 or less, preferably 3,000 or less, more preferably 2,000 or less.

When the molecular weight of the electron-accepting compound is too small, then delocalization of positive charges and negative charges would be insufficient and therefore the electron acceptability may lower; but when the molecular weight of the electron-accepting compound is too large, then the electron-accepting compound itself would obstruct charge transport.

Specific examples of the electron-accepting compound in the present invention are shown below, to which, however, the present invention is not limited.

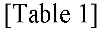

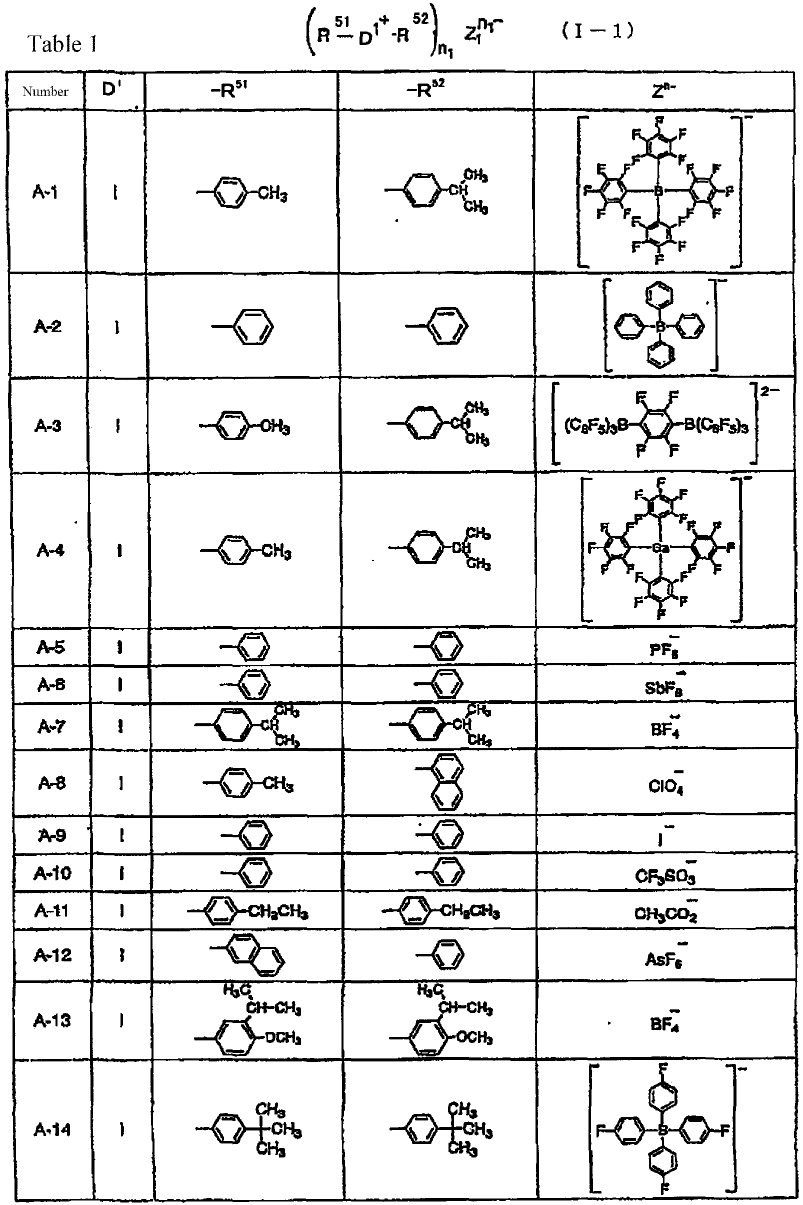

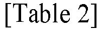

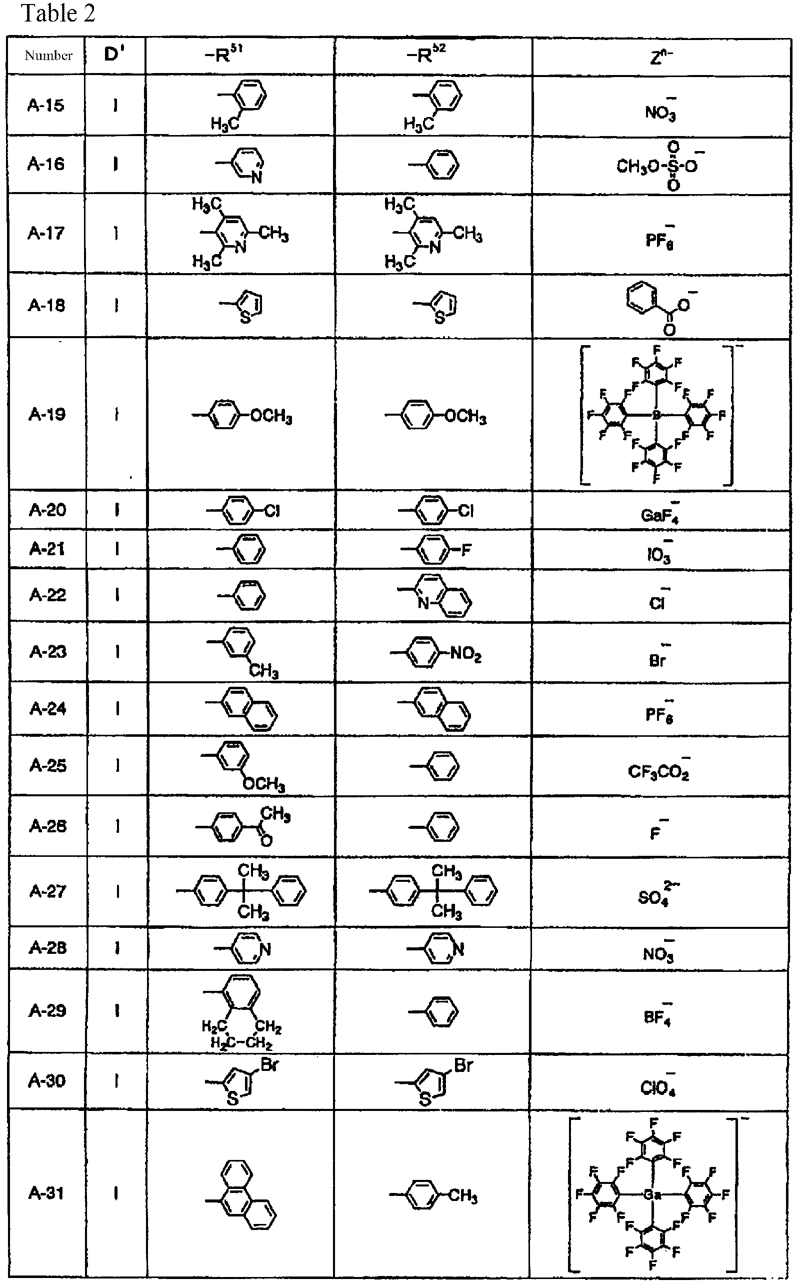

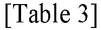

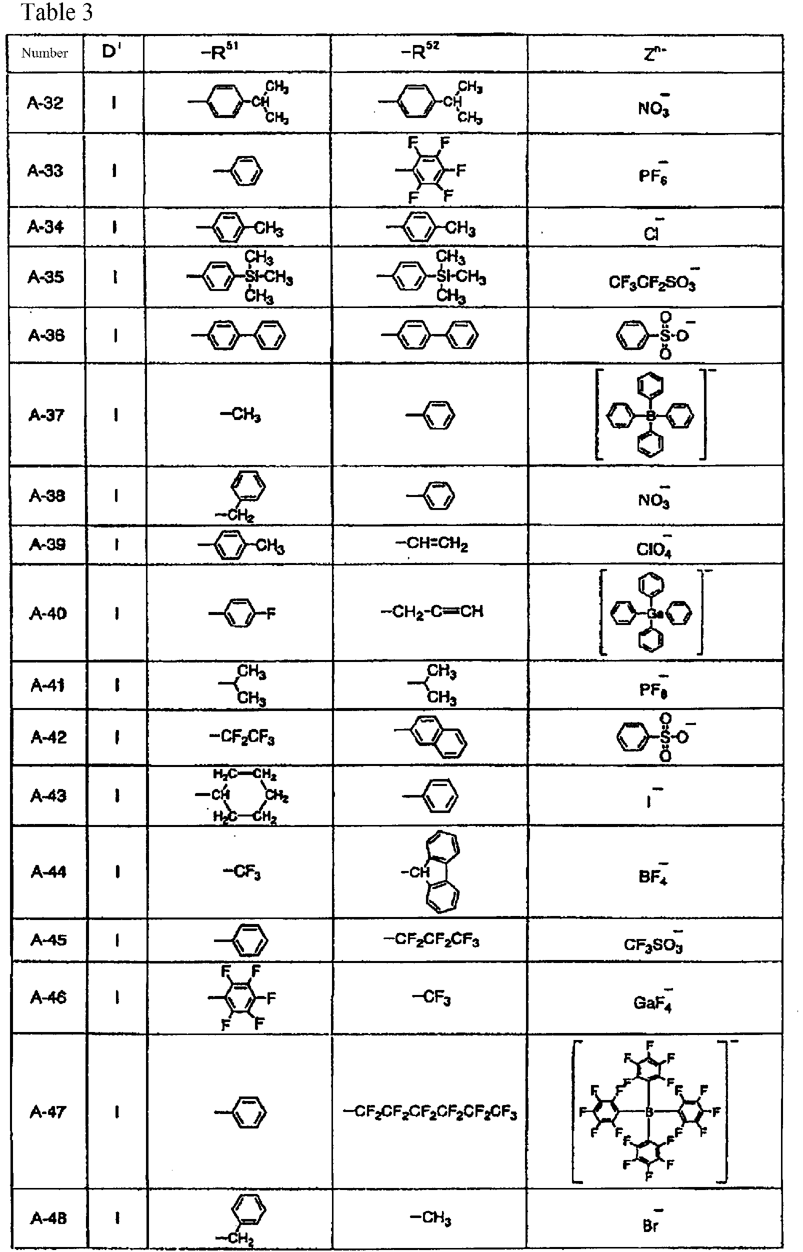

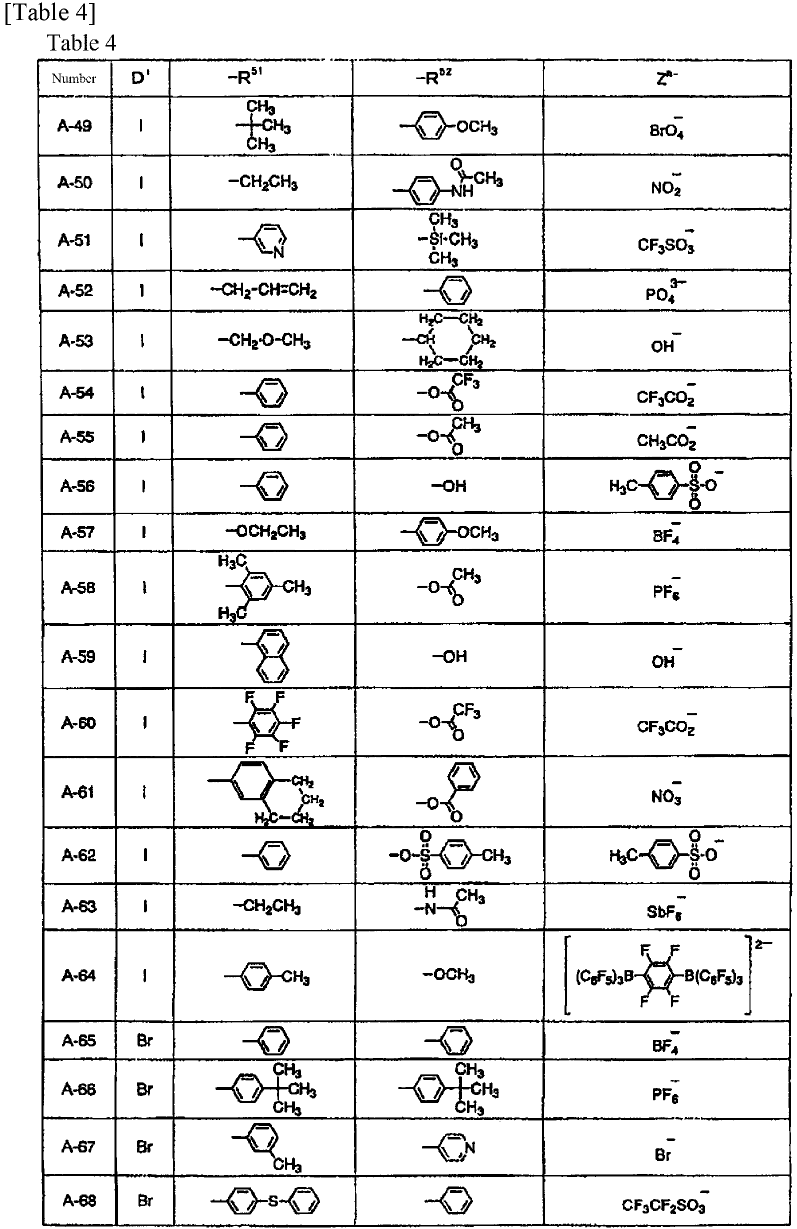

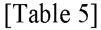

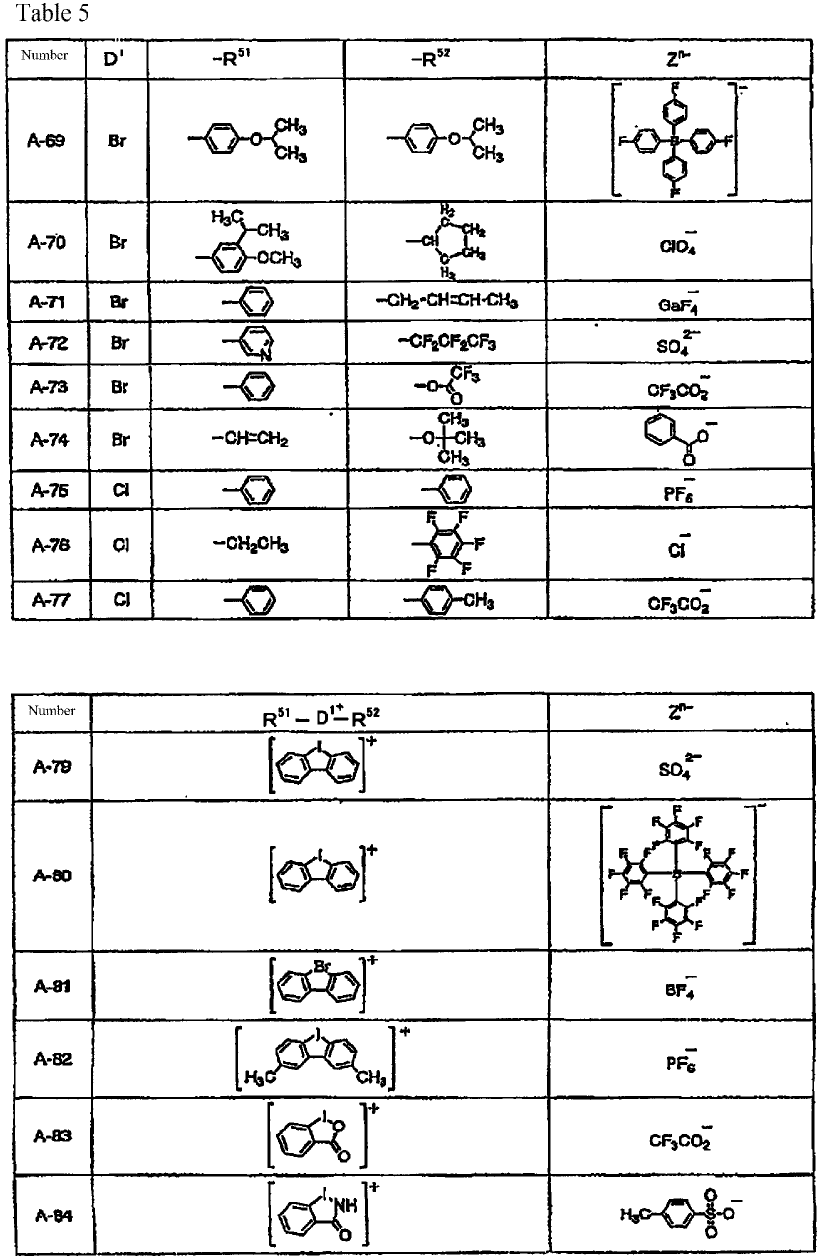

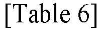

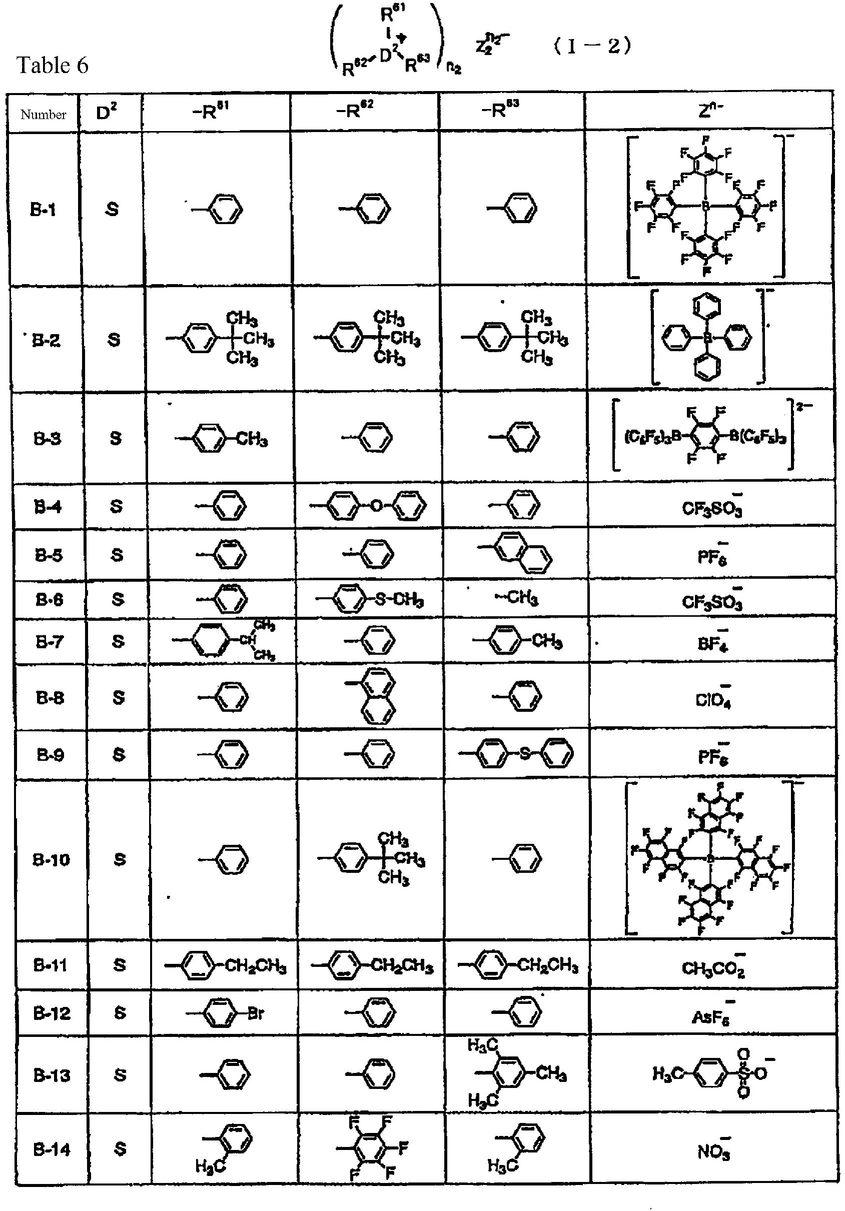

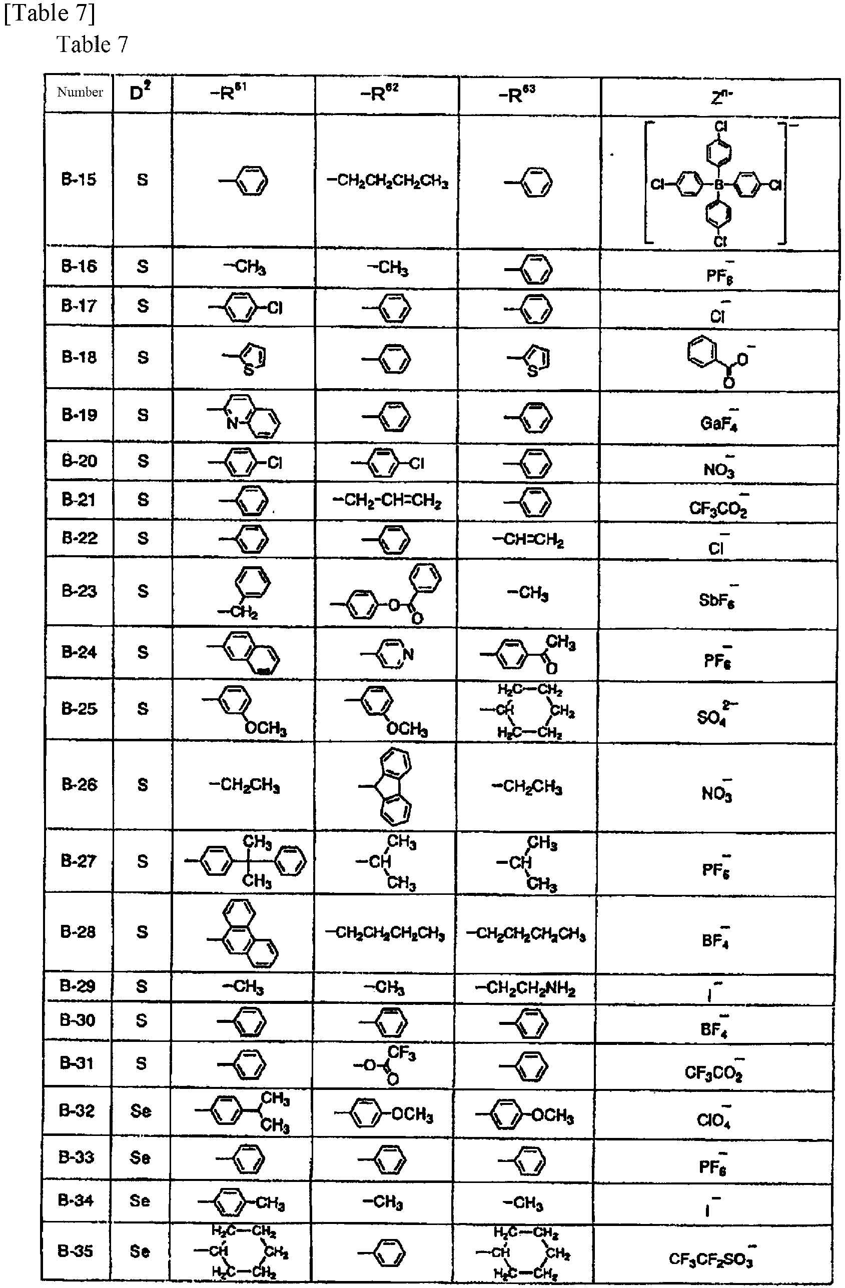

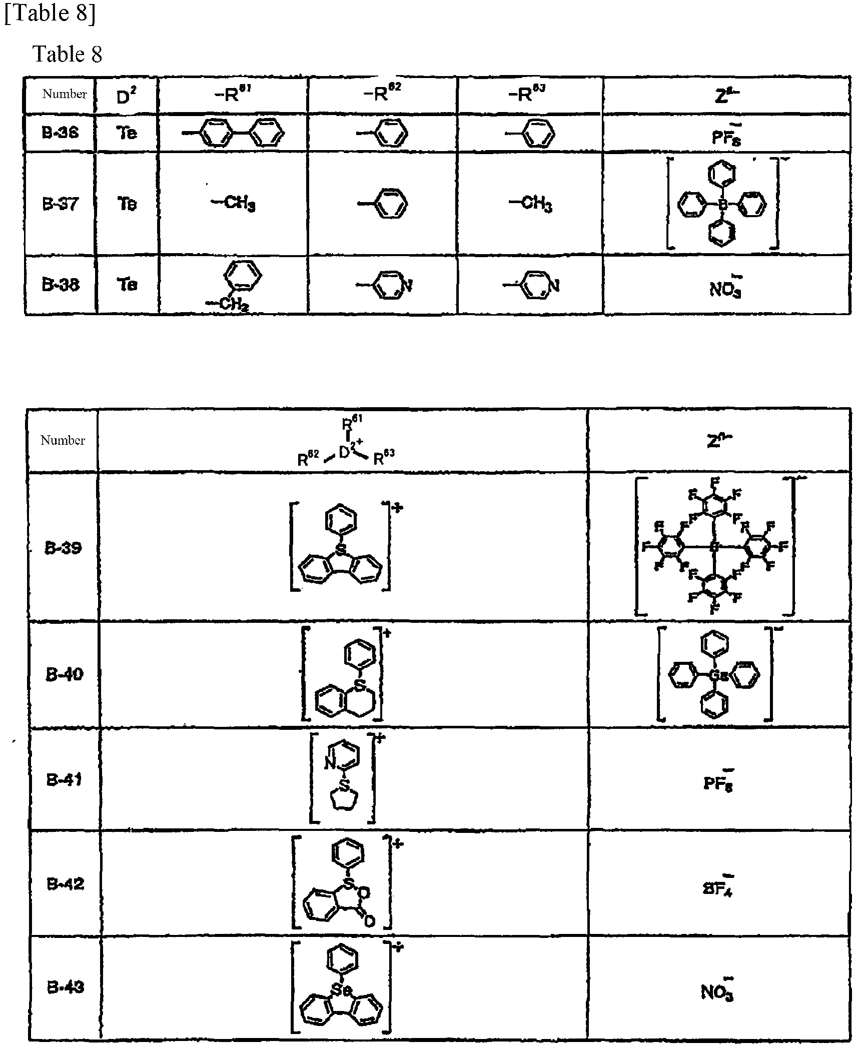

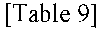

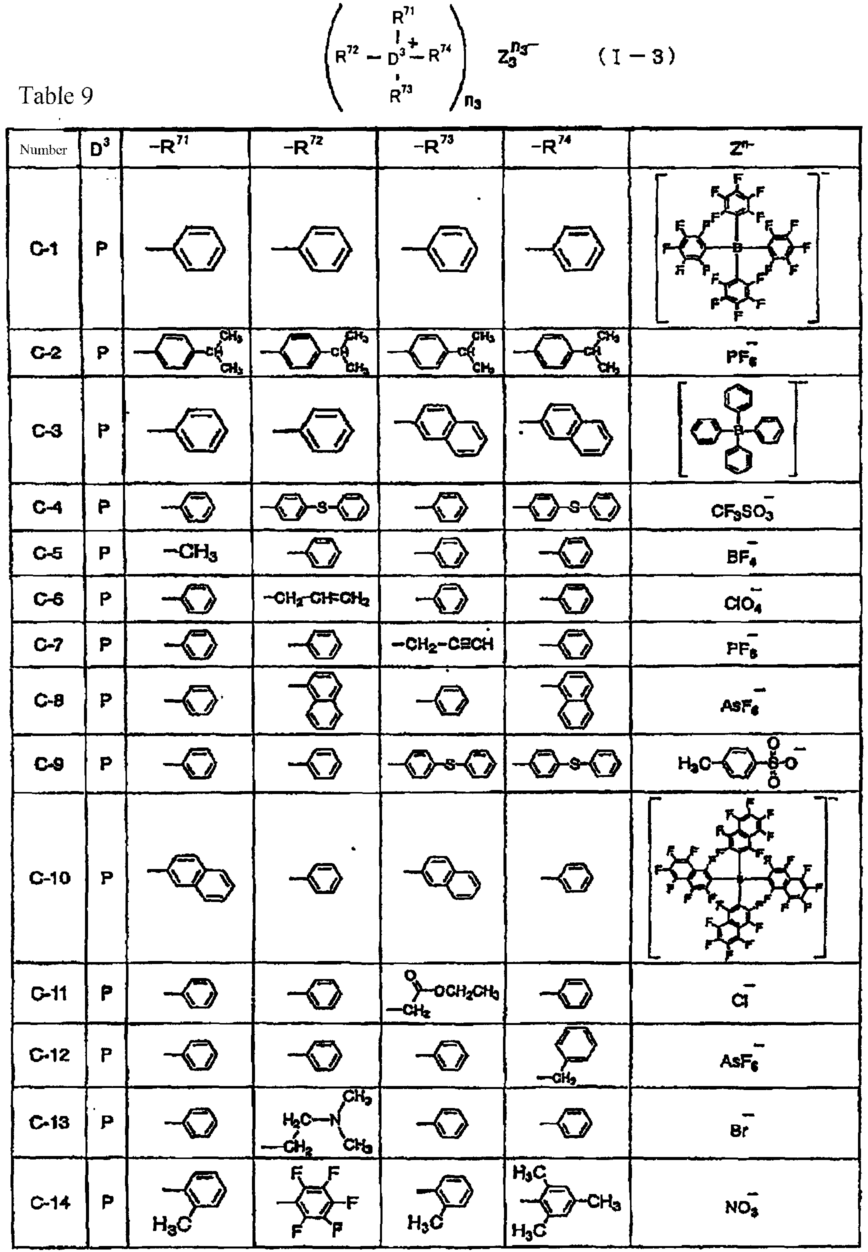

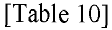

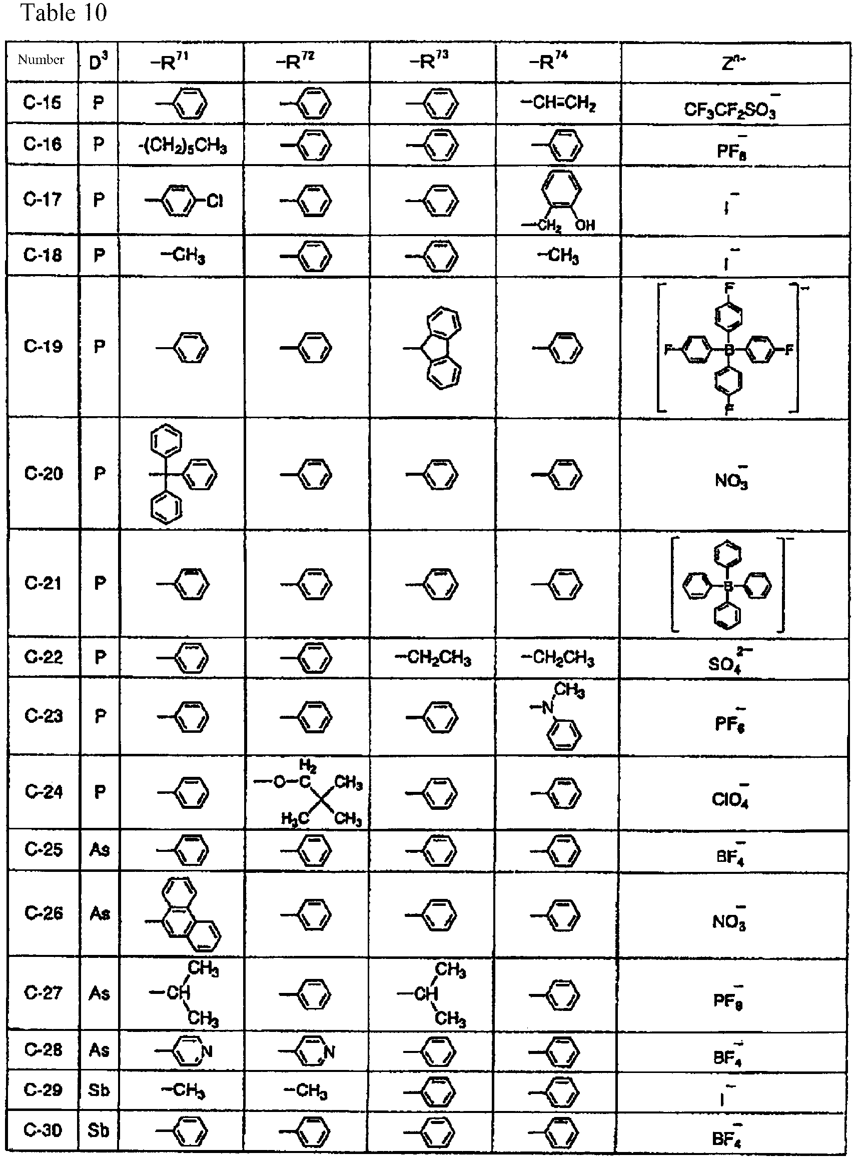

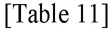

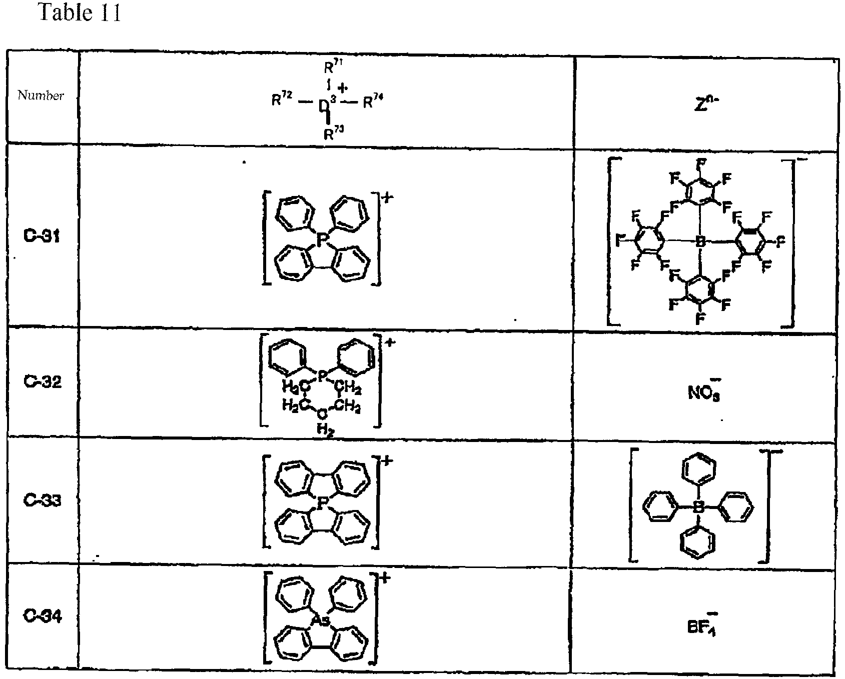

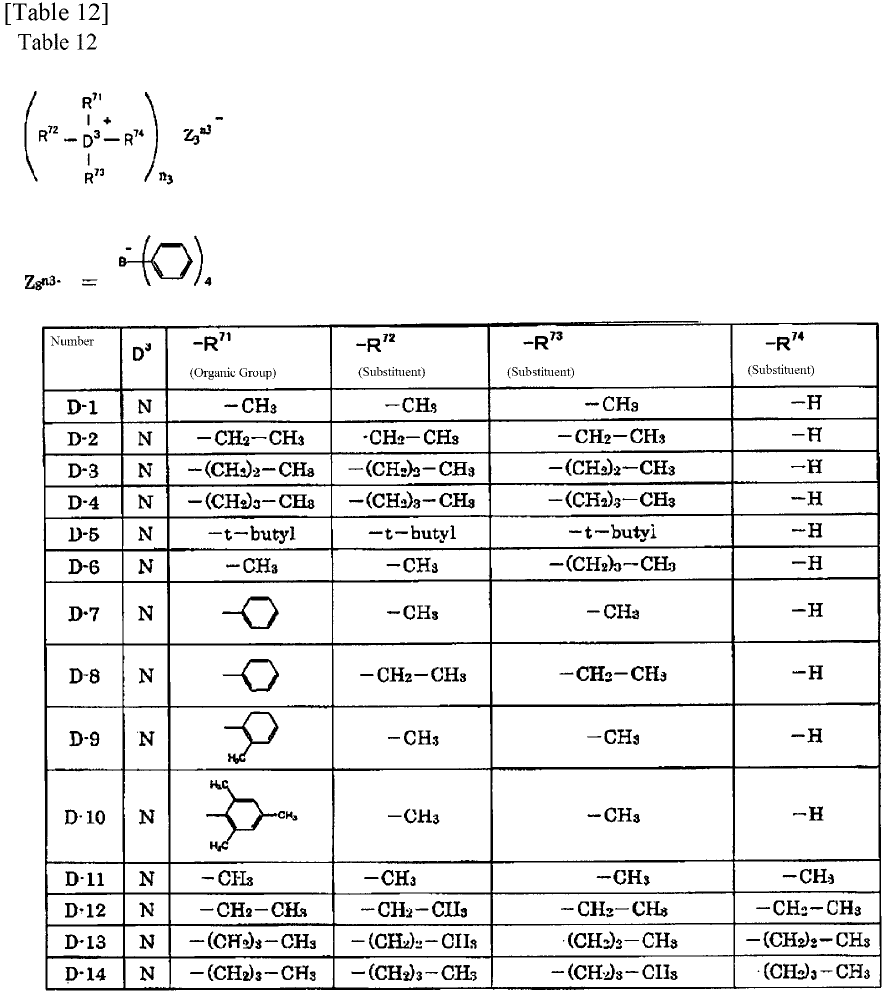

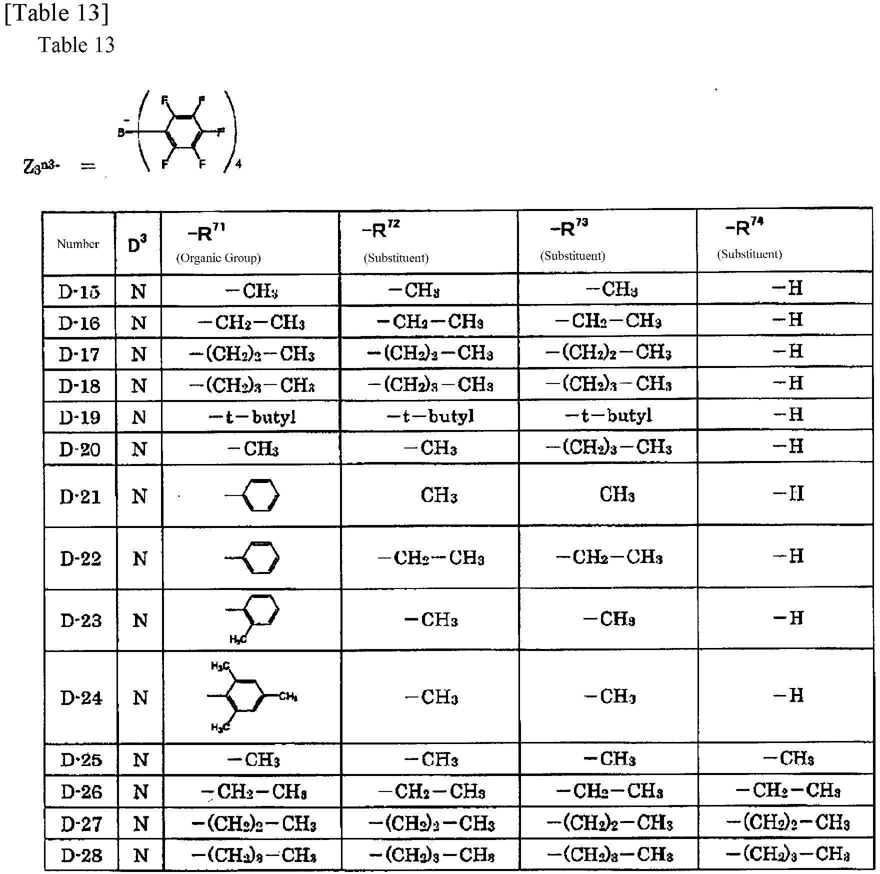

Of the above-mentioned examples, preferred are compounds of A-1 to A-48, A-54, A-55, A-60 to A-62, A-64 to A-75, A-79 to A-83, B-1 to B-20, B-24, B-25, B-27, B-30 to B-37, B-39 to B-43, C-1 to C-10, C-19 to C-21, C-25 to C-27, C-30, C-31 and D-15 to D-28, from the viewpoint of electron acceptability, heat resistance, and solubility in organic solvent. More preferred are compounds of A-1 to A-9, A-12 to A-15, A-17, A-19, A-24, A-29, A-31 to A-33, A-36, A-37, A-65, A-66, A-69, A-80 to A-82, B-1 to B-3, B-5, B-7 to B-10, B-16, B-30, B-33, B-39, C-1 to C-3, C-5, C-10, C-21, C-25, C-31, and D-17 to D-28; and most preferred are compounds of A-1 to A-7, A-80 and D-21 to D-24.

The method for producing the above-mentioned electron-accepting compounds is not specifically defined, and the compounds may be produced according to various methods. For example, there are mentioned the methods described in Chem. Rev., Vol. 66, p. 243, 1966, and J. Org. Chem., Vol. 53, p. 5571, 1988.

The composition for organic electroluminescent elements of the present invention may contain any one of the above-mentioned electron-accepting compounds or two or more of the compounds as combined in any desired manner and in any desired ratio. If desired, two or more electron-accepting compounds corresponding to any one of the formulae (I-1) to (I-3) may be combined, and two or more electron-accepting compounds corresponding to different formulae may be combined.

The content of the electron-accepting compound in the composition for electroluminescent elements of the present invention may be, as the value relative to the above-mentioned aromatic amine polymer, generally 0.1% by weight or more, preferably 1% by weight or more and is generally 100% by weight or less, preferably 40% by weight or less.

When the content of the electron-accepting compound is too small, then the driving voltage for the elements may increase; but when the content of the electron-accepting compound is too large, the film formability of the composition may worsen. In case where two or more different types of electron-accepting compounds are used as combined, the total content of the combined compounds is controlled to fall within the above-mentioned range.

### <Organic Solvent>

The organic solvent contained in the composition for organic electroluminescent elements of the present invention is preferably an organic solvent capable of dissolving the aromatic amine polymer in the present invention in an amount of generally 0.05% by weight or more, preferably 0.5% by weight or more, more preferably 1% by weight or more.

Also preferably, the organic solvent dissolves the electron-accepting compound in an amount of 0.005% by weight or more, more preferably 0.05% by weight or more, even more preferably 0.5% by weight or more.

Concretely, the organic solvent includes an aromatic organic solvent, a halogen-containing organic solvent, an ether organic solvent and an ester organic solvent.

Specific examples of the aromatic organic solvent include toluene, xylene, mesitylene, cyclohexylbenzene, pentafluoromethoxybenzene, ethyl (pentafluorobenzoate), etc.;

Specific examples of the halogen-containing organic solvent include 1,2-dichloroethane, chlorobenzene, o-dichlorobenzene, etc.;

Specific examples of the ether organic solvent include aliphatic ethers such as ethylene glycol dimethyl ether, ethylene glycol diethyl ether, propylene glycol-1-monomethylethyl acetate (PGMEA), etc.; aromatic ethers such as 1,2-dimethoxybenzene, 1,3-dimethoxybenzene, anisole, phenetol, 2-methoxytoluene, 3-methoxytoluene, 4-methoxytoluene, 2,3-dimethylanisole, 2,4-dimethylanisole, diphenyl ether, etc.;

Specific examples of the ester organic solvent include aliphatic esters such as ethyl acetate, n-butyl acetate, ethyl lactate, n-butyl lactate, etc.; aromatic esters such as phenyl acetate, phenyl propionate, methyl benzoate, ethyl benzoate, propyl benzoate, n-butyl benzoate, etc.

Because the solvent must dissolve the aromatic amine polymer and because the solvent has a high capability of dissolving the cation radical of the hole injection/transporting material to be formed by mixing a hole transporting material such as the aromatic amine polymer and an electron-accepting compound, preferred are an ether organic solvent and an ester organic solvent.

One alone or two or more of these solvents may be used here either alone or as a mixed solvent thereof.

The organic solvent to be contained in the composition for organic electroluminescent elements of the present invention includes an organic solvent having a vapor pressure at 25°C of 10 mmHg or less, preferably 5 mmHg or less, and generally 0.1 mmHg or more.

The concentration of the organic solvent to be contained in the composition for organic electroluminescent elements of the present invention is generally 10% by weight or more, preferably 50% by weight or more, more preferably 80% by weight or more.

The organic solvent may contain, if desired, any other various types of organic solvents, in addition to the above-mentioned organic solvent. Such other organic solvents include, for example, amide organic solvents such as N,N-dimethylformamide, N,N-dimethylacetamide, etc., and dimethyl sulfoxide, etc. Further, the solvent may contain various additives such as a leveling agent, a defoaming agent, etc.

It is widely known that water may promote performance deterioration of organic electroluminescent elements, especially brightness reduction thereof during continuous operation. Consequently, for reducing as much as possible the content of water that may remain in coating films, more preferred is, of those organic solvents, one having a water solubility at 25°C of 1% by weight or less, even more preferably 0.1% by weight or less.

As the organic solvent for use herein, further mentioned is an organic solvent having a surface tension at 20°C of generally less than 40 dyn/cm, preferably 36 dyn/cm or less, more preferably 33 dyn/cm or less.

The organic solvent may be a mixed solvent, which includes a mixed organic solvent of an organic solvent having a vapor pressure at 25°C of 2 mmHg or more, preferably 3 mmHg or more, more preferably 4 mmHg or more (however, the upper limit is preferably 10 mmHg or less), and an organic solvent having a vapor pressure at 25°C of less than 2 mmHg, preferably 1 mmHg or less, more preferably 0.5 mmHg or less. Using the organic solvent of the type makes it possible to prepare a composition suitable to a process of producing organic electroluminescent elements according to a wet film formation method, and suitable to the properties of the aromatic amine polymer to be used here.

### <Regarding Physical Properties of Composition for Organic Electroluminescent Elements>

The viscosity of the composition for organic electroluminescent elements of the present invention is, though varying depending on the concentration of the solid component therein, generally 15 mPas or less, preferably 10 mPas or less, more preferably 8 mPas or less, and is generally 2 mPas or more, preferably 3 mPas or more, more preferably 5 mPas or more.

When the viscosity is higher than the range, then a uniform film could not be formed in film formation according to a wet film formation method. When lower than the range, the composition would fail in film formation.

The viscosity may be measured using a rotary viscometer. In general, the viscosity depends on the temperature and the rotation number in measurement. The above-mentioned value is one measured under given conditions at a measurement temperature of 23°C at a measurement rotation number of 20 rotations.

### <Additives>

If desired, the composition for organic electroluminescent elements of the present invention may contain various additives of coatability improvers, such as a leveling agent, a defoaming agent, etc. In the case, the organic solvent is preferably one capable of dissolving both the aromatic amine polymer and the additives in an amount of 0.05% by weight or more, more preferably 0.5% by weight or more, even more preferably 1% by weight or more.

### <Use>

The composition for organic electroluminescent elements of the present invention is favorable since it is free from a problem of foreign substance formation and enables uniform film formation in a case of forming a hole injection layer and/or a hole transport layer according to a wet film formation method.

The wet film formation method in the present invention is meant to indicate a film formation method using an organic solvent-containing composition in a mode of a spin coating method, a dip coating method, a die coating method, a bar coating method, a blade coating method, a roll coating method, a spray coating method, a capillary coating method, a composition jet method, a screen printing method, a gravure printing method, a flexographic printing method, an offset printing method, etc.

From the viewpoint of easiness in patterning, preferred is a die coating method, a roll coating method, a spray coating method, a composition jet method or a flexographic printing method.

### <Production Method for Composition for Organic Electroluminescent Elements>

Examples of the production method for the composition for organic electroluminescent elements of the present invention are mentioned below, to which, however, the present invention is not limited.

In particular, the composition for organic electroluminescent elements of the present invention may be produced according to the method mentioned below, or according to a combination of especially preferred methods.

### [1] Addition Mode/Method

When the aromatic amine polymer, the electron-accepting compound and the organic solvent to be contained in the composition for organic electroluminescent elements of the present invention are mixed, the aromatic amine polymer and the electron-accepting compound each may be independently a solid, or may also be a solution.

Preferably, the aromatic amine polymer and the electron-accepting compound are mixed both as solutions. Also preferably, any one of the aromatic amine polymer and the electron-accepting compound is a solid and the other is a solution, and the two are mixed as they are. In this case, the solid is added to the solution since the dissolution of the solid can be confirmed.

Also preferably, the aromatic amine polymer and the electron-accepting compound are both solids, and these are ground and mixed, and then dissolved in an organic solvent.

In the case of mixing the solids as mentioned above, the particle size of the solids is generally 5 cm or less, preferably 1 cm or less, more preferably 5 mm or less, and is generally 0.5 mm or more.

### [2] Dissolving Step

The preferred production method for the composition for organic electroluminescent elements of the present invention generally comprises a dissolving step.

The dissolving step is a step of stirring the solids in an organic solvent to dissolve them therein to such a degree that floating of any solid could not be confirmed visually.

The temperature in the dissolving step is generally 20°C or higher, preferably 40°C or higher, and is generally not higher than the boiling point of the organic solvent used, preferably a temperature lower by at least 10°C than the boiling point of the organic solvent.

When the temperature is higher than the upper limit, then the organic solvent may partly evaporate away and the concentration of the resultant solution may vary; but when lower than the lower limit, then the organic solvent used may solidify or the solubility therein may lower and therefore the solution could not have a desired concentration.

The atmosphere in the dissolving step is not specifically defined, not detracting from the advantageous effects of the present invention, for which there may be mentioned an inert gas. The inert gas includes, for example, a nitrogen gas, an argon gas, etc. From the viewpoint of easy handleability, preferred is a nitrogen gas.

### [3] Ultrasonic Treatment, Photoirradiation Treatment, Heat Treatment

Especially preferably, the production method for the composition for organic electroluminescent elements of the present invention includes at least one treatment of ultrasonic treatment, photoirradiation treatment and heat treatment.

The time for the treatment is not specifically defined, not detracting from the advantageous effects of the present invention. The treatment may be carried out in the dissolving step, or may be carried out after the dissolving step.

Any one alone or two or more of these treatments may be carried out either singly or as combined.

### (Ultrasonic Treatment)

For ultrasonic treatment, preferably used is an oscillator at 28 kHz.

The ultrasonic treatment time is generally 5 minutes or more, preferably 10 minutes or more, and is generally 2 hours or less, preferably 1 hour or less.

When the time is longer than the upper limit, then the polymer may decompose; but when shorter than the lower limit, the dissolution would be insufficient.

### (Photoirradiation Treatment)

For photoirradiation treatment, preferably used is a high-pressure mercury lamp. The high-pressure mercury lamp is a light source for greenish blue-white (5,700 K) comprising a bright line spectrum at 404.7 nm, 435.8 nm, 546.1 nm, 577.0 nm and 579.1 nm, and provides UV irradiation at 253.7 nm and 365.0 nm.

The UV irradiation method is not specifically defined. The prepared composition may be directly irradiated, or the composition put in a suitable container may be irradiated with UV rays.

In a case where the container can transmit UV rays, the container may be UV-irradiated while kept closed; however, in a case where the container blocks UV rays, then, for example, the cover is opened and UV rays may be applied via the opening.

The apparatus for use in UV irradiation is not specifically defined. For example, usable here are a xenon lamp, a mercury lamp, a high-pressure mercury lamp, an ultrahigh-pressure mercury lamp, a metal halide lamp, a UV fluorescent lamp, a D2 lamp, a carbon arc lamp, an LED, etc.

When the composition contains an organic solvent, the liquid temperature of the composition is not specifically defined. In the case, the temperature is generally room temperature, but the composition may be further cooled or heated.

The UV dose is generally 10 mJ/cm² or more, preferably 100 mJ/cm² or more, more preferably 600 mJ/cm² or more, and is generally 50,000 mJ/cm² or less, preferably 10,000 mJ/cm² or less, even more preferably 5,000 mJ/cm² or less.

Falling within the above range is preferred since the electro mobility from the aromatic amine polymer to the electron-accepting compound could be sufficient and the aromatic amine polymer is hardly degraded.

In general, UV rays are absorbed on the surface of the composition, and therefore it is desirable that after UV irradiation, the composition is stirred to be uniform, or the composition is UV-irradiated with stirring.

Regarding the UV irradiation area, preferably, the entire container containing the composition therein is UV-irradiated, but a part of the composition may be UV-irradiated. In the case, it is desirable that the composition is stirred after UV irradiation, or the composition is UV-irradiated with stirring.

### (Heat Treatment)

For the heating means for the heat treatment, employable here is any known technique not detracting from the advantageous effects of the present invention.

Concretely, there may be mentioned a stirring method in which an aromatic amine polymer, an electron-accepting compound and an organic solvent are put in a heatable container, and with stirring and with controlling the temperature by the use of a heating bath, these are heated and stirred.

As the heating bath, usable here are a water bath, an oil bath, etc.

As the case may be, an aromatic amine polymer, an electron-accepting compound and an organic solvent may be put in a heating container and stirred therein, and then kept in a thermostat chamber capable of being controllable at a predetermined temperature, thereby heating them therein.

In consideration of safety, preferred is a heating and stirring method using a heating bath.

The heating temperature in the heat treatment is generally 40°C or more, preferably 80°C or more, and is generally not higher than the boiling point of the organic solvent used, preferably a temperature lower by at least 10°C than the boiling point of the organic solvent.

The upper limit of the boiling point is based on the boiling point of the organic solvent having the lowest boiling point of two or more organic solvents.

When the temperature is higher than the upper limit, then there may be a risk of bumping of the organic solvent and, in addition, owing to evaporation of the organic solvent, the concentration of the system solution may vary. When lower than the lower limit, then the heat treatment would be ineffective and the dissolution would be insufficient.

The heating time for the heat treatment is generally 1 hour or more, preferably 5 hours or more and is generally 36 hours or less, preferably 24 hours or less. When the time is longer than the upper limit, then the organic solvent may evaporate away, but when shorter than the lower limit, then the dissolution would be insufficient.

The reason why at least one treatment of ultrasonic treatment, photoirradiation treatment or heat treatment could make it possible to produce the composition for organic electroluminescent elements of the present invention may be presumed as follows.

Through at least one treatment of ultrasonic treatment, photoirradiation treatment or heat treatment, the aggregated state of the aromatic amine polymer could be relaxed so that the aromatic amine polymer could be more readily close to the electron-accepting compound.

Thus kept in contact in the manner, the aromatic amine polymer forms a cation radical in the molecule thereof and is in an ion pair state to the electron-accepting compound that is an anion radical, and consequently, there hardly occurs polymer aggregation or electron-accepting compound aggregation. As a result, it becomes possible to produce a composition for charge transport films, in which the proportion of large-size aggregates having a micron-order particle size is reduced.

### [4] Filtration Step

Preferably, the production method for the composition for organic electroluminescent elements of the present invention includes a filtration step. Also preferably, the filtration step is carried out after the dissolution step in the present invention.

The pore size of the filter to be used in the filtration step is generally 5 µm or less, preferably 0.5 µm or less, and is generally 0.02 µm or more, preferably 0.1 µm or more.

When the size is more than the upper limit, then insolubles may mix in the solution, but when less than the lower limit, the solution could not pass through the filter and may clog the filter.

### <Use for forming a layer according to a Film Formation Method>

The present invention also pertains to the use of the composition for organic electroluminescent elements as described above for forming at least one layer selected from a group consisting of a light-emitting layer, a hole injection layer and a hole transport layer according to a wet film formation method, the at least one layer selected from a group consisting of a light-emitting layer, a hole injection layer and a hole transport layer being comprised in an organic electroluminescent element comprising, as laminated on a substrate, at least an anode, a hole injection layer, a hole transport layer, a light-emitting layer and a cathode.

As described above, organic electroluminescent elements are formed through lamination of multiple layers comprising a large number of organic compounds, and therefore it is extremely important that the film quality is uniform. In layer formation according to a wet film formation method, there may be employed a known film formation method including a coating method such as a spin coating method, or a spray coating method, and a printing method such as an inkjet method, or a screen method, depending on the layer-constituting materials and on the quality of the substrate.

In such a use according to a wet film formation method, the composition for organic electroluminescent elements of the present invention is applied onto a layer that corresponds to an underlayer on which the intended layer is to be formed, according to a method of a spin coating method, or a dip coating method, and then dried thereon to form the intended layer.] In case where the aromatic amine polymer in the present invention does not have an insolubilizing group, the film of the composition for organic electroluminescent elements is, after formed by coating, dried according to ordinary heating. As the drying method, generally employed is a heating step.

Examples of the heating means for use in the heating step include a clean oven, a hot plate, an IR ray, a halogen heater, microwave irradiation, etc. Above all, for giving heat uniformly to the entire film, preferred are a clean oven and a hot plate.

Regarding the heating temperature in the heating step, the coating film may be heated at a temperature not lower than the boiling point of the organic solvent used in the composition for organic electroluminescent elements, not markedly detracting from the advantageous effects of the present invention. In case where the layer contains the dissociating polymer mentioned above, it is desirable that the coating layer is heated at a temperature not lower than the temperature at which the dissociating group may dissociate.

In case where the composition for organic electroluminescent elements contains two or more types of organic solvents, it is desirable that at least one is heated at a temperature not lower than the boiling point of the organic solvent.

In consideration of the boiling point elevation of the organic solvent, it is desirable that, in the heating step, the coating layer is heated preferably at 120°C or higher and preferably at 410°C or lower.

In case where the coating layer is heated through irradiation with active energy such as light, in addition to heating, there may be employed a method of direct irradiation using a UV/visible light/IR light source such as an ultrahigh-pressure mercury lamp, a high-pressure mercury lamp, a halogen lamp, or an IR lamp, or a method of irradiation using a mask aligner or a conveyor-type photoirradiation apparatus having a built-in light source of the above-mentioned ones.

For active energy irradiation not with light, for example, there may be employed a method using an irradiating apparatus with microwaves generated through a magnetron, or that is, using a so-called microwave oven.

The irradiation time is preferably one for which insolubilization reaction could go on sufficiently, and is generally 0.1 seconds or more, and preferably 10 hours or less.

The active energy irradiation with heating or light may be carried out each independently, or as combined. In combined irradiation, the order of the operation is not specifically defined.

The active energy irradiation with heating or light is preferably carried out in an atmosphere not containing water, such as a nitrogen gas atmosphere, for reducing the water content in the layer after the treatment and/or for reducing the amount of water that may adsorb to the surface of the layer. For the same purpose, in case where active energy irradiation with heating and/or light is carried out as combined, it is especially desirable that the step just before formation of light-emitting layer is carried out in an atmosphere not containing water such as a nitrogen atmosphere.

### [Organic Electroluminescent Element]

The organic electroluminescent element of the present invention has at least an anode, a hole injection layer, a hole transport layer, a light-emitting layer and a cathode as laminated on a substrate, in which at least one layer of the hole injection layer and the hole transport layer is formed according to a wet film formation method using the composition for organic electroluminescent elements of the present invention.

The organic electroluminescent element in which the layer formed of the composition for organic electroluminescent elements of the present invention is a layer adjacent to the anode therein has an effective of evading short circuit and dark spot formation. Consequently, the layer formed of the composition for organic electroluminescent elements of the present invention is preferably a hole injection layer.

Also preferably, all the hole injection layer, the hole transport layer and the light-emitting layer are formed according to a wet film formation method. The organic electroluminescent element of the present invention may have an inorganic layer.

One example of the layer configuration of the organic electroluminescent element of the present invention, and a general forming method for the element are described hereinunder with reference to Fig. 1.

Fig. 1 is a schematic cross-sectional view showing one example of configuration of the organic electroluminescent element of the present invention. In Fig. 1, 1 is a substrate, 2 is an anode, 3 is a hole injection layer, 4 is a hole transport layer, 5 is a light-emitting layer, 6 is a hole block layer, 7 is an electron transport layer, 8 is an electron injection layer and 9 is a cathode.

In case where the organic layer between the anode and the cathode in such an organic electroluminescent element is formed according to a wet film formation method, a composition for wet film formation is prepared by dispersing or dissolving the materials for each layer mentioned below, in an organic solvent to prepare a composition for wet film formation, and the composition for wet film formation may be used for forming the intended layer.

### {Substrate}

The substrate is to be a support of the organic electroluminescent element, for which usable is a plate of quartz or glass, a metal plate or a metal foil, or a plastic film, sheet. In particular, preferred are a glass plate, and a transparent synthetic resin plate of polyester, polymethacrylate, polycarbonate, polysulfone, etc.

In case where a synthetic resin plate is used, attention should be paid to the gas barrier property thereof. When the gas barrier property of the substrate is poor, then the organic electroluminescent element may be degraded by air having passed through the substrate. Consequently, a method of providing a dense silicon oxide film on at least one surface of such a synthetic resin substrate to secure the gas barrier property of the substrate is one preferred method.

### {Anode}

The anode plays a role of hole injection into the layer on the side of the light-emitting layer.

In general, the anode is formed of a metal such as aluminium, gold, silver, nickel, palladium, platinum, etc.; a metal oxide such as indium and/or tin oxide, etc.; a metal halide such as copper iodide, etc.; carbon black; or a conductive polymer such as poly(3-methylthiophene), polypyrrole, polyaniline, etc.

In general, the anode is formed according to a sputtering method, a vacuum vapor deposition method in many cases. On the other hand, in a case where the anode is formed using metal fine particles of silver, fine particles of copper iodide, carbon black, conductive metal oxide fine particles, conductive polymer fine powder, the material may be dispersed in a suitable binder resin solution and may be applied onto the substrate by coating to form the anode thereon.

Further, in a case of using a conductive polymer, a thin film may be formed directly on the substrate through electrolytic polymerization, or a conductive polymer may be applied onto the substrate by coating to form the anode thereon (Appl. Phys. Lett., Vol. 60, p. 2711, 1992).

The anode generally has a single-layer structure, but if desired, may have a laminate structure comprising different types of materials.

The thickness of the anode may vary depending on the needed transparency. In case where the transparency is needed, it is desirable that the visible light transmittance is generally 60% or more, preferably 80% or more. In this case, the thickness of the anode is generally 5 nm or more, preferably 10 nm or more, and is generally 1000 nm or less, preferably 500 nm or less or so.

In case where the anode may be nontransparent, the thickness thereof may be any arbitrary one, and the anode may be the same as the substrate.

Further, any different conductive material may be layered on the anode.

For the purpose of improving the hole injectability by removing the impurities having adhered to the anode and by controlling the ionization potential, it is desirable that the surface of the anode is processed through ultraviolet (UV)/ozone treatment, oxygen plasma treatment or argon plasma treatment.

### {Hole Injection Layer}

The hole injection layer is a layer having the function of transporting holes from the anode to the light-emitting layer and is, in general, formed on the anode.

For expressing this function, the hole injection layer is preferably a layer formed of the composition for organic electroluminescent elements of the present invention.

### (Film Formation Method)

After the composition for organic electroluminescent elements of the present invention has been prepared, the composition is applied onto the layer that corresponds to the underlayer below the hole injection layer (in general, anode) for film formation thereon according to wet film formation, and dried to form the hole injection layer.

The temperature in wet film formation is preferably 10°C or higher and is preferably 50°C or lower for preventing the film from having defects owing to crystal formation in the composition.

The relative humidity in wet film formation is not specifically defined so far as it does not markedly detract from the advantageous effects of the present invention, but is generally 0.01 ppm or more and is generally 80% or less.

After the film formation, the film of the composition for organic electroluminescent elements of the present invention is dried generally by heating. Examples of the heating means include clean oven, hot plate, IR rays, halogen heater, microwave irradiation, etc. Above all, preferred is clean oven or hot plate for uniformly giving heat to the entire film.

The heating temperature may be any one not markedly detracting from the advantageous effects of the present invention, and preferably, the coating film is heated at a temperature not lower than the boiling point of at least one of the organic solvents used in the composition for organic electroluminescent elements of the present invention, or at a temperature close to that boiling point.

In consideration of boiling point elevation of the organic solvent, it is desirable that the coating film is heated at 200°C or higher, more preferably at 220°C or higher, and preferably at 410°C or lower in the heating step.

In the heating step, the heating time is not specifically defined so far as the heating temperature is not lower than the boiling point of the organic solvent in the composition for organic electroluminescent elements of the present invention and so far as the film formed through wet film formation can be fully insolubilized; however, the heating time is preferably 10 seconds or more and is generally 180 minutes or less. Falling within the range is preferred since a uniform film can be formed. The heating may be carried out two times.

The thickness of the film formed according to the above-mentioned method is generally 1 nm or more, preferably 5 nm or more, and is generally 1,000 nm or less, preferably 500 nm or less.

### {Hole Transport Layer}

The organic electroluminescent element of the present invention generally has a hole transport layer.

The formation method for the hole transport layer is not specifically defined, however, from the viewpoint of reducing dark spots, the hole transport layer is preferably formed through wet film formation.

The hole transport layer may be formed on the hole injection layer in the case of the organic electroluminescent element having the configuration shown in Fig. 1.

The material for forming the hole transport layer is preferably a material having high hole transportability and capable of efficiently transporting the injected holes. Consequently, it is desirable that the material for forming the hole transport layer has a small ionization potential, is highly transparent to visible light, has a large hole mobility, is excellent in stability and generates few impurities to be traps in production and during use.

Kept in adjacent to the light-emitting layer, in many cases, it is desirable that the hole transport layer does not quench the emission from the light-emitting layer and does not form an exciplex with the light-emitting layer lower the light emission efficiency.

The material for the hole transport layer may be any and every material heretofore used as the constitutive material for hole transport layer, and includes, for example, those exemplified as the hole-transporting compound for use in the composition for organic electroluminescent elements of the present invention.

Further mentioned are aromatic diamines which contain two or more tertiary amines and in which the nitrogen atom is substituted with two or more condensed aromatic rings, such as typically 4,4'-bis[N-(1-naphthyl)-N-phenylamino]biphenyl (JP-A 5-234681), aromatic amine compounds having a starburst structure such as 4,4',4"-tris(1-naphthylphenylamino)triphenylamine (J. Lumin., Vols. 72-74, p. 985, 1997), aromatic amine compounds comprising a tetramer of triphenylamine (Chem. Commun., p.2175, 1996), spiro compounds such as 2,2',7,7'-tetrakis-(diphenylamino)-9,9'-spirofluorene (Synth. Metals, Vol. 91, p. 209, 1997), carbazole derivatives such as 4,4'-N,N'-dicarbazole-biphenyl, etc.

In addition, for example, further mentioned are polyvinylcarbazole, polyvinyltriphenylamine (JP-A 7-53953), tetraphenylbenzidine-containing polyarylene ether sulfone (Polym. Adv. Tech., Vol. 7, p. 33, 1996), etc.

In case where the hole transport layer is formed according to a wet film formation method, a composition for forming the hole transport layer is prepared, then applied for film formation, and heated and dried.

The hole transport layer-forming composition contains an organic solvent in addition to the hole-transporting compound therein. The organic solvent is the same as that used in the composition for organic electroluminescent elements of the present invention, and the film-forming condition and the heating and drying condition are also the same as those in hole injection layer formation.

In case where the hole transport layer is formed according to a vacuum vapor deposition method, the film-forming condition is as mentioned below.

For forming the hole transport layer through vacuum vapor deposition, one or more of the constitutive materials of the hole injection layer (above-mentioned hole-transporting compound, electron-accepting compound, etc.) are put into the crucibles set in a vacuum chamber (in case where two or more different types of materials are used, the materials are individually put in different crucibles), the vacuum chamber is degassed down to 10⁻⁴ Pa or so via a suitable vacuum pump, then the crucibles are heated (in case where two or more different types of materials are used, the respective crucibles are heated) to thereby evaporate the solvent under control of the evaporation amount thereof (in case where two or more different types of materials are used, each material is evaporated under independent control of the evaporation amount thereof), and thus the hole injection layer is formed on the anode on the substrate put to face the crucibles.

In case where two or more different types of materials are used, a mixture thereof may be put in one crucible, and may be heated and evaporated to form the hole injection layer.

Not markedly detracting from the advantageous effects of the present invention, the vacuum degree in evaporation is not specifically defined. The vacuum degree in evaporation is typically 0.1 × 10⁻⁶ Torr (0.13 × 10⁻⁴ Pa) or more and 9.0 × 10⁻⁶ Torr (12.0 × 10⁻⁴ Pa) or less.

Not markedly detracting from the advantageous effects of the present invention, the evaporation rate is not specifically defined. The evaporation rate is typically 0.1 angstrom/sec or more and is 5.0 angstrom/sec or less.

Also not markedly detracting from the advantageous effects of the present invention, the film formation temperature in vapor deposition is preferably 10°C or higher and is preferably 50°C or lower.

The hole transport layer may contain various types of light-emitting material, electron-transporting compound, binder resin, and coating improver, in addition to the above-mentioned hole-transporting compound.

The hole transport layer may be a layer formed by crosslinking a crosslinking compound.

The crosslinking compound is a compound having a crosslinking group to be mentioned below, and crosslinks to form a network aromatic amine polymer. The crosslinking compound may be any of monomer, oligomer and polymer, and above all, preferred is an aromatic amine polymer.

One alone or two or more different types of crosslinking compounds may be used here either singly or as combined in any desired manner and in any desired ratio.

The crosslinking group is a group that reacts with the same or different group of any other molecule existing in the vicinity thereof, thereby forming a new chemical bond.

For example, there is mentioned a group that reacts with the same or different group of any other molecule existing in the vicinity thereof through irradiation with heat and/or active energy rays, thereby forming a new chemical bond.

Examples of the crosslinking group include a cyclic ether group such as an oxetane group, an epoxy group, etc.; an unsaturated double bond such as a vinyl group, a trifluorovinyl group, a styryl group, an acryl group, a methacryloyl group, a cinnamoyl group, etc.; a benzocyclobutane group, etc.

The number of the crosslinking groups that the crosslinking group-having monomer, oligomer or polymer has is not specifically defined. In general, the number is less than 2.0 per the charge transport unit, preferably 0.8 or less, more preferably 0.5 or less. The range is for controlling the specific permittivity of the crosslinking compound to fall within a preferred range.

In addition, when the number of the crosslinking groups is too large, then a reactive active species may form and may have some negative influence on the other materials.

Here, the charge transport unit is the monomer itself, when the material to form the network aromatic amine polymer is a monomer, indicating the skeleton excluding the crosslinking group (main skeleton). In a case of mixing different types of monomers, the unit indicates the main skeleton of each monomer.

In a case where the material to form the network polymer is an aromatic amine polymer and where the polymer has a structure where the conjugation is organochemically interrupted, the repeating structure is referred to as the charge transport unit. In a case of a structure where conjugation continues broadly, the minimum repeating structure showing charge transportability is the monomer structure.

For example, there are mentioned polycyclic aromatics such as naphthalene, triphenylene, phenanthrene, tetracene, chrysene, pyrene, perylene, etc.; fluorene, triphenylene, carbazole, triarylamine, tetra-arylbenzidine, 1,4-bis(diarylamino)benzene, etc.

As the crosslinking compound, preferably used is a crosslinking group-having hole-transporting compound.

Examples of the hole-transporting compound include nitrogen-containing aromatic compound derivatives such as pyridine derivatives, pyrazine derivatives, pyrimidine derivatives, triazine derivatives, quinoline derivatives, phenanthroline derivatives, carbazole derivatives, phthalocyanine derivatives, porphyrin derivatives, etc.; triphenylamine derivatives; silol derivatives; oligothiophene derivatives, condensed polycyclic aromatic derivatives, metal complexes, etc.

Of those, preferred are nitrogen-containing aromatic derivatives such as pyridine derivatives, pyrazine derivatives, pyrimidine derivatives, triazine derivatives, quinoline derivatives, phenanthroline derivatives, carbazole derivatives, etc.; triphenylamine derivatives, silol derivatives, condensed polycyclic aromatic derivatives, metal complexes, etc.; and more preferred are triphenylamine derivatives.

The molecular weight of the crosslinking compound is generally 5,000 or less, preferably 2,500 or less, and is preferably 300 or more, more preferably 500 or more.

For forming the hole transport layer by crosslinking the crosslinking compound, in general, the crosslinking compound is dispersed or dissolved in an organic solvent to prepare a coating liquid (hole transport layer-forming composition), and the liquid is applied through wet film formation and crosslinked to form a film.

The coating liquid may contain an additive for promoting crosslinking reaction, in addition to the crosslinking compound.

Examples of the additive for promoting crosslinking reaction include a crosslinking initiator and a crosslinking promoter such as alkylphenone compounds, acylphosphine oxide compounds, metallocene compounds, oxime ester compounds, azo compounds, onium salts, etc.; an optical sensitizer such as condensed polycyclic hydrocarbons, porphyrin compounds, diarylketone compounds, etc.

The composition may further contain a coating improver such as a leveling agent, a defoaming agent, etc.; an electron-accepting compound; a binder resin, etc.

In case where the composition for organic electroluminescent elements of the present invention is used for forming the hole injection layer, the organic solvent to be used in the coating liquid may be the same as those exemplified for the organic solvent for the composition for forming hole transport layer in PTL 1.

The coating liquid contains the crosslinking compound generally in an amount of 0.01% by mass or more, preferably 0.05% by mass or more, more preferably 0.1% by mass or more and is generally in an amount of 50% by weight or less, preferably 20% by weight or less, more preferably 10% by weight or less.

In case where the composition for organic electroluminescent elements of the present invention is not used for forming the hole injection layer, the organic solvent in the present invention is preferably used in the hole transport layer.

After the coating liquid has been applied onto the underlayer to form a film thereon, the crosslinking compound is crosslinked by heating and/or active energy ray irradiation to form a network polymer. The heating method after the film formation is not specifically defined. For example, there are mentioned heating drying, reduced-pressure drying, etc.

Regarding the condition for heating drying, the coating layer may be heated generally at 120°C or higher, and preferably 400°C or lower. The heating time is generally 1 minute or more and preferably 24 hours or less.

The heating means is not specifically defined. Employable is a method of putting the laminate having the coating layer on a hot plate, or heating it in an oven. For example, the laminate may be heated on a hot plate at 120°C or higher for 1 minute or more.

For the case of active energy ray irradiation, there may be mentioned a method of direct irradiation with a UV/visible light/IR light source such as an ultrahigh-pressure mercury lamp, a high-pressure mercury lamp, a halogen lamp, an IR lamp, or a method of irradiation using a mask aligner or a conveyor-type photoirradiation apparatus having a built-in light source of the above-mentioned ones.

For active energy ray irradiation not with light, for example, there may be employed a method using an irradiating apparatus with microwaves generated through a magnetron, or that is, using a so-called microwave oven.

The irradiation time is preferably one necessary for lowering the film solubility, and is generally 0.1 seconds or more, and preferably 10 hours or less.

Heating and active energy ray irradiation may be carried out each independently, or as combined. In combined irradiation, the order of the operation is not specifically defined.

Heating and active energy ray irradiation is preferably carried out in an atmosphere not containing water, such as a nitrogen gas atmosphere, for reducing the water content in the layer after the treatment and/or for reducing the amount of water that may adsorb to the surface of the layer. For the same purpose, in case where heating and/or active energy ray irradiation is carried out as combined, it is especially desirable that the step just before formation of light-emitting layer is carried out in an atmosphere not containing water such as a nitrogen atmosphere.

The thickness of the hole transport layer is generally 5 nm or more, preferably 10 nm or more, and is generally 300 nm or less, preferably 100 nm or less.

### {Light-Emitting Layer}

In case where the hole transport layer is formed on the hole injection layer, a light-emitting layer is provided on the hole transport layer. The light-emitting layer is, as sandwiched between the electrodes given an electric field, excited though recombination of the holes injected thereinto from the anode and the electrons injected thereinto from the cathode, and is a layer to be a main light-emitting source in the element.

### <Material of Light-Emitting Layer>

The light-emitting layer contains, as the constituent material thereof, at least a material having the property of light emission (light-emitting material), and preferably contains a compound having the property of hole movement (hole-transporting material) or a compound having the property of electron movement (electron-transporting material).

The light-emitting material is not specifically defined, and any substance capable of emitting light at a desired emission wavelength and having good emission efficiency may be used here. Preferably, the light-emitting material contains two or more different types of charge-transporting materials. In addition, the light-emitting layer may contain any other component within a range not markedly detracting from the advantageous effects of the present invention.

In case where the light-emitting layer is formed according to a wet film formation method, every material is preferably used in a monomer amount thereof.

### (Light-Emitting Material)

As the light-emitting material, any known material is usable here. For example, usable is a fluorescent light-emitting material or a phosphorescent light-emitting material. From the viewpoint of the internal quantum efficiency thereof, preferred is a phosphorescent light-emitting material.

For the purpose of improving the solubility in organic solvent, it is desirable that the symmetry and the rigidness of the molecule of the light-emitting material are lowered or an oleophilic substituent such as an alkyl group is introduced into the material.

Of the light-emitting materials, examples of the fluorescent dye are shown below. However, the fluorescent dye for use herein is not limited to the following exemplified ones.

As fluorescent dyes of giving blue light emission (blue fluorescent dyes), for example, there are mentioned naphthalene, perylene, pyrene, anthracene, coumarin, chrysene, p-bis(2-phenylethenyl)benzene and their derivatives, etc.

As fluorescent dyes of giving green light emission (green fluorescent dyes), for example, there are mentioned quinacridone derivatives, coumarin derivatives, aluminium complexes such as Al(C₉H₆NO)₃, etc.

As fluorescent dyes of giving yellow light emission (yellow fluorescent dyes), for example, there are mentioned rubrene, perimidone derivatives, etc.

As fluorescent dyes of giving red light emission (red fluorescent dyes), for example, there are mentioned DCM (4-(dicyanomethylene)-2-methyl-6-(p-dimethylaminostyryl)-4H-pyran) compounds, benzopyran derivatives, rhodamine derivatives, benzothioxanthene derivatives, azabenzothioxanthene, etc.

As the phosphorescent light-emitting materials, for example, there are mentioned organic metal complexes containing a metal selected from Groups 7 to 11 of the Long Periodic Table.

As the metal selected from Groups 7 to 11 of the Long Periodic Table, preferably mentioned are ruthenium, rhodium, palladium, silver, rhenium, osmium, iridium, platinum, gold, etc.

The ligand in the complexes is preferably one having a (hetero)aryl group and pyridine, pyrazole, or phenanthroline bonding thereto, such as a (hetero)arylpyridine ligand, or a (hetero)arylpyrazole ligand, and is more preferably a phenylpyridine ligand or a phenylpyrazole ligand.

Here, (hetero)aryl means an aryl group or a heteroaryl group.

As the phosphorescent light-emitting materials, concretely, there are mentioned tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethylplatinum porphyrin, octaphenylplatinum porphyrin, octaethylpalladium porphyrin, octaphenylpalladium porphyrin, etc.

Not markedly detracting from the advantageous effects of the present invention, the molecular weight of the compound for use as the light-emitting material is not specifically defined, but is generally 10,000 or less, preferably 5,000 or less, more preferably 4,000 or less, even more preferably 3,000 or less and is generally 100 or more, preferably 200 or more, more preferably 300 or more, even more preferably 400 or more.

When the molecular weight of the light-emitting material is too small, then the heat resistance may greatly lower, the material may cause gas generation, the quality of the formed film may lower, or the material may cause morphology change of organic electroluminescent elements owing to migration. On the other hand, when the molecular weight of the light-emitting material is too large, then the light-emitting material would be difficult to purify, or would take much time in dissolving in organic solvent.

One alone or two or more of the above-mentioned light-emitting materials may be used here either singly or as combined in any desired manner and in any desired ratio.

The proportion of the light-emitting material in the light-emitting layer may be any desired one, not markedly detracting from the advantageous effects of the invention, and is generally 0.05% by weight or more, preferably 0.3% by weight or more, more preferably 0.5% by weight or more, and is generally 35% by weight or less, preferably 25% by weight or less, more preferably 20% by weight or less.

When the amount of the light-emitting material is too small, then there may occur emission unevenness; but when too large, then the emission efficiency may lower.

In case where two or more light-emitting materials are used here, as combined, the total content of the materials is controlled to fall within the above range.

### (Hole-Transporting Material)

The light-emitting layer may contain a hole-transporting material as the constituent material therein. Here, examples of the monomer amount of the hole-transporting material of hole-transporting materials include, for example, in addition to various types of compounds exemplified hereinabove as (monomer amount of hole-transporting material) in the hole injection layer, aromatic diamines having two or more tertiary amines and having two or more condensed aromatic rings on the nitrogen atoms therein, such as typically 4,4'-bis[N-(1-naphthyl)-N-phenylamino]biphenyl (JP-A 5-234681); aromatic amine compounds having a starburst structure such as 4,4',4"-tris(1-naphthylphenylamino)triphenylamine, etc. (Journal of Luminescence, 1997, Vol. 72-74, p. 985); aromatic amine compounds comprising a triphenylamine tetramer (Chemical Communications, 1996, p. 2175); spiro compounds such as 2,2',7,7'-tetrakis-(diphenylamino)-9,9'-spirobifluorene, etc. (Synthetic Metals, 1997, Vol. 91, p. 209), etc.

In the light-emitting material, one alone or two or more hole-transporting materials may be used either singly or as combined in any desired manner and in any desired ratio.

The proportion of the hole-transporting material in the light-emitting layer may be any desired one, not markedly detracting from the advantageous effects of the present invention, and is generally 0.1% by weight or more, preferably 0.5% by weight or more, more preferably 1% by weight or more, and is generally 65% by weight or less, preferably 50% by weight or less, more preferably 40% by weight or less.

When the amount of the hole-transporting material is too small, then the layer would be readily influenced by short circuit, but when too large, then there may occur film thickness unevenness.

In case where two or more hole-transporting materials are used here, as combined, the total content of the materials is controlled to fall within the above range.

### (Electron-Transporting Material)

The light-emitting layer may contain an electron-transporting material as the constituent material therein. Here, examples of the monomer amount of the electron-transporting material of electron-transporting materials include 2,5-bis(1-naphthyl)-1,3,4-oxadiazole (BND), 2,5-bis(6'-(2',2"-bipyridyl))-1,1-dimethyl-3,4-diphenylsilol (PyPySPyPy), basophenanthroline (BPhen), 2,9-dimethyl-4,7-diphenyl-1,10-phenanthroline (BCP, bathocuproin), 2-(4-biphenylyl)-5-(p-tertiary butylphenyl)-1,3,4-oxadiazole (tBu-PBD), 4,4'-bis(9-carbazole)-biphenyl (CBP), etc.

In the light-emitting layer, one alone or two or more electron-transporting materials may be used either singly or as combined in any desired manner and in any desired ratio.

The proportion of the electron-transporting material in the light-emitting layer may be any desired one, not markedly detracting from the advantageous effects of the present invention, and is generally 0.1% by weight or more, preferably 0.5% by weight or more, more preferably 1% by weight or more, and is generally 65% by weight or less, preferably 50% by weight or less, more preferably 40% by weight or less.

When the amount of the electron-transporting material is too small, then the layer would be readily influenced by short circuit, but when too large, then there may occur film thickness unevenness. In case where two or more hole-transporting materials are used here, as combined, the total content of the materials is controlled to fall within the above range.

### <Formation of Light-Emitting Layer>

In case where the light-emitting layer is formed according to the wet film formation method of the present invention, the above-mentioned materials are dissolved in a suitable solvent to prepare a composition for wet film formation, and using it, the layer is formed through a film formation step and preferably through a drying step.

The details of these steps are the same as those described hereinabove. In case where any other organic material is formed according to the wet film formation method of the present invention, the light-emitting layer may be formed according to a vapor deposition method or in any other method.

Preferred examples of the organic solvent for the light-emitting layer are the same as the organic solvents for light-emitting layer in PTL 1.

The proportion of the organic solvent for light-emitting layer to the composition for wet film formation for forming the light-emitting layer may be any desired one, not markedly detracting from the advantageous effects of the present invention, and is generally 0.01% by weight or more, preferably 0.1% by weight or more, more preferably 0.5% by weight or more, and is generally 70% by weight or less, preferably 60% by weight or less, more preferably 50% by weight or less.

In case where two or more organic solvents are used, as mixed, for the light-emitting layer, the total content of these organic solvents is controlled to fall within the above range.

After wet film formation with the composition for wet film formation for forming the light-emitting layer, the coating film is dried and the organic solvent for light-emitting layer is removed to provide the light-emitting layer.

The mode of the wet film formation method is not specifically defined so far as it does not markedly detract from the advantageous effects of the present invention, for which is employable any of the above-mentioned modes.

The film thickness of the light-emitting layer may be any desired one, not markedly detracting from the advantageous effects of the present invention, and is generally 3 nm or more, preferably 5 nm or more, and generally 200 nm or less, preferably 100 nm or less.

When the light-emitting layer is too thin, then the film would have defects, but when too thick, then the driving voltage for the elements may increase.

### {Hole Block Layer}

A hole block layer may be provided between the light-emitting layer and the electron injection layer to be mentioned below. The hole block layer is a layer to be laminated on the light-emitting layer so as to be kept in contact with the interface on the side of the cathode of the light-emitting layer.

The hole block layer plays a role of blocking the holes moving from the anode from reaching the cathode, and plays a role of efficiently transporting the electrons injected from the cathode toward the light-emitting layer.

Regarding the necessary physical properties thereof, the material to constitute the hole block layer is desired to have a high electron mobility, a low hole mobility, a large energy gap (difference between HOMO and LUMO) and a high excitation triplet energy level (T1).

The material satisfying the requirements for the hole block layer includes, for example, mixed ligand complexes such as bis(2-methyl-8-quinolinolato)(phenolato)aluminium, bis(2-methyl-8-quinolinolato)(triphenylsilanolato)aluminium, etc.; metal complexes such as bis(2-methyl-8-quinolato)aluminium-µ-oxo-bis(2-methyl-8-quinolinolato)aluminium binuclear metal complex, etc.; styryl compounds such as distyrylbiphenyl derivatives, etc. (JP-A 11-242996); triazole derivatives such as 3-(4-biphenylyl)-4-phenyl-5(4-tert-butylphenyl)-1,2,4-triazole, etc. (JP-A 7-41759); phenanthroline derivatives such as bathocuproin, etc. (JP-A 10-79297), etc.

Further, compounds having at least one pyridine ring substituted at the 2,4,6-positions, as described in WO2005/022962, are also preferred as the material for the hole block layer.

One alone or two or more materials may be used for the hole block layer either singly or as combined in any desired manner and in any desired ratio.

The method for forming the hole block layer is not defined. Accordingly, the layer may be formed according to a wet film formation method, a vapor deposition method or any other method.

The thickness of the hole block layer may be any desired one, not markedly detracting from the advantageous effects of the present invention, and is typically 0.3 nm or more, preferably 0.5 nm or more, and typically 100 nm or less, preferably 50 nm or less.

### {Electron Transport Layer}

An electron transport layer is generally provided between the light-emitting layer and the cathode to be mentioned below.

The electron transport layer is a layer to be provided for further improving the emission efficiency of the element, and is formed of a compound capable of efficiently transporting the electrons injected from the cathode toward the direction of the light-emitting layer between the electrodes given an electric field.

The electron-transporting compound for the electron transport layer is a compound having a high electron injection efficiency from the cathode or the electron injection layer, having a high electron mobility and capable of efficiently transporting the injected electrons.

The compounds satisfying the requirements includes, for example, metal complexes such as aluminium complex of 8-hydroxyquinoline, etc. (JP-A 59-194393), 10-hydroxybenzo[h]quinoline metal complexes, oxadiazole derivatives, distyrylbiphenyl derivatives, silol derivatives, 3-hydroxyflavone metal complexes, 5-hydroxyflavone metal complexes, benzoxazole metal complexes, benzothiazole metal complexes, trisbenzimidazolylbenzene (USP 5645948), quinoxaline compounds (JP-A 6-207169), phenanthroline derivatives (JP-A 5-331459), 2-t-butyl-9,10-N,N'-dicyanoanthraquinonediimine, n-type hydrogenated amorphous silicon carbide, n-type zinc sulfide, n-type zinc selenide, etc.

One alone or two or more materials for the electron transport layer may be used either singly or as combined in any desired manner and in any desired ratio.

The formation method for the electron transport layer is not defined. Accordingly, the layer may be formed according to a wet film formation method or a vapor deposition method or in any other method.

The thickness of the electron transport layer may be any one, not markedly detracting from the advantageous effects of the present invention, and is typically 1 nm or more, preferably 5 nm or more, and typically 300 nm or less, preferably 100 nm or less.

The light-emitting layer and the electron transport layer may be a single one layer. In the case, the one layer contains the above-mentioned light-emitting material and electron-transporting material.

As the light-emitting material and the electron-transporting material, different compounds may be used, but one type of a compound having both a light emission function and an electron transportation function (for example, 8-hydroxyquinoline aluminium complex represented by the formula (C3) to be mentioned below) may be used.

### {Electron Injection Layer}

Preferably, an electron injection layer may be provided between the electron transport layer and the cathode.

The electron injection layer plays a role of efficiently injecting the electrons injected from the cathode to the light-emitting layer. For efficient electron injection, the material to form the electron injection layer is preferably a metal having a low work function.

Examples of the material include alkali metals such as sodium, cesium, etc.; and alkaline earth metals such as barium, calcium, etc. Preferably, the thickness of the layer is typically 0.1 nm or more and 5 nm or less.

Further, it is also desirable to dope an organic electron-transporting material such as typically a nitrogen-containing heterocyclic compound, for example, basophenanthroline or a metal complex, for example, an aluminium complex of 8-hydroxyquinoline with an alkali metal such as sodium, potassium, cesium, lithium, rubidium (as described in JP-A 10-270171, 2002-100478, 2002-100482, etc.), as capable of satisfying an excellent film quality having improved electron injection/transportation ability.

The thickness of the layer in the case is generally 5 nm or more, preferably 10 nm or more, and is generally 200 nm or less, preferably 100 nm or less.

One alone or two or more materials for the electron injection layer may be used either singly or as combined in any desired manner and in any desired ratio.

The formation method for the electron injection layer is not defined. Accordingly, the layer may be formed according to a wet film formation method or a vapor deposition method or in any other method.

### {Cathode}

The cathode plays a role of injecting electrons into the layer on the side of the light-emitting layer (electron injection layer or light-emitting layer).

As the material for the cathode, usable are those that are used for the above-mentioned anode. For efficient electron injection, preferred is use of a metal having a low work function. For example, employable are metals such as tin, magnesium, indium, calcium, aluminium, silver, or their alloys.

As concrete examples, there are mentioned alloy electrodes having a low work function, for example, magnesium-silver alloy, magnesium-indium alloy, aluminium-lithium alloy. etc.

One alone or two or more materials for the cathode may be used either singly or as combined in any desired manner and in any desired ratio.

The thickness of the cathode is generally the same as that of the anode.

Further, for the purpose of protecting the cathode formed of a metal having a low work function, it is desirable that a metal layer having a high work function and stable to air is laminated on the cathode to enhance the stability of the element. For this purpose, for example, used is a metal such as aluminium, silver, copper, nickel, chromium, gold, platinum, etc.

One alone or two or more such materials may be used here either singly or as combined in any desired manner and in any desired ratio.

### {Other Layers}

The organic electroluminescent element of the present disclosure may have any other configuration within a range not overstepping the scope thereof. For example, not detracting from the performance of the element, any other arbitrary layer than the above-mentioned layers may be provided between the anode and the cathode, or any arbitrary layer therebetween may be omitted.

### <Electron Block Layer>

The other optional layer that the element may have includes an electron block layer.

The electron block layer is provided between the hole injection layer of the hole transport layer and the light-emitting layer, and blocks the electrons moving from the light-emitting layer so as not to reach the hole injection layer, and therefore plays a role of increasing the recombination probability between holes and electrons in the light-emitting layer and trapping the formed excitons in the light-emitting layer and a role of efficiently transporting the holes injected from the hole injection layer toward the light-emitting layer. In particular, it is effective to provide the hole block layer in a case where a phosphorescent material is used as the light-emitting material and in a case where a blue light-emitting material is used.

Regarding the necessary properties thereof, the electron block layer is desired to have a high hole transferability, a large energy gap (difference between HOMO and LUMO) and a high excitation triplet energy level (T1).

In the present invention, in case where the light-emitting layer is formed according to a wet film formation method, the electron block layer is desired to be adaptable to wet film formation. The material to be used for the electron block layer includes a copolymer of dioctylfluorene and triphenylamine such as typically F8-TFB (WO 2004/084260), etc.

One alone or two or more materials may be used for the electron block layer either singly or as combined in any desired manner and in any desired ratio.

The formation method for the electron block layer is not defined. Accordingly, the layer may be formed according to a wet film formation method or a vapor deposition method or in any other method.

A method of inserting an ultrathin insulating film (0.1 to 5 nm) formed of, for example, lithium fluoride (LiF), magnesium fluoride (MgF₂), lithium oxide (Li₂O), or cesium(II) carbonate (CsCO₃), into the interface between the cathode and the light-emitting layer or the electron transport layer is also an effective method for improving the efficiency of the element (See Applied Physics Letters, 1997, Vo. 70, p. 152; JP-A 10-74586; IEEE Transactions on Electron Devices, 1997, Vol. 44, p. 1245; SID 04 Digest, p. 154, etc.).

In the layer configuration described above, the constituent members except the substrate may be laminated in the reverse order.

For example, in the layer configuration of Fig. 1, the other constituent members may be laminated on the substrate in an order of the cathode, the electron injection layer, the electron transport layer, the hole block layer, the light-emitting layer, the hole transport layer, the hole injection layer and the anode thereon. Further, between two substrate of which at least one is transparent, the other constituent members than those substrates may be sandwiched to construct the organic electroluminescent element of the present invention.

The other constituent members (light-emitting units) than the substrate may be laminated in multiple stages to construct a structure (having multiple light-emitting units laminated therein). In the case, in place of the interlayer between the adjacent stages (light-emitting units) (when the anode is ITO and the cathode is Al, the two are the interlayers), for example, a carrier generation layer (CGL) formed of vanadium pentoxide (V₂O₅) may be provided, and the embodiment is more preferred since the barrier between the stages is reduced and from the viewpoint of the luminescent efficiency and the driving voltage.

Further, the organic electroluminescent element of the present invention may be formed as a single organic electroluminescent element, or may be applied to a configuration where multiple organic electroluminescent elements are arranged in an array, or may also be applied to a configuration where the anode and the cathode are arranged in an X-Y matrix.

Not markedly detracting from the advantageous effects of the present invention, the above-mentioned layers may contain any other component than those described hereinabove as the materials of the layers.

### [Organic Electroluminescent (Organic EL) Display Device]

The organic EL display device of the present invention uses the above-mentioned organic electroluminescent element of the present invention. The type and the configuration of the organic EL display device of the present invention are not specifically defined. The display device can be constructed using the organic electroluminescent element of the present invention and according to an ordinary method.

For example, the organic EL display device can be constructed according to the method described in "Organic EL Display" (by Ohm, issued on August 20, 2004, written by Shizuo Tokito, Chihaya Adachi, Hideyuki Murata).

### [Organic Electroluminescent (Organic EL) Illumination]

The organic EL illumination of the present invention uses the above-mentioned organic electroluminescent element of the present invention. The type and the configuration of the organic EL illumination of the present invention to which the organic electroluminescent element of the present invention is applied are not specifically defined. The illumination can be constructed using the organic electroluminescent element of the present invention and according to an ordinary method.

### Examples

Next, the invention is described more concretely with reference to Examples; however, not overstepping the scope thereof, the present invention is not limited to the following Examples.

### [Synthesis and Purification of Aromatic Amine Polymer]

### [Synthesis Example 1: Synthesis of Aromatic Amine Polymer (P1-1)]

An aromatic amine polymer (P1-1) was synthesized according to the following reaction formula:

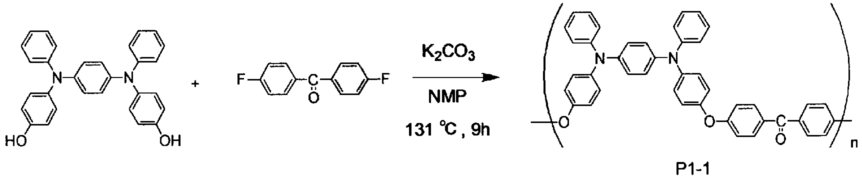

In a nitrogen stream atmosphere,
N,N'-bis(4-hydroxyphenyl)-N,N'-diphenyl-p-phenylenediamine (1.00 part by weight), 4,4'-difluorobenzophenone (0.49 parts by weight), potassium carbonate (1.87 parts by weight) and 1-methyl-2-pyrrolidone (23.13 parts by weight) were stirred at 131°C for 9 hours.

The resultant reaction mixture was cooled, and the insolubles were removed therefrom through intermediate filtration. The resultant filtrate was added to methanol to give a precipitate. This was collected through filtration, and dried under reduced pressure at 60°C for 6 hours to give a crude composition 1-1.

The crude composition 1-1 was dissolved in tetrahydrofuran, and normal heptane was added to the solution, and stirred at 20 ± 5°C for 30 minutes to give a precipitate. The supernatant was removed through decantation to give a precipitate. The same reprecipitation operation was repeated to give a crude composition 1-2.

The crude composition 1-2 was dissolved in toluene, and 2-propanol and desalted water were added to the toluene solution and stirred at 50± 5°C for 30 minutes. This was left statically as such for liquid-liquid separation, and the resultant organic layer was washed further twice according to the same operation to remove the inorganic fraction.

The resultant organic layer was concentrated under reduced pressure, the residue was extracted with tetrahydrofuran, the solution was added to methanol for precipitation, then the precipitate was collected through filtration and dried under reduced pressure at 60°C for 8 hours to give the intended, aromatic amine polymer (P1-1) (0.81 parts by weight, yield 59%).

### (SEC of Aromatic Amine Polymer (P1-1))

The resultant aromatic amine polymer (P1-1) was analyzed through SEC (size exclusion chromatography) under the condition mentioned below to determine the molecular weight thereof.

### <SEC Condition>

Apparatus: Tosoh's HLC 8020
Column: Tosoh's TSK gel GMHxL (column size 30 cm, two columns)
Column temperature: 40°C
Mobile phase: tetrahydrofuran
Flow rate: 1.0 ml/min
Injection concentration: 0.1% by weight
Injection amount: 0.10 ml
Detector: RI
Conversion method: polystyrene equivalent
Approximation expression: tertiary method

The weight-average molecular weight (Mw) of the resultant aromatic amine polymer (P1-1) was 24,000.

### [Synthesis Example 2: Synthesis of Aromatic Amine Polymer (P1-2)]

In the same manner as in Synthesis Example 1, in which, however, the starting material lot of the starting materials,
N,N'-bis(4-hydroxyphenyl)-N,N'-diphenyl-p-phenylenediamine and 4,4'-difluorobenzophenone was changed, the same aromatic amine polymer (P1-2) (weight-average molecular weight (Mw) = 24,000) as the aromatic amine polymer (P1-1) was produced.

### [Synthesis Example 3: Purification of Aromatic Amine Polymer (P1-2)]

105 parts by weight of tetrahydrofuran and 345 parts by weight of toluene were added to 50 parts by weight of the aromatic amine polymer (P1-2) produced in Synthesis Example 2 to give a uniform solution. Further, 500 parts by weight of 1 N hydrochloric acid was added to the solution, stirred and processed for liquid-liquid separation.

The resultant organic phase was washed three times with 500 parts by weight of water. 630 parts by weight of toluene was added to the separated organic layer, and the toluene solution of the organic layer was led to pass through a mixed bed ion-exchange resin layer formed by mixing 167 parts by weight of a strongly-acidic cation-exchange resin (Mitsubishi Chemical's trade name "Diaion (registered trademark) WK11 (trade name)") and 83 parts by weight of a strongly-basic anion-exchange resin (Mitsubishi Chemical's trade name "Diaion (registered trademark) SAN1 (trade name)").

The eluate was filtered through a polytetrafluoroethylene filter having a pore size of 0.1 µm (hereinafter referred to as "0.1 µm PTFE filter"), then discharged into 3,500 parts by weight of methanol to prepare a polymer slurry, filtered, and the solid fraction was washed with 350 parts by weight of methanol, and dried at 60°C for 8 hours to give a purified aromatic amine polymer (P1-3).

### [Synthesis Example 4: Purification of Aromatic Amine Polymer (P1-2)]

The aromatic amine polymer (P1-2) produced in Synthesis Example 2 was purified in the same manner as in Synthesis Example 3.

84 parts by weight of tetrahydrofuran and 276 parts by weight of toluene were added to 40 parts by weight of the aromatic amine polymer (P1-2) produced in Synthesis Example 2 to give a uniform solution. Further, 400 parts by weight of 1 N hydrochloric acid was added to the solution, stirred and processed for liquid-liquid separation.

The resultant organic phase was washed three times with 400 parts by weight of water. 630 parts by weight of toluene was added to the separated organic layer, and the toluene solution of the organic layer was led to pass through a mixed bed ion-exchange resin layer formed by mixing 134 parts by weight of a strongly-acidic cation-exchange resin (Mitsubishi Chemical's trade name "Diaion (registered trademark) WK11 (trade name)") and 66 parts by weight of a strongly-basic anion-exchange resin (Mitsubishi Chemical's trade name "Diaion (registered trademark) SAN1 (trade name)").

The eluate was filtered through a 0.1 µm PTFE filter, then discharged into 2800 parts by weight of methanol to prepare a polymer slurry, filtered, and the solid fraction was washed with 280 parts by weight of methanol, and dried at 60°C for 8 hours to give a purified aromatic amine polymer (P1-4).

### [Preparation and Evaluation of Composition for Organic Electroluminescent Elements]

### [Example 1]

### <Preparation of Composition 1 for Organic Electroluminescent Elements>

A composition 1 for organic electroluminescent elements containing the aromatic amine polymer (P1-3) obtained in Synthesis Example 3, an electron-accepting compound (A1) represented by the following structural formula and an organic solvent was prepared according to the formulation mentioned below.

| | | |
|---|---|---|
| Solute Components | compound (P1-3) | 3.0 parts by weight |
| | compound (A1) | 0.3 parts by weight |
| Organic Solvent ethyl benzoate | | 96.7 parts by weight |

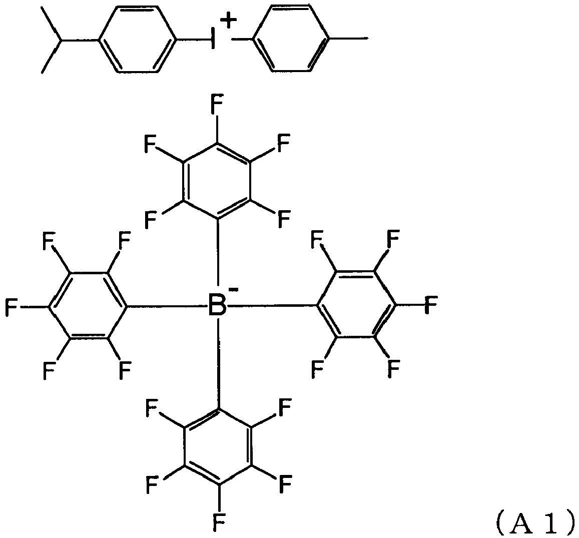

The compound (P1-3), the compound (A1) and the organic solvent were mixed, heated and stirred at 140°C for 3 hours. After left cooled, absence of any undissolved residue precipitate in the solution was confirmed visually, and then the solution was filtered through a 0.1 µm PTFE filter to give a composition 1 for organic electroluminescent elements.

The Zn concentration in the composition 1 for organic electroluminescent elements was quantified through ICP, and was 0.03 ppm.

### <Production of Organic Electroluminescent Element>

Using the resultant composition 1 for organic electroluminescent elements, an organic electroluminescent element was produced according to the method mentioned below.

### (Formation of Hole Injection Layer)

The composition 1 for organic electroluminescent elements mentioned above was applied onto a washed ITO substrate according to a spin coating method, then dried and baked to form a hole injection layer. The spin coating was carried out in air at an ambient temperature of 23°C and at a relative humidity of 50%, and the spinner rotation number was 2750 rpm, and the spinning time was 30 seconds.

After the coating, the layer was heated and dried on a hot plate at 80°C for 1 minute, and then baked in air in an oven at 230°C for 15 minutes to form a hole injection layer having a thickness of 35 nm.

### (Formation of Hole Transport Layer)

The ITO substrate with the hole injection layer thus formed thereon was set in the chamber of a vacuum vapor deposition apparatus. The chamber was roughly degassed through a rotary pump, and then further depressurized through a cryopump. The vacuum degree was 2.0 × 10⁻⁴ Pa. A vapor deposition mask was arranged on a predetermined region of the substrate, and necessary vapor deposition materials were previously put in separate ceramic crucibles and set in the chamber.

A ceramic crucible with 4,4'-bis[N-(9-phenanthryl)-N-phenyl-amino]biphenyl (PPD) represented by the following structural formula put therein was heated electrically for vapor deposition on the hole injection layer. The vacuum degree during the vapor deposition was 1.8 × 10⁻⁴ Pa, and the vapor deposition rate was from 0.8 angstrom/sec to 1.3 angstrom/sec. In that manner, a hole transport layer having a thickness of 45 nm was formed.

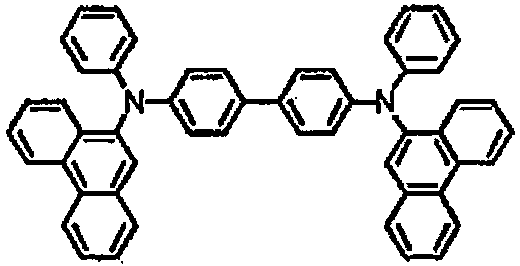

### (Formation of Light-Emitting/Electron Transport Layer)

Next, a ceramic crucible with 8-hydroxyquinoline aluminium complex (Alq3) represented by the following formula (C3) put therein was heated electrically for vapor deposition on the hole transport layer. The vacuum degree during the vapor deposition was 1.8 × 10⁻⁴ Pa, and the vapor deposition rate was from 1.0 angstrom/sec to 1.4 angstrom/sec. In that manner, an electron transport layer serving also as a light-emitting layer was formed, having a thickness of 60 nm.

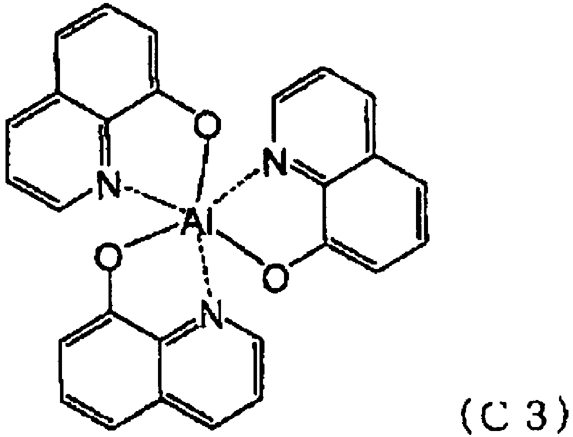

### (Cathode Formation)

Next, the substrate having been processed to have the light-emitting/electron transport layer was once taken out into air, and, as a mask for cathode deposition, a 7 mm-wide stripy shadow mask was arranged on the substrate so as to be orthogonal to the ITO stripe of the anode, and then immediately set in the vapor deposition apparatus. The chamber was roughly degassed through a rotary pump, and then depressurized through a cryopump. The vacuum degree was 3.4 × 10⁻⁶ Torr.

As the cathode, first, a molybdenum boat with lithium fluoride (LiF) put therein was heated electrically for vapor deposition on the electron transport layer. Regarding the vapor deposition condition, the vacuum degree during vapor deposition was 3.6 × 10⁻⁶ Torr, and the vapor deposition rate was from 0.16 angstrom/sec to 0.20 angstrom/sec. In that manner, a layer was formed to have a thickness of 0.5 nm.

Finally, a molybdenum boat with aluminium put therein was heated electrically, and the cathode was formed through vapor deposition. Regarding the vapor deposition condition, the vacuum degree during vapor deposition was from 6.0 × 10⁻⁶ Torr to 12.0 × 10⁻⁶ Torr, and the vapor deposition rate was from 2.6 angstrom/sec to 5.6 angstrom/sec. In that manner, a layer of the cathode was formed to have a thickness of 80 nm.

### (Sealing)

Next, the substrate with the cathode formed thereon was once taken out in air, and rapidly transferred into a nitrogen-purged glove box. In the nitrogen-purged glove box, a moisture-absorbing sheet was stuck to the recess region of a sealing glass plate, then a UV-curable resin was applied to the peripheral area of the recess region of the sealing glass plate using a dispenser, and the layer-deposited substrate was airtightly attached thereto in such a manner that the deposition region of the substrate could be sealed up with the sealing glass plate, and in that state, this was UV-irradiated with a UV lamp to thereby cure the UV-curable resin.

According to the above process, an organic electroluminescent element was produced.

### <Reverse Voltage Leakage Current Test>

### (Evaluation Method)

The produced element was analyzed for the current voltage characteristics thereof according to a direct current two-terminal method. For the measurement, used was a 2400-model source meter by KEYTHLEY. The system was swept from 0.0 V to -16.0 V at a voltage of 2.0 V/sec, and the current value was recorded at every interval of 0.2 V.

For the evaluation, four pixels formed using the composition 1 for organic electroluminescent elements were swept each two times in the manner as above, and herein provided was a form of 8 data series.

The sample in which a current of 1 × 10⁻⁷ A or more run in the region of from -15.0 V to -16.0 V was judged as NG, and the proportion of NG samples in the 8 data series was expressed as a percentage of "NG frequency".

Specifically, the NG frequency 0% means an extremely good condition of such that no reverse direction leak current runs even in application of reversed direction voltage, while the NG frequency 100% means an extremely unsuitable condition of such that a reversed direction leak current runs in a probability of 100% in reversed direction voltage application.

### (Evaluation Result)

The element using the composition 1 for organic electroluminescent elements prepared using the aromatic amine polymer (P1-3) provided a good result of NG frequency 25%.

### [Comparative Example 1]

A composition x for organic electroluminescent elements was prepared in the same manner as in Example 1, in which, however, the aromatic amine polymer (P1-1) produced in Synthesis Example 1 was used in place of the aromatic amine polymer (P1-3).

The Zn concentration in the composition x was quantified through ICP, and was 0.7 ppm, or that is, the Zn concentration was higher than that in the composition 1 for organic electroluminescent elements used in Example 1.

An organic electroluminescent element was produced in the same manner as in Example 1, in which, however, the above-mentioned composition x for organic electroluminescent elements was used in place of the composition 1 for organic electroluminescent elements, and the element was tested similarly in the reversed voltage leakage current test. As a result, the element provided an unfavorable result of an NG frequency 88%.

### [Example 2]

A composition 2 for organic electroluminescent elements was prepared in the same manner as in Example 1, in which, however, a mixture of 0.5 parts by weight of the aromatic amine polymer (P1-2) produced in Synthesis Example 2 and 2.5 parts by weight of the aromatic amine polymer (P1-3) was used in place of the aromatic amine polymer (P1-3).

The Zn concentration in the composition 2 was quantified through ICP, and was 0.2 ppm, or that is, the Zn concentration was lower than that in the composition x for organic electroluminescent elements used in Comparative Example 1.

An organic electroluminescent element was produced in the same manner as in Example 1, in which, however, the above-mentioned composition 2 for organic electroluminescent elements was used in place of the composition 1 for organic electroluminescent elements, and the element was tested similarly in the reversed voltage leakage current test. As a result, the element provided a result of an NG frequency 50%, better than that in Comparative Example 1.

### [Example 3]

### <Preparation of Composition 3 for Organic Electroluminescent Elements>

A composition 3 for organic electroluminescent elements was prepared in the same manner as in Example 1, in which, however, the aromatic amine polymer (P1-4) was used in place of the aromatic amine polymer (P1-3).

The Zn concentration in the composition x was quantified through ICP, and was 0.10 ppm.

### <Storage Stability Test Method>

The storage stability of the composition 3 for organic electroluminescent elements was confirmed according to the method mentioned below, in point of the presence or absence of formation of any Zn-containing foreign substance therein.

Specifically, 1 ml of the composition 3 for organic electroluminescent elements, which had been stored at room temperature for 3 weeks, was metered, and filtered through a 0.1 µm PTFE filter having a diameter of 1.3 cm, and after the filtration, the filter was dried at room temperature for 3 hours, and the filter was observed with a scanning electronic microscope (power: 1000 magnification).

Specifically, in this, 1 ml of the composition for organic electroluminescent elements was filtered through the filter having a pore size of 0.1 µm, and therefore after the filtration, in case where some foreign substances remained on the filter, then the foreign substances are foreign substances having a long diameter of 0.1 µm or more contained in 1 ml of the composition for organic electroluminescent elements. Consequently, by counting the number of the foreign substances, the number of the foreign substances having a long diameter of 0.1 µm or more in 1 ml of the composition can be determined.

### <Storage Stability Test Result>

The filter was checked for foreign substances, but no foreign substances were confirmed.

### [Comparative Example 2]

In Example 3, the composition x for organic electroluminescent elements prepared in Comparative Example 1 was used in place of the composition 3 for organic electroluminescent elements, and the storage stability was confirmed similarly. As a result, 10 to 20 foreign substances were seen per one viewing field, and it was presumed that about 56,000 to 112,000 foreign substances in total would be on the entire surface of the filter.

As a result of EDX analysis, it was confirmed that the foreign substances contained Zn. Specifically, the number of the Zn-containing foreign substances having a long diameter of 0.1 µm or more in 1 ml of the composition x for organic electroluminescent elements was about 56,000 to 112,000.

### [Example 4]

In Example 3, the composition 2 for organic electroluminescent elements prepared in Example 2 was used in place of the composition 3 for organic electroluminescent elements, and the storage stability was confirmed similarly. As a result, 0 to 1 foreign substance was seen per one viewing field, and it was presumed that about 5,600 or less foreign substances in total would be on the entire surface of the filter.

As a result of EDX analysis, it was confirmed that the foreign substances contained Zn. Specifically, the number of the Zn-containing foreign substances having a long diameter of 0.1 µm or more in 1 ml of the composition 2 for organic electroluminescent elements was about 5,600. However, the Zn foreign substance precipitation behavior in the composition was markedly improved as compared with that of the composition x for organic electroluminescent elements of Comparative Example.

### [Zn Removal from Aromatic Amine Polymer]

As a method for reducing the Zn concentration in the aromatic amine polymer for use in the present invention, employable is any other known method than the acid treatment method, the ion exchange method or their combination exemplified in the above-mentioned Examples.

Specifically, there is mentioned a method of bringing an organic solvent solution of the aromatic amine polymer into contact with, for example, an active carbon or silica as an ion remover. The Zn removing effect using active carbon and silica is shown below.

### [Reference Example 1]

2 parts by weight of the aromatic amine polymer (P1-1) obtained in Synthesis Example 1 was dissolved in 18 parts by weight of tetrahydrofuran. The Zn concentration in the solution was 3 ppm.

### [Reference Example 2]

2 parts by weight of Fuji Silysia's diamine silica was added to 20 parts by weight of the aromatic amine polymer solution obtained in Reference Example 1, then stirred at room temperature for 3 hours, thereafter the silica was removed through filtration, and the Zn concentration in the liquid phase part was quantified. The Zn concentration was 1 ppm, or that is, the Zn concentration was reduced here.

### [Reference Example 3]

2 parts by weight of Kanto Chemical's active carbon (powder) was added to 20 parts by weight of the aromatic amine polymer solution obtained in Reference Example 1, and stirred at room temperature for 3 hours, thereafter the active car on was removed through filtration, and the Zn concentration in the liquid phase part was quantified. The Zn concentration was 0.1 ppm, or that is, the Zn concentration was reduced here.

### [Synthesis Example 5: Synthesis of Aromatic Amine Polymer (P1-5)]

According to the same method as in Synthesis Example 1, an aromatic amine polymer (P1-5) (weight-average molecular weight (Mw) = 24,000) was again synthesized.

### [Synthesis Example 6: Synthesis of Aromatic Amine Polymer (P1-6)]

105 parts by weight of tetrahydrofuran and 345 parts by weight of toluene were added to 50 parts by weight of the aromatic amine polymer (P1-5) produced in Synthesis Example 5 to give a uniform solution. Further, 500 parts by weight of 1 N hydrochloric acid was added to the solution, stirred and processed for liquid-liquid separation.

The resultant organic phase was washed three times with 500 parts by weight of water. 630 parts by weight of toluene was added to the separated organic layer, and the toluene solution of the organic layer was led to pass through a mixed bed ion-exchange resin layer formed by mixing 167 parts by weight of a strongly-acidic cation-exchange resin (Mitsubishi Chemical's trade name "Diaion (registered trademark) WK11 (trade name)") and 83 parts by weight of a strongly-basic anion-exchange resin (Mitsubishi Chemical's trade name "Diaion (registered trademark) SAN1 (trade name)").

The eluate was filtered through a polytetrafluoroethylene filter having a pore size of 0.1 µm (hereinafter referred to as "0.1 µm PTFE filter"), then discharged into 3500 parts by weight of methanol to prepare a polymer slurry, filtered, and the solid fraction was washed with 350 parts by weight of methanol, and dried at 60°C for 8 hours to give a purified aromatic amine polymer (P1-6) (weight-average molecular weight (Mw) = 24,000).

### [Purification of Organic Solvent]

### [Purification Example 1: Purification of ethyl benzoate]

30 mL of Mitsubishi Chemical's strongly-basic anion-exchange resin (Diaion (registered trademark) SAN1 (trade name)) and 30 mL of Mitsubishi Chemical strongly-acidic cation-exchange resin (Diaion (registered trademark) SKN1 (trade name)) were mixed and stirred with 500 mL of methanol, and filtered for solid-liquid separation. Thus separated, 24 ml of "SAN1" and 12 ml of "SKN1" were mixed, and charged in a 100-mL dropping funnel to form a mixed bed ion-exchange resin layer.

400 mL of ethyl benzoate (by Kishida Chemical - hereinafter referred to as "EB-1") was introduced into the mixed bed ion-exchange resin layer for solvent substitution, and then EB-1 was further introduced thereinto. This EB-1 having passed through the mixed bed ion-exchange resin layer was filtered through a PTFE filter having a pore size of 0.2 µm. The purified ethyl benzoate is referred to as "EB-2".

EB-1 and EB-2 were analyzed for the S concentration therein through ICP. The S concentration in EB-1 was 33 ppm, while the S concentration in EB-2 was 4 ppm.

### [Preparation and Evaluation of Composition for Organic Electroluminescent Elements]

### [Example 5]

### <Preparation of Composition 4 for Organic Electroluminescent Elements>

A composition 4 for organic electroluminescent elements containing the aromatic amine polymer (P1-5) obtained in Synthesis Example 5, the electron-accepting compound (A1) and, as an organic solvent, the ethyl benzoate EB-2 purified in Purification Example 1 was prepared according to the formulation mentioned below.

| | | |
|---|---|---|
| Solute Components | compound (P1-5) | 3.0 parts by weight |
| | compound (A1) | 0.3 parts by weight |
| Organic Solvent ethyl benzoate (EB-2) | | 96.7 parts by weight |

The compound (P1-5), the compound (A1) and the organic solvent (EB-2) were mixed, heated and stirred at 140°C for 3 hours. After left cooled, absence of any undissolved residue precipitate in the solution was confirmed visually, and then the solution was filtered through a PTFE filter having a pore size of 0.1 µm to give a composition 4 for organic electroluminescent elements.

The S concentration in the composition 4 for organic electroluminescent elements was quantified through ICP, and was 2 ppm. The Zn concentration was 0.2 ppm.

### <Storage Stability Test Method>

The storage stability of the composition 4 for organic electroluminescent elements was evaluated by confirming the presence or absence of formation of foreign substances according to the method described in Example 3.

### <Storage Stability Test Result>

The filter was checked for foreign substances, but any foreign substance having a long diameter of 0.5 µm or more was not confirmed. To that effect, since no foreign substances formed in the storage test under such cooling condition, it is known that the composition 4 for organic electroluminescent elements has no problem in practical use and could provide stable elements.

### [Example 6]

### <Preparation of Composition 5 for Organic Electroluminescent Elements>

A composition 5 for organic electroluminescent elements was prepared in the same manner as in Example 5, in which, however, 3 parts by mass of the polymer (P1-6) produced in Synthesis Example 6 was used in place of the polymer (P1-5) in Example 5.

As a result of ICP analysis, the Zn concentration in the composition 5 for organic electroluminescent elements was less than 0.1 ppm, and the S concentration therein was 2 ppm.

### <Storage Stability Test Result>

The filter was checked for the presence or absence of foreign substances thereon according to the same storage stability test as in Example 3, for the composition 5 for organic electroluminescent elements, but any foreign substance having a long diameter of 0.5 µm or more was not confirmed.

To that effect, since no foreign substances formed in the storage test under the cooling condition, it is known that the composition 5 for organic electroluminescent elements has no problem in practical use and could provide stable elements.

### <Production of Organic Electroluminescent Element>

Using the stored composition 5 for organic electroluminescent elements, an organic electroluminescent element was produced according to the method mentioned below.

### (Formation of Hole Injection Layer)

The composition 5 for organic electroluminescent elements was applied onto a washed ITO substrate according to a spin coating method, then dried and baked to form a hole injection layer. The spin coating was carried out in air at an ambient temperature of 23°C and at a relative humidity of 50%, and the spinner rotation number was 2750 rpm, and the spinning time was 30 seconds. After the coating, the layer was heated and dried on a hot plate at 80°C for 1 minute, and then baked in air in an oven at 230°C for 15 minutes to form a hole injection layer having a thickness of 35 nm.

### (Formation of Hole Transport Layer)

The ITO substrate with the hole injection layer thus formed thereon was set in the chamber of a vacuum vapor deposition apparatus. The chamber was roughly degassed through a rotary pump, and then further depressurized through a cryopump. The vacuum degree was 0.8 × 10⁻⁶ Torr. A vapor deposition mask was arranged on a predetermined region of the substrate, and necessary vapor deposition materials were previously put in separate ceramic crucibles and set in the chamber.

A ceramic crucible with 4,4'-bis[N-(9-phenanthryl)-N-phenylamino]biphenyl (PPD) put therein was heated electrically for vapor deposition on the hole injection layer. The vacuum degree during the vapor deposition was 0.8 × 10⁻⁶ Torr, and the vapor deposition rate was from 0.9 to 1.1 angstrom/sec. In that manner, a hole transport layer having a thickness of 45 nm was formed.

### (Formation of Light-Emitting/Electron Transport Layer)

Next, a ceramic crucible with 8-hydroxyquinoline aluminium complex (Alq3) put therein was heated electrically for vapor deposition on the hole transport layer. The vacuum degree during the vapor deposition was 0.7 × 10⁻⁶ to 0.8 × 10⁻⁶ Torr, and the vapor deposition rate was from 1.1 to 1.4 angstrom/sec. In that manner, an electron transport layer serving also as a light-emitting layer was formed, having a thickness of 60 nm.

### (Cathode Formation)

Next, the substrate was once taken out into air, and, as a mask for cathode deposition, a 2 mm-wide stripy shadow mask was arranged on the substrate so as to be orthogonal to the ITO stripe of the anode, and then immediately set in the vapor deposition apparatus. The chamber was roughly degassed through a rotary pump, and then depressurized through a cryopump. The vacuum degree was 1.5 × 10⁻⁴ Pa.

As the cathode, first, a molybdenum boat with lithium fluoride (LiF) put therein was heated electrically for vapor deposition on the electron transport layer. Regarding the vapor deposition condition, the vacuum degree during vapor deposition was 1.7 × 10⁻⁴ to 1.9 × 10⁻⁴ Pa, and the vapor deposition rate was from 0.12 to 0.13 angstrom/sec. In that manner, a layer was formed to have a thickness of 0.5 nm.

Finally, a molybdenum boat with aluminium put therein was heated electrically for vapor deposition. Regarding the vapor deposition condition, the vacuum degree during vapor deposition was from 2.2 × 10⁻⁴ to 2.5 × 10⁻⁴ Pa, and the vapor deposition rate was from 1.2 to 5.5 angstrom/sec. The thickness of the layer was 80 nm.

### (Sealing)

Next, the substrate was once taken out in air, and rapidly transferred into a nitrogen-purged glove box. In the nitrogen-purged glove box, a moisture-absorbing sheet was stuck to the recess region of a sealing glass plate, then a UV-curable resin was applied to the peripheral area of the recess region of the sealing glass plate using a dispenser, and the layer-deposited substrate was airtightly attached thereto in such a manner that the deposition region of the substrate could be sealed up with the sealing glass plate, and in that state, this was UV-irradiated with a UV lamp to thereby cure the UV-curable resin.

According to the above process, an organic electroluminescent element was produced.

### <Confirmation of Light-Emitting Performance>

When electrified, the element gave planar green light emission with no emission failure.

### [Reference Example 4]

### [AFM Analysis of Contact Surface of Glass Container]

The following three types of borosilicate glass containers were prepared.
Glass container 1: brown screw-cap tube (sold by Maruemu)
Glass container 2: 100-ml brown screw-cap tube (sold by Alpha Purchase)
Glass container 3: light brown screw-top round tube (Shott Duran's "Duran (registered trademark)")

Of the above-mentioned three types of glass containers, the surface profile of the inner surface part at which the container is kept in contact with a liquid therein was analyzed through AFM according to the method mentioned below.

As the measuring surface, two sites were randomly extracted from the contact surface of the bottom of each glass container. Of all the above-mentioned glass containers, the contact surface was a uniform surface, and there is little difference in the surface profile between the measuring sites.
Apparatus: Asylum Research's MFP-3D
Probe: Olympus's AC240TS-C3, with spring constant of around 2 N/m
Measurement environment: laboratory atmosphere, room temperature
Measuring region of one sample: 10 µm square (= 10 µm × 10 µm)
Data sampling number: 256 × 256

### (Mode of Analysis)

Of the resultant AFM image of 10 µm square, the height image observed with AFM was analyzed with an imaging program. A region from -6.4 nm to 6.4 nm was converted into from 0 to 255 gradations (0.05 nm/density), and using an image-processing program (Media Cybernetics' Image-Pro Plus) and using a median filter (filter region 5 × 5, frequency 1), the image was noise-processed.

Using the image-processing program, an area of 10 pixels or less was cut as noise, and through number and area measurement, the number of the projections of 0.8 nm or more and the areal ratio thereof, and the number of the recesses of 0.8 nm or more and the areal ratio thereof were determined.

The number of the projections and the recesses of 0.8 nm or more is the number/sample of the projections higher by 0.8 nm or more than the base level, and the number/sample of the recesses lower by 0.8 nm or more than the base level, respectively, as calculated in the same manner as that for the surface projection/recess density.

The areal ratio of the recesses of 0.8 nm or more corresponds to the areal ratio of the surface recess part, and the areal ratio of the projections of 0.8 nm or more was determined like the areal ratio of the surface recess part.

The results are shown in Table 14 below.

### [Table 14]

**Table 14**

| | Projections of 0.8 nm or more | | Recesses of 0.8 nm or more | |
|---|---|---|---|---|
| | number (number/100 µm²) | areal ratio (%) | number (number/100 µm²) | areal ratio (%) |
| Glass Container 1 | 26 | 7.2 | 17 | 6.7 |
| Glass Container 2 | 9 | 0.9 | 4 | 0.5 |
| Glass Container 3 | 1 | 1 | 0 | 0 |

From Table 14, it is known that, of the glass container 3, the contact surface has few surface projections/recesses, while of the glass containers 1 and 2, the contact surface has surface projections/recesses.

### [Synthesis and Purification of Aromatic Amine Polymer]

### [Synthesis Example 7: Synthesis of Aromatic Amine Polymer (P1-7)]

Again through the same reaction as in Synthesis Example 1, an aromatic amine polymer (P1-7) was synthesized.

The weight-average molecular weight (Mw) of the obtained aromatic amine polymer (P1-7) was 29,000.

The aromatic amine polymer (P1-7) was analyzed through ICP to determine the inorganic fraction, and the Zn content therein was 6,600 ppb, and the Cu content therein was less than 1,000 ppb.

### [Synthesis Example 8: Synthesis of Aromatic Amine Polymer (P1-8)]

In the same manner as in Synthesis Example 7, in which, however, as the starting material, N,N'-bis(4-hydroxyphenyl)-N,N'-diphenyl-p-phenylenediamine, one from a different starting material lot was used, an aromatic amine polymer (P1-8) was synthesized and analyzed similarly.

The weight-average molecular weight (Mw) of the obtained aromatic amine polymer (P1-8) was 24,000, the Zn content was 270 ppb, and the Cu content therein was 2,000 ppb.

### [Synthesis Example 9: Synthesis of Aromatic Amine Polymer (P1-9)]

In the same manner as in Synthesis Example 7, in which, however, as the starting material, N,N'-bis(4-hydroxyphenyl)-N,N'-diphenyl-p-phenylenediamine, one from a different starting material lot was used, an aromatic amine polymer (P1-9) was synthesized and analyzed similarly.

The weight-average molecular weight (Mw) of the obtained aromatic amine polymer (P1-9) was 29,000, the Zn content was 220 ppb, and the Cu content therein was 1,400 ppb.

### [Preparation and Evaluation of Composition for Organic Electroluminescent Elements]

### [Example 7]

### <Preparation of Composition 6 for Organic Electroluminescent Elements>

A composition 6 for organic electroluminescent elements containing the aromatic amine polymer (P1-7) obtained in Synthesis Example 7, the electron-accepting compound (A1) and, as an organic solvent, ethyl benzoate was prepared according to the formulation mentioned below.

| | | |
|---|---|---|
| Solute Components | compound (P1-7) | 3.0 parts by weight |
| | compound (A1) | 0.3 parts by weight |
| Organic Solvent ethyl benzoate | | 96.7 parts by weight |

The compound (P1-7), the compound (A1) and the organic solvent were mixed, heated and stirred at 140°C for 3 hours. After left cooled, absence of any undissolved residue precipitate in the solution was confirmed visually, and then the solution was filtered through a PTFE filter having a pore size of 0.1 µm to give a composition 6 for organic electroluminescent elements.

The resultant composition 6 for organic electroluminescent elements was stored, as sealed up in the glass container 1, and evaluated as follows.

### <Storage Stability Test-1>

Specifically, 2 ml of the composition 6 for organic electroluminescent elements, which had been sealed up in the glass container 1 and stored therein at 5°C for 1 week, was metered, and filtered through a PTFE filter having a pore size of 0.1 µm and having a diameter of 1.3 cm, and after the filtration, the filter was dried at room temperature for 3 hours, and the filter was observed with a scanning electronic microscope (power: 1000 magnification).

The filter was thus observed at 9 viewing fields or more to check any foreign substance thereon; however, no foreign substance was confirmed.

### <Determination of Zn Concentration>

The composition 6 for organic electroluminescent elements that had been sealed up in the glass container 1 and stored therein at room temperature for 3 weeks was analyzed through ICP to determine the Zn concentration therein. The result is shown in Table 15.

### <ToF-SIMS Analysis>

After the Zn concentration measurement, the composition was removed from the glass container 1, and the inner wall of the container was washed with ethyl benzoate, then dried with air for 2 days, and thereafter the contact surface was analyzed through ToF-SIMS under the measurement condition mentioned below to thereby determine the Zn count number (mass 63.93). The result is shown in Table 15.
Mode of analysis: time-of-flight secondary ion mass spectrometry (abbreviated expression, ToF-SIMS)
Model of apparatus: ION-TOF's TOF-SIMS IV
Primary ion: Bi₃⁺⁺, acceleration voltage 25 kV, irradiation current 0.1 pA, 200 µm scanning
Secondary ion: positive ion collection, 30 scans integration

### [Reference Example 5]

The composition 6 for organic electroluminescent elements was tested in the storage stability test-1 in the same manner as in Example 7 except that the composition was sealed up and stored in the glass container 3. The filter was observed and checked for any foreign substance thereon. Five or more spherical foreign substances per 1 viewing field were confirmed, and it was presumed that 28,000 or more foreign substances in total would be on the entire surface of the filter. Through observation with a scanning electronic microscope (Kvex's S-4100) and through EDX using the attached X-ray analyzer, these foreign substances were identified as those having a main component of Zn.

Also in the same manner as in Example 7, the Zn concentration was measured and the sample was analyzed through ToF-SIMS. The results are shown in Table 15.

### [Reference Example 6]

The composition 6 for organic electroluminescent elements was analyzed in the same manner as in Example 7 to determine the Zn concentration therein, except that the composition was sealed up in a Teflon (registered trademark) container (made of Big Boy SCC (Teflon (registered trademark)) PFA, sold by Alpha Purchase). The result is shown in Table 15. Teflon (registered trademark) is nonpolar, and could not trap any foreign substance and metal ion on the contact surface of the container. Accordingly, a large number of foreign substances are easy to form in the composition.

**[Table 15]**

| | Storage Container | Zn Concentration in Composition after Storage (ppm) | Zn Count Number on Contact Surface of Container after Storage * |
|---|---|---|---|
| Example 7 | glass container 1 | 0.46 | 338 (89) |
| Reference Example 5 | glass container 3 | 0.55 | 104 (48) |
| Reference Example 6 | Teflon container | 0.53 | - |

| | | | |
|---|---|---|---|
| * The parenthesized data are the measurement results on the contact surface before storage of the composition. | | | |

Table 15 indicates the following.

In Example 7, Zn in the composition was trapped by the glass container 1, and the Zn count number increased on the container surface.

As opposed to this, in the case where the composition was stored in the glass container 3 or the Teflon (registered trademark) container, the Zn count number increase was small.

From the above, it is known that, of the glass container of the present invention, the contact surface has many projections and recesses and therefore, owing to these projections and recesses, the surface area of the contact surface increases therefore resulting in that mechanical/chemical bonds to metal ions are easy to form on the contact surface and the surface readily traps those metal ions in the composition.

### [Example 8]

### <Preparation of Composition 7 for Organic Electroluminescent Elements>

A composition 7 for organic electroluminescent elements was produced in the same manner as that for the composition 6 for organic electroluminescent elements in Example 7, except that the aromatic amine polymer (P1-8) was used in place of the aromatic amine polymer (P1-7) and the heating temperature in mixing was changed from 140°C to 110°C.

The resultant composition 7 for organic electroluminescent elements was stored, as sealed up in the glass container 1, and evaluated as follows.

### <Storage Stability Test-2>

2 ml of the composition 7 for organic electroluminescent elements, which had been sealed up in the glass container 1 and stored therein at 23°C for 1 week, was metered, and filtered through a PTFE filter having a pore size of 0.1 µm and having a diameter of 1.3 cm, and after the filtration, the filter was dried at room temperature for 3 hours, and the filter was observed with a scanning electronic microscope (power: 1000 magnification).

The filter was thus observed at 9 viewing fields or more to check any foreign substance thereon; however, no foreign substance was confirmed.

### [Comparative Example 3]

The composition 7 for organic electroluminescent elements was tested in the storage stability test-2 in the same manner as in Example 7 except that the composition was sealed up and stored in the glass container 3. The filter was observed and checked for any foreign substance thereon. Five or more spherical foreign substances per 1 viewing field were confirmed, and it was presumed that 28,000 or more foreign substances in total would be on the entire surface of the filter. Through observation with a scanning electronic microscope (Kvex's S-4100) and through EDX using the attached X-ray analyzer, these foreign substances were identified as those having a main component of Cu.

### [Example 9]

### <Preparation of Composition 8 for Organic Electroluminescent Elements>

A composition 8 for organic electroluminescent elements was produced in the same manner as that for the composition 6 for organic electroluminescent elements in Example 7, except that the aromatic amine polymer (P1-9) was used in place of the aromatic amine polymer (P1-7).

The resultant composition 8 for organic electroluminescent elements was stored, as sealed up in the glass container 2, and evaluated as follows.

### <Storage Stability Test-3>

2 ml of the composition 8 for organic electroluminescent elements, which had been sealed up in the glass container 2 and stored therein at room temperature for 3 months, was metered, and filtered through a PTFE filter having a pore size of 0.1 µm and having a diameter of 1.3 cm, and after the filtration, the filter was dried at room temperature for 3 hours, and the filter was observed with a scanning electronic microscope (power: 1000 magnification).

The filter was thus observed at 9 viewing fields or more to check any foreign substance thereon; however, no foreign substance was confirmed.

### [Production of Organic Electroluminescent Element]

### [Example 10]

Using the composition 7 for organic electroluminescent elements, which had been sealed up in the glass container 1 and stored therein at 23°C for 1 week in Example 8, an organic electroluminescent element was produced according to the method mentioned below.

### (Formation of Hole Injection Layer)

The stored composition 2 for organic electroluminescent elements was applied onto a washed ITO substrate according to a spin coating method, then dried and baked to form a hole injection layer. The spin coating was carried out in air at an ambient temperature of 23°C and at a relative humidity of 50%, and the spinner rotation number was 2750 rpm, and the spinning time was 30 seconds.

After the coating, the layer was heated and dried on a hot plate at 80°C for 1 minute, and then baked in air in an oven at 230°C for 15 minutes to form a hole injection layer having a thickness of 35 nm.

### (Formation of Hole Transport Layer)

The ITO substrate with the hole injection layer thus formed thereon was set in the chamber of a vacuum vapor deposition apparatus. The chamber was roughly degassed through a rotary pump, and then further depressurized through a cryopump. The vacuum degree was 2.0 × 10⁻⁴ Pa. A vapor deposition mask was arranged on a predetermined region of the substrate, and necessary vapor deposition materials were previously put in separate ceramic crucibles and set in the chamber.

A ceramic crucible with 4,4'-bis[N-(9-phenanthryl)-N-phenylamino]biphenyl (PPD) put therein was heated electrically for vapor deposition on the hole injection layer. The vacuum degree during the vapor deposition was 1.8 × 10⁻⁴ Pa, and the vapor deposition rate was from 0.8 to 1.3 angstrom/sec. In that manner, a hole transport layer having a thickness of 45 nm was formed.

### (Formation of Light-Emitting/Electron Transport Layer)

Next, a ceramic crucible with 8-hydroxyquinoline aluminium complex (Alq3) put therein was heated electrically for vapor deposition on the hole transport layer. The vacuum degree during the vapor deposition was 1.8 × 10⁻⁴ Pa, and the vapor deposition rate was from 1.0 to 1.4 angstrom/sec. In that manner, an electron transport layer serving also as a light-emitting layer was formed, having a thickness of 60 nm.

### (Cathode Formation)

Next, the substrate was once taken out into air, and, as a mask for cathode deposition, a 7 mm-wide stripy shadow mask was arranged on the substrate so as to be orthogonal to the ITO stripe of the anode, and then immediately set in the vapor deposition apparatus. The chamber was roughly degassed through a rotary pump, and then depressurized through a cryopump. The vacuum degree was 4.5 × 10⁻⁴ Pa.

As the cathode, first, a molybdenum boat with lithium fluoride (LiF) put therein was heated electrically for vapor deposition on the electron transport layer. Regarding the vapor deposition condition, the vacuum degree during vapor deposition was 4.8 × 10⁻⁴ Pa, and the vapor deposition rate was from 0.16 to 0.20 angstrom/sec. In that manner, a layer was formed to have a thickness of 0.5 nm.

Finally, a molybdenum boat with aluminium put therein was heated electrically for vapor deposition. Regarding the vapor deposition condition, the vacuum degree during vapor deposition was from 8.0 × 10⁻⁴ to 16.0 × 10⁻⁴ Pa, and the vapor deposition rate was from 2.6 to 5.6 angstrom/sec. The thickness of the layer was 80 nm.

### (Sealing)

Next, the substrate with the cathode formed thereon was once taken out in air, and rapidly transferred into a nitrogen-purged glove box. In the nitrogen-purged glove box, an moisture absorbent sheet was stuck to the recess region of a sealing glass plate, then a UV-curable resin was applied to the peripheral area of the recess region of the sealing glass plate using a dispenser, and the layer-deposited substrate was airtightly attached thereto in such a manner that the deposition region of the substrate could be sealed up with the sealing glass plate, and in that state, this was UV-irradiated with a UV lamp to thereby cure the UV-curable resin.

According to the above process, an organic electroluminescent element was produced.

### <Confirmation of Light-Emitting Performance>

When electrified, the element gave planar green light emission with no emission failure.

The present application is based on a Japanese patent application filed on April, 9, 2012 (Application No. 2012-088476), and a Japanese patent application filed on April 9, 2012 (Application No. 2012-088477) and a Japanese patent application filed on March 12, 2013 (Application No. 2013-049291).

### Industrial Applicability

The composition for organic electroluminescent elements of the present invention is free from a problem of foreign substance formation, and can form a uniform film in a case of forming a hole injection layer and/or a hole transport layer according to a wet film formation method, and does not bring about any disadvantage from the industrial viewpoint.

In addition, the organic electroluminescent element having a hole injection layer and/or a hole transport layer formed according to a wet film formation method using the composition for organic electroluminescent elements of the present invention is free from short circuit and dark spots, and has a long driving life.

Consequently, the present invention is favorably used in various fields of using organic electroluminescent elements, for example, in the fields of light sources taking advantage of flat panel displays (for example, for OA computers or wall-hanging televisions) or planar light-emitting articles (for example, light sources for duplicators, backlight sources for liquid-crystal displays and indicators, for example, lighting sources of ordinary lighting systems such as sealing lights, stand lights, etc., lighting sources for stage lighting systems such as display racks, etc.), sign boards, marker lamps, etc.

### Reference Signs List

- 1: Substrate
- 2: Anode
- 3: Hole Injection Layer
- 3: Hole Transport Layer
- 5: Light-Emitting Layer
- 6: Hole-Blocking Layer
- 7: Electron Transport Layer
- 8: Electron Injection Layer
- 9: Cathode

## Claims

1. A composition for organic electroluminescent elements that is for forming at least one layer selected from a group consisting of a light-emitting layer, a hole injection layer and a hole transport layer of an organic electroluminescent element, wherein
the composition comprises an aromatic amine polymer having a weight-average molecular weight of from 3,000 to 1,000,000 and an organic solvent, and
the content of Zn in the composition is less than 0.5 ppm by weight, as determined by the ICP method described in the Examples.

2. The composition for organic electroluminescent elements according to claim 1, wherein the composition for organic electroluminescent elements is a composition for forming at least one layer of a hole injection layer and a hole transport layer of an organic electroluminescent element.

3. The composition for organic electroluminescent elements according to claim 1 or 2, wherein the content of Zn is less than 0.1 ppm by weight, as determined by the ICP method described in the Examples.

4. The composition for organic electroluminescent elements according to any one of claims 1 to 3, wherein the number of Zn-containing foreign substances having a long diameter of 0.1 µm or more contained in 1 ml of the composition is 50,000 or less.

5. The composition for organic electroluminescent elements according to any one of claims 1 to 4, wherein the content of S in the composition is less than 20 ppm by weight, as determined by the ICP method described in the Examples.

6. The composition for organic electroluminescent elements according to any one of claims 1 to 4, wherein the content of S in the composition is less than 5 ppm by weight, as determined by the ICP method described in the Examples.

7. The composition for organic electroluminescent elements according to claim 5 or 6, wherein S existing in the composition is derived from an organic compound.

8. The composition for organic electroluminescent elements according to any one of claims 1 to 7, wherein the aromatic amine polymer has a repeating unit represented by the following formula (2): 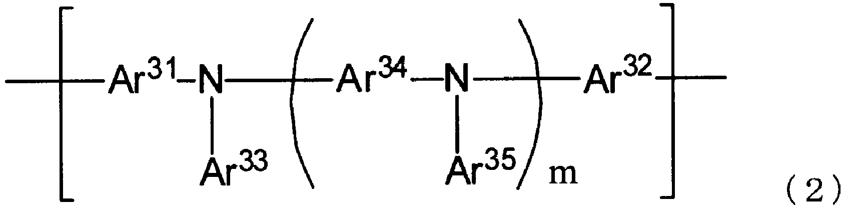 In the formula, m indicates an integer of from 0 to 3,
Ar³¹ and Ar³² each independently represent a direct bond, a divalent aromatic hydrocarbon-cyclic group optionally having a substituent, or a divalent aromatic heterocyclic group optionally having a substituent,
Ar³³ to Ar³⁵ each independently represent an aromatic hydrocarbon-cyclic group optionally having a substituent or an aromatic heterocyclic group optionally having a substituent,
in which Ar³³ and Ar³⁵ each are a monovalent group, and Ar³⁴ is a divalent group, and Ar³¹ and Ar³² are not a direct bond at the same time.

9. The composition for organic electroluminescent elements according to any one of claims 1 to 7, wherein the aromatic amine polymer has a repeating unit represented by the following formula (3): 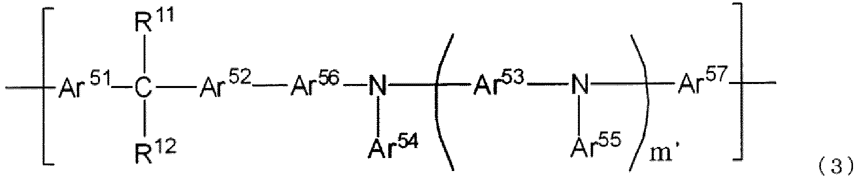 In the formula, Ar⁵¹ to Ar⁵³ each independently represent a divalent aromatic group optionally having a substituent,
Ar⁵⁴ and Ar⁵⁵ each independently represent an aromatic group optionally having a substituent,
Ar⁵⁶ and Ar⁵⁷ each independently represent a direct bond, or a divalent aromatic group optionally having a substituent,
R¹¹ and R¹² each independently represent a hydrogen atom, an alkyl group optionally having a substituent, an alkoxy group optionally having a substituent, or an aromatic group optionally having a substituent,
m' indicates an integer of from 0 to 5,
R¹¹ and R¹² may bond to each other to form a cyclic structure.

10. The composition for organic electroluminescent elements according to any one of claims 1 to 8, wherein the aromatic amine polymer has a repeating unit represented by the following formula (1): 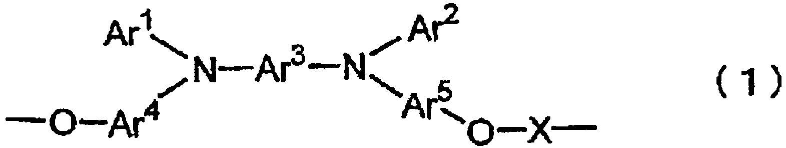 In the formula, Ar¹ and Ar² each independently represent an aromatic hydrocarbon-cyclic group optionally having a substituent, or an aromatic heterocyclic group optionally having a substituent, Ar³ to Ar⁵ each independently represent a divalent aromatic hydrocarbon-cyclic group optionally having a substituent, or a divalent aromatic heterocyclic group optionally having a substituent, and, of Ar¹ to Ar⁵, two groups bonding to the same N atom may bond to each other to form a ring, and X represents one linking group selected from the following linking group family X'. <Linking group family X'> 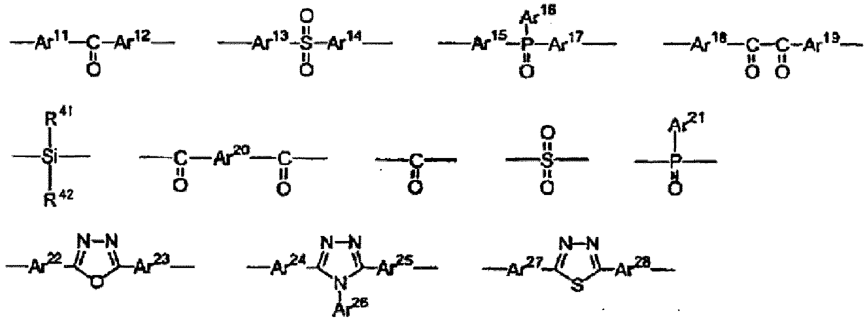 In the formulae, Ar¹¹ to Ar²⁸ each independently represent an aromatic hydrocarbon-cyclic group optionally having a substituent, or an aromatic heterocyclic group optionally having a substituent, R⁴¹ and R⁴² each independently represent a hydrogen atom or an arbitrary substituent.

11. The composition for organic electroluminescent elements according to claim 10, wherein the formula (1) is a repeating unit represented by the following formula (1-1): 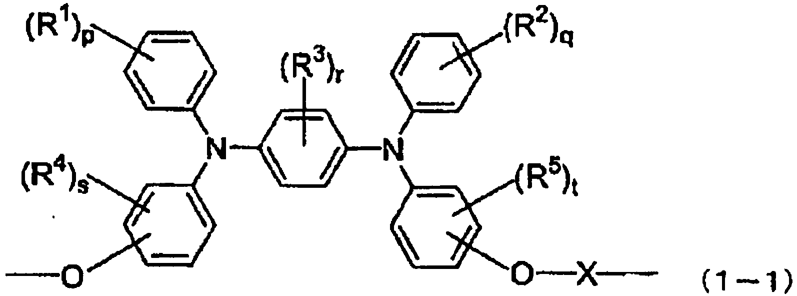 In the formula, R¹ to R⁵ each independently represent an arbitrary substituent. p and q each independently indicate an integer of from 0 to 5, r, s and t each independently indicate an integer of from 0 to 4, and X has the same meaning as that of X in the formula (1).

12. The composition for organic electroluminescent elements according to any one of claims 8 to 11, wherein the aromatic amine polymer has a dissociating group or a crosslinking group.

13. The composition for organic electroluminescent elements according to any one of claims 1 to 12, which further comprises an electron-accepting compound.

14. The composition for organic electroluminescent elements according to any one of claims 1 to 13, wherein the composition for organic electroluminescent elements is sealed up in a glass container having the following characteristic: A glass container where, in the inner surface of the container that is in contact with the composition for organic electroluminescent elements, the areal ratio of the surface projection/recess part of being the total of the projection regions projecting from the base level by 0.8 nm or more and the recess regions recessing from the base level by 0.8 nm or more, as calculated from the projected area, is 0.2% or more.

15. The composition for organic electroluminescent elements according to any one of claims 1 to 13, wherein the composition for organic electroluminescent elements is sealed up in a glass container having the following characteristic: A glass container where, in the inner surface of the container that is in contact with the composition for organic electroluminescent elements, the areal ratio of the surface recess part of the recess regions recessing from the base level by 0.8 nm or more, as calculated from the projected area, is 0.1% or more.

16. The composition for organic electroluminescent elements according to any one of claims 1 to 13, wherein the composition for organic electroluminescent elements is sealed up in a glass container having the following characteristic: A glass container where, in the inner surface of the container that is in contact with the composition for organic electroluminescent elements, the total of the number of the projection regions projecting from the base level by 0.8 nm or more and the number of the recess regions recessing from the base level by 0.8 nm or more in an arbitrarily-selected region of 10 µm × 10 µm is 5 or more.

17. Use of the composition for organic electroluminescent elements according to any one of claims 1 to 16 for forming at least one layer selected from a group consisting of a light-emitting layer, a hole injection layer and a hole transport layer according to a wet film formation method, the at least one layer selected from a group consisting of a light-emitting layer, a hole injection layer and a hole transport layer being comprised in an organic electroluminescent element comprising, as laminated on a substrate, at least an anode, a hole injection layer, a hole transport layer, a light-emitting layer and a cathode.

18. A sealed body of the composition for organic electroluminescent elements according to any one of claims 1 to 13, as sealed up in a glass container,
wherein the glass container is a glass container where, in the inner surface of the container that is in contact with the composition for organic electroluminescent elements, the areal ratio of the surface projection/recess part of being the total of the projection regions projecting from the base level by 0.8 nm or more and the recess regions recessing from the base level by 0.8 nm or more, as calculated from the projected area, is 0.2% or more.

19. A sealed body of the composition for organic electroluminescent elements according to any one of claims 1 to 13, as sealed up in a glass container,
wherein the glass container is a glass container where, in the inner surface of the container that is in contact with the composition for organic electroluminescent elements, the areal ratio of the surface recess part of the recess regions recessing from the base level by 0.8 nm or more, as calculated from the projected area, is 0.1% or more.

20. A sealed body of the composition for organic electroluminescent elements according to any one of claims 1 to 13, as sealed up in a glass container,
wherein the glass container is a glass container where, in the inner surface of the container that is in contact with the composition for organic electroluminescent elements, the total of the number of the projection regions projecting from the base level by 0.8 nm or more and the number of the recess regions recessing from the base level by 0.8 nm or more in an arbitrarily-selected region of 10 µm × 10 µm is 5 or more.

## Patentansprüche

1. Zusammensetzung für organische elektrolumineszierende Elemente, die zum Bilden von zumindest einer Schicht ist, ausgewählt aus der Gruppe bestehend aus einer lichtemittierenden Schicht, einer Lochinjektionsschicht und einer Lochtransportschicht eines organischen elektrolumineszenten Elements, worin
die Zusammensetzung ein aromatisches Amin-Polymer mit einem gewichtsgemittelten Molekulargewicht von 3.000 bis 1.000.000 und ein organisches Lösungsmittel umfasst, und
worin der Gehalt von Zn in der Zusammensetzung weniger als 0,5 ppm (gewichtsbezogen) beträgt, bestimmt durch das in den Beispielen beschriebene ICP-Verfahren.

2. Zusammensetzung für organische elektrolumineszierende Elemente gemäß Anspruch 1, worin die Zusammensetzung für organische elektrolumineszierende Elemente eine Zusammensetzung zum Bilden von zumindest einer Schicht von einer Lochinjektionsschicht und einer Lochtransportschicht eines organischen elektrolumineszierenden Elements ist.

3. Zusammensetzung für organische elektrolumineszierende Elemente gemäß Anspruch 1 oder 2, worin der Gehalt von Zn weniger als 0,1 ppm (gewichtsbezogen) beträgt, bestimmt mit dem in den Beispielen beschriebenen ICP-Verfahren.

4. Zusammensetzung für organische elektrolumineszierende Elemente gemäß irgendeinem der Ansprüche 1 bis 3, worin die Anzahl der Zn-haltigen Fremdsubstanzen mit einem Langdurchmesser von 0,1 µm oder mehr, die in 1 ml der Zusammensetzung enthalten sind, 50.000 oder weniger beträgt.

5. Zusammensetzung für organische elektrolumineszierende Elemente gemäß irgendeinem der Ansprüche 1 bis 4, worin der Gehalt von S in der Zusammensetzung weniger als 20 ppm (gewichtsbezogen) beträgt, bestimmt durch das in den Beispielen beschriebene ICP-Verfahren.

6. Zusammensetzung für organische elektrolumineszierende Elemente gemäß irgendeinem der Ansprüche 1 bis 4, worin der Gehalt von S in der Zusammensetzung weniger als 5 ppm (gewichtsbezogen) beträgt, bestimmt mit dem in den Beispielen beschriebenen ICP-Verfahren.

7. Zusammensetzung für organische elektrolumineszierende Elemente gemäß Anspruch 5 oder 6, worin das in der Zusammensetzung vorliegende S aus einer organischen Verbindung stammt.

8. Zusammensetzung für organische elektrolumineszierende Elemente gemäß irgendeinem der Ansprüche 1 bis 7, worin das aromatische Amin-Polymer eine durch die folgende Formel (2) dargestellte Wiederholungseinheit aufweist: 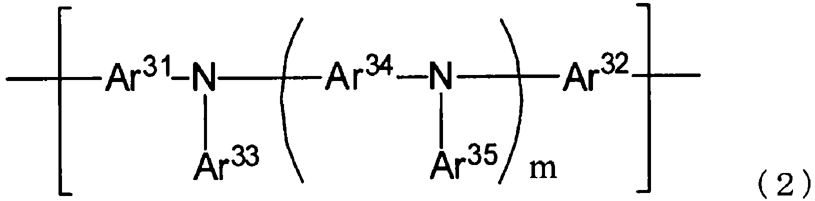 worin in der Formel m eine ganze Zahl von 0 bis 3 bezeichnet,
Ar³¹ und Ar³² jeweils unabhängig eine direkte Bindung, eine divalente aromatische cyclische Kohlenwasserstoff-Gruppe, optional aufweisend einen Substituenten, oder eine divalente aromatische heterocyclische Gruppe, optional aufweisend einen Substituenten, darstellen,
Ar³³ bis Ar³⁵ jeweils unabhängig eine aromatische cyclische Kohlenwasserstoff-Gruppe, optional aufweisend einen Substituenten, oder eine aromatische heterocyclische Gruppe, optional aufweisend einen Substituenten, darstellen,
worin Ar³³ und Ar³⁵ jeweils eine monovalente Gruppe sind und Ar³⁴ eine divalente Gruppe ist, und Ar³¹ und Ar³² nicht gleichzeitig eine direkte Bindung sind.

9. Zusammensetzung für organische elektrolumineszierende Elemente gemäß irgendeinem der Ansprüche 1 bis 7, worin das aromatische Amin-Polymer eine durch die folgende Formel (3) dargestellte Wiederholungseinheit aufweist: 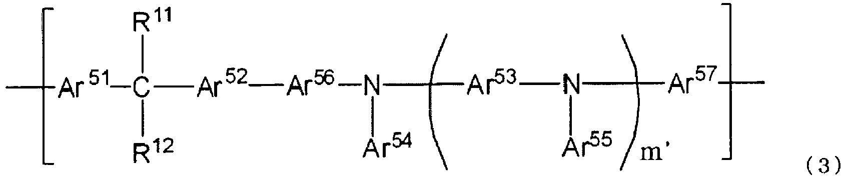 worin in der Formel Ar⁵¹ bis Ar⁵³ jeweils unabhängig eine direkte aromatische Gruppe, optional aufweisend einen Substituenten, darstellen,
Ar⁵⁴ und Ar⁵⁵ jeweils unabhängig eine aromatische Gruppe, optional aufweisend einen Substituenten, darstellen,
Ar⁵⁶ und Ar⁵⁷ jeweils unabhängig eine direkte Bindung oder eine divalente aromatische Gruppe, optional aufweisend einen Substituenten, darstellen,
R¹¹ und R12 jeweils unabhängig ein Wasserstoffatom, eine Alkylgruppe, optional aufweisend einen Substituenten, eine Alkoxygruppe, optional aufweisend einen Substituenten, oder eine aromatische Gruppe, optional aufweisend einen Substituenten, darstellen,
m' eine ganze Zahl von 0 bis 5 bezeichnet, und
R¹¹ und R¹² miteinander verbunden sein können, um eine cyclische Struktur zu bilden.

10. Zusammensetzung für organische elektrolumineszierende Elemente gemäß irgendeinem der Ansprüche 1 bis 8, worin das aromatische Amin-Polymer eine durch die folgende Formel (1) dargestellte Wiederholungseinheit aufweist: 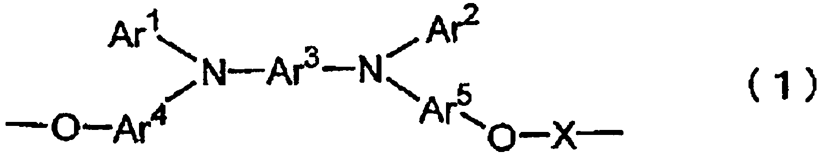 worin in der Formel Ar¹ und Ar² jeweils unabhängig eine aromatische cyclische Kohlenwasserstoff-Gruppe, optional aufweisend einen Substituenten, oder eine aromatische heterocyclische Gruppe, optional aufweisend einen Substituenten, darstellen, Ar³ bis Ar⁵ jeweils unabhängig eine divalente aromatische cyclische Kohlenwasserstoff-Gruppe, optional aufweisend einen Substituenten, oder eine divalente aromatische heterocyclische Gruppe, optional aufweisend einen Substituenten, darstellen, und worin zwei Gruppen von Ar¹ bis Ar⁵, die an das gleiche N-Atom binden, aneinander gebunden sein können, um einen Ring zu bilden, und X eine Verknüpfungsgruppe darstellt, ausgewählt aus der folgenden Verknüpfungsgruppenfamilie X' :
<Verknüpfungsgruppenfamilie X'> 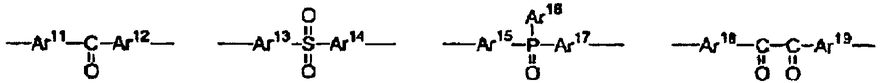 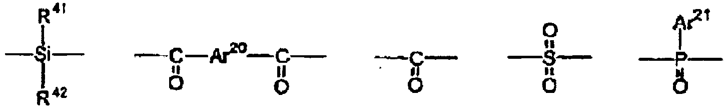 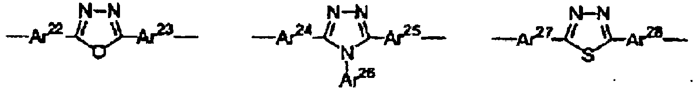 worin in den Formeln Ar¹¹ bis Ar²⁸ jeweils unabhängig eine aromatische cyclische Kohlenwasserstoff-Gruppe, optional aufweisend einen Substituenten, oder eine aromatische heterocyclische Gruppe, optional aufweisend einen Substituenten, darstellen, und R⁴¹ und R⁴² jeweils unabhängig ein Wasserstoffatom oder einen willkürlichen Substituenten darstellen.

11. Zusammensetzung für organische elektrolumineszierende Elemente gemäß Anspruch 10, worin die Formel (1) eine durch die folgende Formel (1-1) dargestellte Wiederholungseinheit ist: 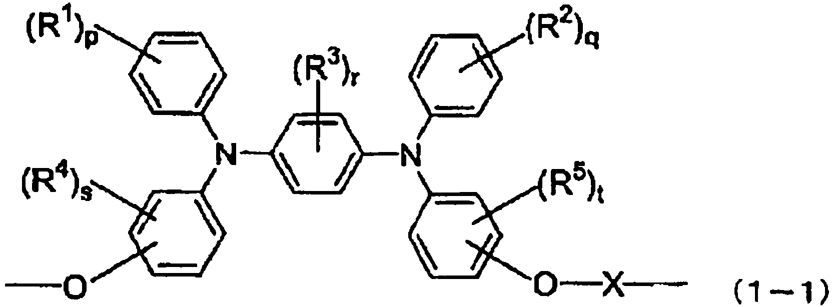 worin in der Formel R¹ bis R⁵ jeweils unabhängig einen willkürlichen Substituenten darstellen, p und q jeweils unabhängig eine ganze Zahl von 0 bis 5 bezeichnen, r, s und t jeweils unabhängig eine ganze Zahl von 0 bis 4 bezeichnen und X die gleiche Bedeutung wie X in Formel (1) besitzt.

12. Zusammensetzung für organische elektrolumineszierende Elemente gemäß irgendeinem der Ansprüche 8 bis 11, worin das aromatische Amin-Polymer eine dissoziierende Gruppe oder eine vernetzende Gruppe aufweist.

13. Zusammensetzung für organische elektrolumineszierende Elemente gemäß irgendeinem der Ansprüche 1 bis 12, welche ferner einen Elektronen-akzeptierende Verbindung umfasst.

14. Zusammensetzung für organische elektrolumineszierende Elemente gemäß irgendeinem der Ansprüche 1 bis 13, worin die Zusammensetzung für organische elektrolumineszierende Elemente in einem Glasbehälter mit den folgenden Eigenschaften verschlossen ist:
ein Glasbehälter, worin in der inneren Oberfläche des Behälters, die in Kontakt mit der Zusammensetzung für organische elektrolumineszierende Elemente steht, der Flächenanteil von Oberflächenvorstößen/Vertiefungen, welcher die Gesamtmenge von Vorstoßbereichen, die von der Grundlinie um 0,8 nm oder mehr vorstoßen, und Vertiefungsbereichen, die von der Grundlinie um 0,8 nm oder mehr vertieft sind, wie aus der projizierten Fläche berechnet wird, 0,2 % oder größer ist.

15. Zusammensetzung für organische elektrolumineszierende Elemente gemäß irgendeinem der Ansprüche 1 bis 13, worin die Zusammensetzung für organische elektrolumineszierende Elemente in einem Glasbehälter mit den folgenden Eigenschaften verschlossen ist:
ein Glasbehälter, worin in der inneren Oberfläche des Behälters, die in Kontakt mit der Zusammensetzung für organische elektrolumineszierende Elemente steht, der Flächenanteil von Oberflächenvorstößen/Vertiefungen, welcher die Gesamtmenge von Vorstoßbereichen, die von der Grundlinie um 0,8 nm oder mehr vorstoßen, und Vertiefungsbereichen, die von der Grundlinie um 0,8 nm oder mehr vertieft sind, wie aus der projizierten Fläche berechnet wird, 0,1 % oder größer ist.

16. Zusammensetzung für organische elektrolumineszierende Elemente gemäß irgendeinem der Ansprüche 1 bis 13, worin die Zusammensetzung für organische elektrolumineszierende Elemente in einem Glasbehälter mit den folgenden Eigenschaften verschlossen ist:
ein Glasbehälter, worin, in den inneren Oberflächen des Behälters, die in Kontakt mit der Zusammensetzung für organisch elektrolumineszierende Elemente steht, die Gesamtanzahl der Vorstoßbereiche, die von der Grundlinie um 0,8 nm oder mehr vorstoßen, und der Anzahl der Vertiefungsbereiche, die von der Grundlinie um 0,8 nm oder mehr vertieft sind, in einem willkürlich ausgewählten Bereich von 10 cm × 10 µm 5 oder mehr beträgt.

17. Verwendung der Zusammensetzung für organische elektrolumineszierende Elemente gemäß irgendeinem der Ansprüche 1 bis 16 zum Bilden von zumindest einer Schicht, ausgewählt aus der Gruppe bestehend aus einer lichtemittierenden Schicht, einer Lochinjektionsschicht und einer Lochtransportschicht, in einem Nass-Filmbildungsverfahren, worin die zumindest eine Schicht, die ausgewählt ist aus der Gruppe bestehend aus einer lichtemittierenden Schicht, einer Lochinjektionsschicht und einer Lochtransportschicht, in einem organischen elektrolumineszierenden Element umfasst ist, umfassend, wie laminiert auf einem Substrat, zumindest eine Anode, eine Lochinjektionsschicht, eine Lochtransportschicht, eine lichtemittierende Schicht und eine Kathode.

18. Verschlossener Körper der Zusammensetzung für organische elektrolumineszierende Elemente gemäß irgendeinem der Ansprüche 1 bis 13, verschlossen in einem Glasbehälter,
worin der Glasbehälter ein Glasbehälter ist, worin in der inneren Oberfläche des Behälters, die in Kontakt mit der Zusammensetzung für organisch elektrolumineszierende Elemente steht, der Flächenanteil von Oberflächenvorstößen/Vertiefungen, welcher die Gesamtmenge von Vorstoßbereichen, die von der Grundlinie um 0,8 nm oder mehr vorstoßen, und Vertiefungsbereichen, die von der Grundlinie um 0,8 nm oder mehr vertieft sind, wie aus der projizierten Fläche berechnet wird, 0,2 % oder größer ist.

19. Verschlossener Körper der Zusammensetzung für organisch elektrolumineszierende Elemente gemäß irgendeinem der Ansprüche 1 bis 13, verschlossen in einem Glasbehälter,
worin der Glasbehälter ein Glasbehälter ist, worin in der inneren Oberfläche des Behälters, die in Kontakt mit der Zusammensetzung für organisch elektrolumineszierende Elemente steht, der Flächenanteil von Oberflächenvorstößen/Vertiefungen, welcher die Gesamtmenge von Vorstoßbereichen, die von der Grundlinie um 0,8 nm oder mehr vorstoßen, und Vertiefungsbereichen, die von der Grundlinie um 0,8 nm oder mehr vertieft sind, wie aus der projizierten Fläche berechnet wird, 0,1 % oder größer ist.

20. Verschlossener Körper der Zusammensetzung für organisch elektrolumineszierende Elemente gemäß irgendeinem der Ansprüche 1 bis 13, verschlossen in einem Glasbehälter,
worin der Glasbehälter ein Glasbehälter ist, worin, in den inneren Oberflächen des Behälters, die in Kontakt mit der Zusammensetzung für organisch elektrolumineszierende Elemente steht, die Gesamtanzahl der Vorstoßbereiche, die von der Grundlinie um 0,8 nm oder mehr vorstoßen, und der Anzahl der Vertiefungsbereiche, die von der Grundlinie um 0,8 nm oder mehr vertieft sind, in einem willkürlich ausgewählten Bereich von 10 cm × 10 µm 5 oder mehr beträgt.

## Revendications

1. Composition pour éléments électroluminescents organiques qui sert à former au moins une couche sélectionnée dans un groupe consistant en une couche émettrice de lumière, une couche d'injection à trous et une couche de transport à trous d'un élément électroluminescent organique, dans laquelle
la composition comprend un polymère amine aromatique présentant une masse moléculaire moyenne en poids de 3 000 à 1 000 000 et un solvant organique, et
la teneur en Zn dans la composition est inférieure à 0,5 ppm en poids, telle que déterminée par le procédé ICP décrit dans les Exemples.

2. Composition pour éléments électroluminescents organiques selon la revendication 1, dans laquelle la composition pour éléments électroluminescents organiques est une composition servant à former au moins une couche parmi une couche d'injection à trous et une couche de transport à trous d'un élément électroluminescent organique.

3. Composition pour éléments électroluminescents organiques selon la revendication 1 ou la revendication 2, dans laquelle la teneur en Zn est inférieure à 0,1 ppm en poids, telle que déterminée par le procédé ICP décrit dans les Exemples.

4. Composition pour éléments électroluminescents organiques selon l'une quelconque des revendications 1 à 3, dans laquelle le nombre de corps étrangers contenant du Zn présentant un grand diamètre supérieur ou égal à 0,1 µm contenus dans 1 ml de la composition est inférieur ou égal à 50 000.

5. Composition pour éléments électroluminescents organiques selon l'une quelconque des revendications 1 à 4, dans laquelle la teneur en S dans la composition est inférieure à 20 ppm en poids, telle que déterminée par le procédé ICP décrit dans les Exemples.

6. Composition pour éléments électroluminescents organiques selon l'une quelconque des revendications 1 à 4, dans laquelle la teneur en S dans la composition est inférieure à 5 ppm en poids, telle que déterminée par le procédé ICP décrit dans les Exemples.

7. Composition pour éléments électroluminescents organiques selon la revendication 5 ou la revendication 6, dans laquelle S existant dans la composition est issu d'un composé organique.

8. Composition pour éléments électroluminescents organiques selon l'une quelconque des revendications 1 à 7, dans laquelle le polymère amine aromatique présente un motif répétitif représenté par la formule (2) suivante : 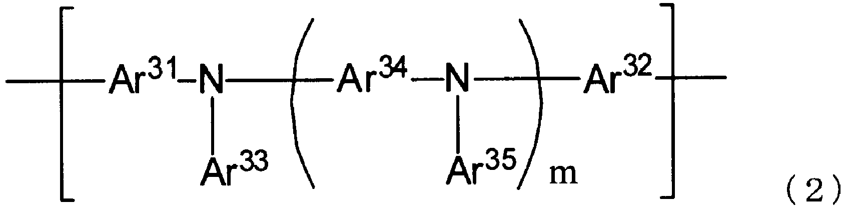 dans la formule, m indique un nombre entier de 0 à 3,
Ar³¹ et Ar³² représentent chacun indépendamment une liaison directe, un groupe hydrocarbure aromatique cyclique divalent présentant éventuellement un substituant, ou un groupe aromatique hétérocyclique divalent présentant éventuellement un substituant,
Ar³³ à Ar³⁵ représentent chacun indépendamment un groupe hydrocarbure aromatique cyclique présentant éventuellement un substituant ou un groupe aromatique hétérocyclique présentant éventuellement un substituant,
dans laquelle Ar³³ et Ar³⁵ sont chacun un groupe monovalent, et Ar³⁴ est un groupe divalent, et Ar³¹ et Ar³² ne sont pas une liaison directe en même temps.

9. Composition pour éléments électroluminescents organiques selon l'une quelconque des revendications 1 à 7, dans laquelle le polymère amine aromatique présente un motif répétitif représenté par la formule (3) suivante : 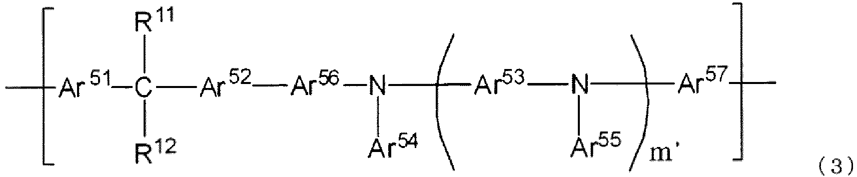 dans la formule, Ar⁵¹ à Ar⁵³ représentent chacun indépendamment un groupe aromatique divalent présentant éventuellement un substituant,
Ar⁵⁴ et Ar⁵⁵ représentent chacun indépendamment un groupe aromatique présentant éventuellement un substituant,
Ar⁵⁶ et Ar⁵⁷ représentent chacun indépendamment une liaison directe, ou un groupe aromatique divalent présentant éventuellement un substituant,
R¹¹ et R¹² représentent chacun indépendamment un atome d'hydrogène, un groupe alkyle présentant éventuellement un substituant, un groupe alcoxy présentant éventuellement un substituant, ou un groupe aromatique présentant éventuellement un substituant,
m' indique un nombre entier de 0 à 5,
R¹¹ et R¹² peuvent se lier l'un à l'autre pour former une structure cyclique.

10. Composition pour éléments électroluminescents organiques selon l'une quelconque des revendications 1 à 8, dans laquelle le polymère amine aromatique présente un motif répétitif représenté par la formule (1) suivante : 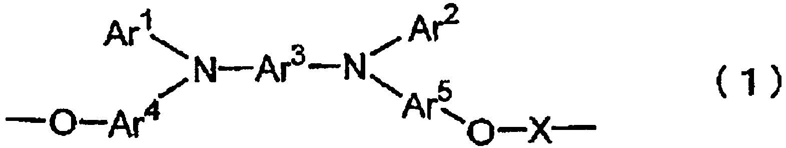 dans la formule, Ar¹ et Ar² représentent chacun indépendamment un groupe hydrocarbure aromatique cyclique présentant éventuellement un substituant, ou un groupe aromatique hétérocyclique présentant éventuellement un substituant, Ar³ à Ar⁵ représentent chacun indépendamment un groupe hydrocarbure aromatique cyclique divalent présentant éventuellement un substituant, ou un groupe aromatique hétérocyclique divalent présentant éventuellement un substituant,
et, parmi Ar¹ à Ar⁵, deux groupes se liant au même atome N peuvent se lier l'un à l'autre pour former un cycle, et X représente un groupe de liaison sélectionné dans la famille de groupes de liaison X' suivante,
<Famille de groupes de liaison X'> 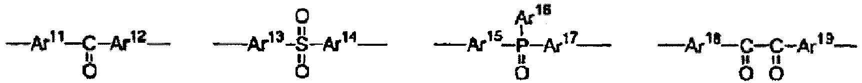 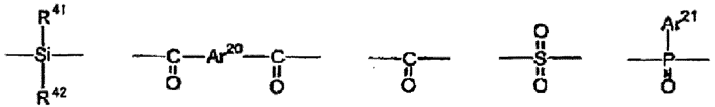 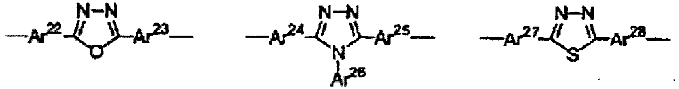
dans les formules, Ar¹¹ à Ar²⁸ représentent chacun indépendamment un groupe hydrocarbure aromatique cyclique présentant éventuellement un substituant, ou un groupe aromatique hétérocyclique présentant éventuellement un substituant, R⁴¹ et R⁴² représentent chacun indépendamment un atome d'hydrogène ou un substituant arbitraire.

11. Composition pour éléments électroluminescents organiques selon la revendication 10, dans laquelle la formule (1) est un motif répétitif représenté par la formule (1-1) suivante : 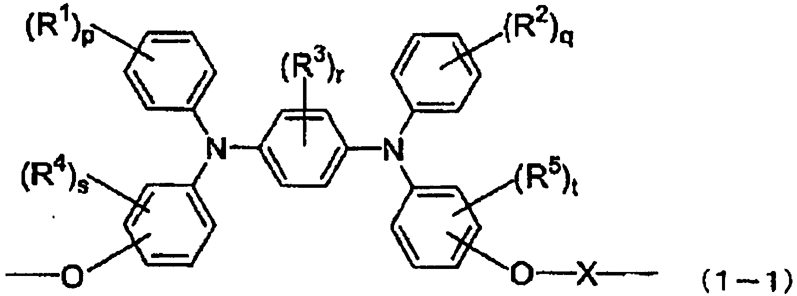 dans la formule, R¹ à R⁵ représentent chacun indépendamment un substituant arbitraire,
p et q indiquent chacun indépendamment un nombre entier de 0 à 5, r, s et t indiquent chacun indépendamment un nombre entier de 0 à 4, et X présente la même signification que celle de X dans la formule (1).

12. Composition pour éléments électroluminescents organiques selon l'une quelconque des revendications 8 à 11, dans laquelle le polymère amine aromatique présente un groupe de dissociation ou un groupe de réticulation.

13. Composition pour éléments électroluminescents organiques selon l'une quelconque des revendications 1 à 12, qui comprend en outre un composé accepteur d'électrons.

14. Composition pour éléments électroluminescents organiques selon l'une quelconque des revendications 1 à 13, dans laquelle la composition pour éléments électroluminescents organiques est contenue hermétiquement dans un récipient en verre présentant la caractéristique suivante :
un récipient en verre dans lequel, dans la surface interne du récipient qui est en contact avec la composition pour éléments électroluminescents organiques, le rapport surfacique de la partie superficielle en saillie/retrait correspondant au total des régions saillantes en saillie par rapport au niveau de base de 0,8 nm ou plus et des régions d'évidement, en retrait par rapport au niveau de base de 0,8 nm ou plus, tel que calculé en fonction de la surface projetée, est supérieur ou égal à 0,2 %.

15. Composition pour éléments électroluminescents organiques selon l'une quelconque des revendications 1 à 13, dans laquelle la composition pour éléments électroluminescents organiques est contenue hermétiquement dans un récipient en verre présentant la caractéristique suivante :
un récipient en verre dans lequel, dans la surface interne du récipient qui est en contact avec la composition pour éléments électroluminescents organiques, le rapport surfacique de la partie d'évidement de surface des régions d'évidement, en retrait par rapport au niveau de base de 0,8 nm ou plus, tel que calculé en fonction de la surface projetée, est supérieur ou égal à 0,1 %.

16. Composition pour éléments électroluminescents organiques selon l'une quelconque des revendications 1 à 13, dans laquelle la composition pour éléments électroluminescents organiques est contenue hermétiquement dans un récipient en verre présentant la caractéristique suivante :
un récipient en verre dans lequel, dans la surface interne du récipient qui est en contact avec la composition pour éléments électroluminescents organiques, le total du nombre des régions saillantes en saillie par rapport au niveau de base de 0,8 nm ou plus et du nombre des régions d'évidement, en retrait par rapport au niveau de base de 0,8 nm ou plus, dans une région sélectionnée arbitrairement de 10 µm × 10 µm est supérieur ou égal à 5.

17. Utilisation de la composition pour éléments électroluminescents organiques selon l'une quelconque des revendications 1 à 16 servant à former au moins une couche sélectionnée dans un groupe consistant en une couche émettrice de lumière, une couche d'injection à trous et une couche de transport à trous selon un procédé de formation de film par voie humide,
l'au moins une couche sélectionnée dans un groupe consistant en une couche émettrice de lumière, une couche d'injection à trous et une couche de transport à trous étant comprise dans un élément électroluminescent organique comprenant, stratifiés sur un substrat, au moins une anode, une couche d'injection à trous, une couche de transport à trous, une couche émettrice de lumière et une cathode.

18. Corps étanche de la composition pour éléments électroluminescents organiques selon l'une quelconque des revendications 1 à 13, tel que contenu hermétiquement dans un récipient en verre,
dans lequel le récipient en verre est un récipient en verre dans lequel, dans la surface interne du récipient qui est en contact avec la composition pour éléments électroluminescents organiques,
le rapport surfacique de la partie superficielle en saillie/retrait correspondant au total des régions saillantes en saillie par rapport au niveau de base de 0,8 nm ou plus et des régions d'évidement en retrait par rapport au niveau de base de 0,8 nm ou plus, tel que calculé en fonction de la surface projetée, est supérieur ou égal à 0,2 %.

19. **Corps** étanche de la composition pour éléments électroluminescents organiques selon l'une quelconque des revendications 1 à 13, tel que contenu hermétiquement dans un récipient en verre,
dans lequel le récipient en verre est un récipient en verre dans lequel, dans la surface interne du récipient qui est en contact avec la composition pour éléments électroluminescents organiques, le rapport surfacique de la partie d'évidement de surface des régions d'évidement, en retrait par rapport au niveau de base de 0,8 nm ou plus, tel que calculé en fonction de la surface projetée, est supérieur ou égal à 0,1 %.

20. Corps étanche de la composition pour éléments électroluminescents organiques selon l'une quelconque des revendications 1 à 13, tel que contenu hermétiquement dans un récipient en verre,
dans lequel le récipient en verre est un récipient en verre dans lequel, dans la surface interne du récipient qui est en contact avec la composition pour éléments électroluminescents organiques, le total du nombre des régions saillantes en saillie par rapport au niveau de base de 0,8 nm ou plus et du nombre des régions d'évidement, en retrait par rapport au niveau de base de 0,8 nm ou plus, dans une région sélectionnée arbitrairement de 10 µm × 10 µm est de 5 ou plus.
